(19) Europäisches Patentamt
European Patent Office
Office européen des brevets

(11) EP 3 018 722 A1

(12) EUROPEAN PATENT APPLICATION
published in accordance with Art. 153(4) EPC

(43) Date of publication:
**11.05.2016 Bulletin 2016/19**

(21) Application number: **14819280.0**

(22) Date of filing: **19.06.2014**

(51) Int Cl.:
***H01L 51/44*** (2006.01) ***C09B 23/00*** (2006.01)
***C09K 3/00*** (2006.01) ***H01G 9/20*** (2006.01)
***H01L 51/46*** (2006.01) ***H01L 51/48*** (2006.01)

(86) International application number:
**PCT/JP2014/066358**

(87) International publication number:
**WO 2015/001984 (08.01.2015 Gazette 2015/01)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **01.07.2013 JP 2013138166**

(71) Applicant: **Konica Minolta, Inc.**
**Tokyo 100-7015 (JP)**

(72) Inventors:
- **ISHIKAWA, Takayuki**
  **Chiyoda-ku, Tokyo 100-7015 (JP)**
- **ISOBE, Kazuya**
  **Chiyoda-ku, Tokyo 100-7015 (JP)**

(74) Representative: **Gille Hrabal**
**Brucknerstrasse 20**
**40593 Düsseldorf (DE)**

# (54) PHOTOELECTRIC CONVERSION ELEMENT MODULE AND METHOD FOR MANUFACTURING SAME

(57) Provided are a photoelectric conversion element module in which sufficient power generation performance can be obtained, and a method for manufacturing the photoelectric conversion element module. A photoelectric conversion element module obtained by electrically connecting two or more photoelectric conversion elements obtained by stacking a substrate, a first electrode, a photoelectric conversion layer containing a semiconductor and a sensitizing dye, a hole transportation layer having a conductive polymer, and a second electrode in the sequence listed, in which the hole transportation layer is formed by bringing the photoelectric conversion layer into contact with a conductive polymer precursor and then irradiating the sensitizing dye with light in the presence of an oxidizer, whereby the conductive polymer precursor is polymerized.

FIG. 1

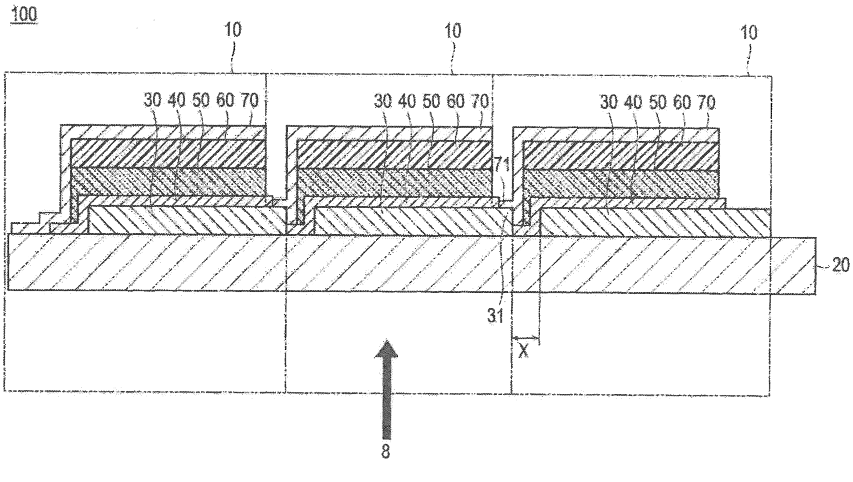




Printed by Jouve, 75001 PARIS (FR)

## Description

### Technical Field

The present invention relates to a photoelectric conversion element module and a method for manufacturing the same.

### Background Art

In recent years, as a means for solving global warming, photovoltaic technologies using solar energy as one of renewable energy without using fossil fuels have received much attention. Among the photovoltaic technologies, a dye-sensitized solar cell generates power by the same mechanism as photoinduced electron transfer carried out by a chlorophyll dye and thus has attracted much attention as one of next-generation rooftop solar cells with low price and high performance.

Generally, such a dye-sensitized solar cell has a configuration in which a substrate, a first electrode, a semiconductor layer (photoelectric conversion layer) that carries a sensitizing dye thereon, a hole transportation layer, and a second electrode are stacked in sequence. For example, a dye-sensitized solar cell technology is described in WO 2005/078853 A. WO 2005/078853 A describes a photoelectric conversion element and a method for manufacturing the photoelectric conversion element in which a second electrode in which platinum is carried on a transparent conductive glass plate coated with a fluorine-doped tin oxide is used as a counter electrode for electrolysis, and with leaving a predetermined size of platinum portion on the center of its surface, the other part of the electrode is masked with an imide resin tape, immersed in an acidic aqueous solution containing aniline and fluoroboric acid and electrically conducted at a predetermined current density, to form an electrolytically polymerized aniline film on the counter electrode, and also describes a photoelectric conversion element and a method for manufacturing the photoelectric conversion element in which the electrolytically polymerized aniline film is impregnated with a liquid electrolyte.

Further, when a liquid electrolyte is used as described in WO 2005/078853 A, leakage or depletion of the electrolyte may occur. Accordingly, there is a technology of using a solid electrolyte as a hole transportation layer. As one of the technology, JP 2003-142168 A describes a photoelectric conversion element and a method for manufacturing the photoelectric conversion element, including: immersing a mesoporous titanium dioxide porous layer as a photoelectric conversion layer in an acetonitrile solution containing pyrrole and $LiClO_4$ dissolved therein; performing irradiation with light at a sustained voltage of 250 mV by using a counter electrode formed of platinum and a reference electrode formed of $Ag/Ag^+$ to sustain the voltage until a polymerization charge quantity reaches a predetermined value; and forming a polypyrrole layer as a hole transportation layer on the photoelectric conversion layer.

Meanwhile, if a dye-sensitized solar cell is actually used, the dye-sensitized solar cell is generally used in the form of a module unit as a combination of a plurality of solar cells configured as described above (see, for example, JP 2013-12366 A).

### Summary of Invention

A hole transportation layer in the dye-sensitized solar cell is formed by electrolytic polymerization in WO 2005/078853 A, or by photoelectrolytic polymerization (photoelectrochemical oxidative polymerization) in JP 2003-142168 A. Generally, electrolytic polymerization is usually employed as one of methods for synthesizing a conductive polymer. According to electrolytic polymerization, when an electrode pair is immersed in a solution containing a monomer and a supporting electrolyte dissolved therein and then a voltage is applied thereto, the monomer is oxidized or reduced on an electrode surface and thus a polymer is formed. In this case, counter ions in the solution can be brought on the electrode by electrochemical doping, and thus, p-n control can be carried out. Accordingly, in the field of dye-sensitized solar cells, electrolytic polymerization is employed as a method for forming a hole transportation layer.

However, when a hole transportation layer is formed by electrolytic polymerization such as photoelectrolytic polymerization, it takes time to perform polymerization and a polymerization amount is small. As described in Patent Literature 1, according to a method of performing electrolytic polymerization of an aniline film serving as a substrate of a hole transportation layer on a second electrode serving as a counter electrode and then the aniline film is bonded to a dye-containing semiconductor film and a substrate with a transparent conductive film, the dye cannot be sufficiently coated with the aniline film. Further, as described in JP 2003-142168 A, according to a method of forming a polypyrrole layer directly on a photoelectric conversion layer, a monomer solution cannot completely permeate a mesoporous layer serving as the photoelectric conversion layer and the polypyrrole layer cannot be formed in an amount sufficient to cover a dye.

Further, when a hole transportation layer is formed by electrolytic polymerization such as photoelectrolytic polymerization, it is necessary to apply a voltage as described above. However, as described in JP 2003-142168 A,

according to the method of forming a polypyrrole layer directly on a photoelectric conversion layer, it is necessary to perform polymerization at a low voltage so as not to oxidize (deteriorate) the dye. However, if polymerization of a polymer constituting a hole transportation layer is performed at a low voltage, drop voltage occurs together with precipitation of the polymer. Therefore, when a monomer is oxidized/reduced on an electrode surface, a sufficient voltage is not applied thereto, and it is difficult to generate a sufficient amount of the polymer around the dye.

Further, for photoelectrolytic polymerization, it is necessary to perform polymerization at a lower voltage as described above. Therefore, it takes time to perform polymerization, which results in low productivity.
Furthermore, in consideration of scaling up of a photoelectric conversion element, it is difficult to uniformly apply a voltage during photoelectrolytic polymerization due to a resistance level of an electrode formed of FTO or the like itself. Further, since it is difficult to uniformly form a hole transportation layer on the entire photoelectric conversion element, the photoelectric conversion element has low photodurability.

In addition, in order to obtain a high photoelectric conversion efficiency from a module-type solar cell in actual use as described in JP 2013-12366 A, it is demanded to reduce an area of a connection portion of each photoelectric conversion element, that is, a portion which does not contribute to power generation. In order to do so, it is necessary to scale up each photoelectric conversion element. However, when a hole transportation layer is formed by photoelectrolytic polymerization, it is difficult to scale up the photoelectric conversion element for the above-described reason. Therefore, there is a problem in that a module with a high photoelectric conversion efficiency cannot be manufactured.

Accordingly, in order to solve this problem, an object of the inventors of the present invention is to provide a photoelectric conversion element module and a method for manufacturing the photoelectric conversion element module capable of exhibiting sufficient power generation performance even in a module-type dye-sensitized solar cell.

The inventors of the present invention conducted a close study to improve durability of a photoelectric conversion element. As a result, they found that when a hole transportation layer is formed, polymerization of a conductive polymer precursor is performed by bringing a photoelectric conversion layer into contact with the conductive polymer precursor and then irradiating a sensitizing dye with light in the presence of an oxidizer, so that a homogeneous hole transportation layer is formed, and thus, durability of a photoelectric conversion element can be improved. Further, the inventors of the present invention conducted a close study to improve power generation performance. As a result, the inventors found that a module obtained by electrically connecting two or more photoelectric conversion elements exhibits excellent power generation performance and thus completed the present invention. That is, the present invention can achieve the above-described object by providing a photoelectric conversion element module obtained by electrically connecting two or more photoelectric conversion elements obtained by stacking a substrate, a first electrode, a photoelectric conversion layer containing a semiconductor and a sensitizing dye, a hole transportation layer having a conductive polymer, and a second electrode in the sequence listed, in which the hole transportation layer is formed by bringing the photoelectric conversion layer into contact with a conductive polymer precursor and then irradiating the sensitizing dye with light in the presence of an oxidizer, whereby the conductive polymer precursor is polymerized.

## Brief Description of Drawings

Fig. 1 is a schematic cross-sectional view illustrating an example of a photoelectric conversion element module according to the present invention. In Fig. 1, reference numeral 10 denotes a photoelectric conversion element; reference numeral 20 denotes a substrate; reference numeral 30 denotes a first electrode; reference numeral 31 denotes an end portion (a connection portion with a second electrode); reference numeral 40 denotes a buffer layer; reference numeral 50 denotes a photoelectric conversion layer; reference numeral 60 denotes a hole transportation layer; reference numeral 70 denotes the second electrode; reference numeral 71 denotes an end portion (a connection portion with the first electrode); reference numeral 8 denotes light; reference numeral 100 denotes a photoelectric conversion element module; and reference numeral X denotes a distance between the first electrodes.

## Description of Embodiments

Hereinafter, preferable embodiments of the present invention will be described.

A first aspect of the present invention relates to a photoelectric conversion element module obtained by electrically connecting two or more photoelectric conversion elements obtained by stacking a substrate, a first electrode, a photoelectric conversion layer containing a semiconductor and a sensitizing dye, a hole transportation layer having a conductive polymer, and a second electrode in the sequence listed, wherein the hole transportation layer is formed by bringing the photoelectric conversion layer into contact with a conductive polymer precursor and then irradiating the sensitizing dye with light in the presence of an oxidizer, whereby the conductive polymer precursor is polymerized. With the above-described configuration, in a photoelectric conversion element module according to the present invention, a solution containing a conductive polymer precursor and an oxidizer is brought into contact with a photoelectric conversion layer and then a hole transportation layer is formed by photochemical polymerization. Thus, the hole transportation layer

is uniform as compared with a hole transportation layer formed by conventional (photo)electrolytic polymerization. Accordingly, it is possible to manufacture an element with high power generation performance.

As described above, conventionally, a hole transportation layer has been formed by electrolytic polymerization such as photoelectrolytic polymerization, but it has been difficult to obtain a homogeneous polymerization layer. Thus, there has been a problem with photodurability of a photoelectric conversion element. Further, there has been known photochemical polymerization of an oxidative polymerizable monomer using an oxidizer and a photosensitizer (for example, JP 1-123228 A, JP 2009-16582 A). However, according to this polymerization method, a mole ratio of the oxidizer to the monomer is small and reactivity is not sufficient. Therefore, it is difficult to form a sufficient film for a photoelectric conversion element, particularly, a photoelectric conversion element for a dye-sensitized solar cell, and the photoelectric conversion element has a low photodurability.

Further, as described above, in order to obtain a high photoelectric conversion efficiency from a module-type solar cell in actual use, it is demanded to reduce an area of a connection portion of each photoelectric conversion element, that is, a portion which does not contribute to power generation. In order to do so, it is necessary to scale up each photoelectric conversion element. If a hole transportation layer is formed by photoelectrolytic polymerization, it is difficult to scale up the photoelectric conversion element as described above. Therefore, a module with a high photoelectric conversion efficiency cannot be manufactured.

In this regard, in the present invention, a sensitizing dye is excited by light irradiation and an excited electron is consumed by an oxidizer (for example, hydrogen peroxide). Accordingly, the sensitizing dye is put into a cation state, and the sensitizing dye in a cation state withdraws electrons from the conductive polymer precursor, whereby the conductive polymer precursor is put into a cation state. The conductive polymer precursor in a cation state acts as a trigger, whereby polymerization is initiated. Herein, according to the present invention, since the sensitizing dye in a cation state efficiently withdraws electrons from the conductive polymer precursor, the polymerization can be initiated more quickly by using the conductive polymer precursor in a cation state as a trigger, by mixing the oxidizer with the conductive polymer precursor at such a ratio that the oxidizer exists at a higher concentration than that of the conductive polymer precursor. Since the above-described process progresses very quickly as compared with a process of electrolytic polymerization, it is possible to shorten the polymerization time, which is very advantageous in simplifying the manufacturing process. Furthermore, it is also possible to easily form a hole transportation layer having a large area by the above-described process.

Furthermore, according to the present invention, since the sensitizing dye promotes polymerization while exerting an action as a polymerization initiator to form a hole transportation layer containing a conductive polymer, it is difficult to peel off the sensitizing dye from the photoelectric conversion layer due to causes such as an external voltage and solvation, and thus, a photoelectric conversion element having an excellent photoelectric conversion efficiency, and a solar cell can be provided.

Further, as described above, according to the present invention, since it is possible to easily form a hole transportation layer having a large area, when a module is manufactured, it is possible to reduce an area of a portion which does not contribute to power generation as compared with a module manufactured by arranging a large number of small photoelectric conversion elements on the entire surface, and thus, a photoelectric conversion element module having an excellent photoelectric conversion efficiency, and a solar cell can be provided.

Further, a method for manufacturing the photoelectric conversion element module obtained by electrically connecting two or more photoelectric conversion elements obtained by stacking a substrate, a first electrode, a photoelectric conversion layer containing a semiconductor and a sensitizing dye, a hole transportation layer having a conductive polymer, and a second electrode in the sequence listed, the method including: forming the photoelectric conversion layer on the first electrode; bringing a conductive polymer precursor into contact with the photoelectric conversion layer in the presence of an oxidizer; irradiating the sensitizing dye with light in the presence of the oxidizer to polymerize the conductive polymer precursor to thereby form the hole transportation layer; forming the second electrode on the hole transportation layer; and electrically connecting at least the two photoelectric conversion elements.

{Photoelectric conversion element module}

A preferable configuration of a photoelectric conversion element module according to the present invention will be described with reference to Fig. 1. Fig. 1 is a schematic cross-sectional view illustrating an example of a photoelectric conversion element module according to the present invention. As illustrated in Fig. 1, a photoelectric conversion element module 100 is formed by electrically connecting two or more photoelectric conversion elements 10. Herein, each of the photoelectric conversion elements 10 includes a substrate 20, a first electrode 30, a buffer layer 40, a photoelectric conversion layer 50, a hole transportation layer 60, and a second electrode 70 as a counter electrode. The photoelectric conversion layer 50 contains a semiconductor (not illustrated) and a sensitizing dye (not illustrated). Each of the photoelectric conversion elements 10 includes the common substrate 20, and the first electrode 30, the buffer layer 40, the photoelectric conversion layer 50, the hole transportation layer 60, and the second electrode 70 are formed in sequence

on the substrate 20. Further, as described above, the photoelectric conversion element 10 is electrically connected with the adjacent photoelectric conversion element 10. Herein, the connection form is not particularly limited, but preferably, the elements 10 may be connected in series. To be more specific, (a) as illustrated in Fig. 1, preferably, an end portion 31 of the first electrode 30 of one of the two adjacent photoelectric conversion elements 10 may be connected in series with an end portion 71 of the second electrode 70 of the other photoelectric conversion element 10. Otherwise, (b) preferably, the end portion 31 of the first electrode 30 of one of the two adjacent photoelectric conversion elements 10 may be connected with the end portion 71 of the second electrode 70 of the other photoelectric conversion element 10 with a conductive member interposed therebetween. Particularly, the form (a) is preferable. That is, as for at least two adjacent photoelectric conversion elements among the photoelectric conversion elements, one end portion of a first electrode of one photoelectric conversion element may be preferably connected with one end portion of a second electrode of the other photoelectric conversion element adjacent to the one photoelectric conversion element.

Further, as illustrated in Fig. 1, the buffer layer 40 may be formed as necessary between the first electrode 30 and the photoelectric conversion layer 50 for the purposes of prevention of short-circuit, sealing and the like.

Herein, a size of the substrate 20 is not particularly limited, and may be suitably selected for desired use (for example, a solar cell). For example, for use in a solar cell, a size of the substrate may be preferably 50 to 3000 mm in length and width and 0.01 to 100 mm in thickness considering the photoelectric conversion efficiency per unit area of the module. Further, a size of each photoelectric conversion element is not particularly limited. However, for example, each photoelectric conversion element may be of such a size that preferably 2 to 300 and more preferably 10 to 100 photoelectric conversion elements can be arranged in series on the substrate. With such a size, the photoelectric conversion element module can show sufficient power generation performance and an area of a portion which does not contribute to power generation can be reduced. Further, preferably, a size of each first electrode 30 may have a ratio of 1 : 2 to 100 between a length (shorter side) and a width (longer side) considering a resistance of an oxide semiconductor or an area contributing to power generation. Furthermore, preferably, a distance ("X" in Fig. 1) between the first electrodes may be as short as possible considering reduction in an area of a portion which does not contribute to power generation and achievement of sufficient photoelectric conversion efficiency, and may be preferably 0.001 to 10 mm and more preferably 0.01 to 1 mm considering formation of the second electrode in a subsequent process.

Further, although Fig. 1 illustrates that the sunlight is incident from a direction indicated by an arrow 8 in the bottom of Fig. 1, the present invention is not limited thereto. The sunlight may be incident in a direction from the top in Fig. 1.

The photoelectric conversion element according to the present invention has a structure in which the substrate, the first electrode, the photoelectric conversion layer, the hole transportation layer, and the second electrode as a counter electrode are stacked in sequence as essential components, and two or more photoelectric conversion elements are electrically connected. If necessary, the buffer layer may be formed between the substrate and the first electrode and/or on a surface of the second electrode. Hereinafter, each component of the photoelectric conversion element according to the present invention and a method for manufacturing a photoelectric conversion element according to the present invention will be described.

"Substrate"

The substrate in the present invention is disposed on the side of the light incidence direction, and may be preferably a transparent substrate and may be more preferably a transparent conductive substrate having the first electrode formed on the surface, and the substrate may have a light transmittance of more preferably 10% or more, still more preferably 50% or more, and particularly preferably from 80% to 100%, in view of the photoelectric conversion efficiency of the photoelectric conversion element.

The light transmittance refers to a total light transmittance in the visible light wavelength region measured by a method based on "Method for testing total light transmittance of plastic-transparent material" in JIS K 7361-1: 1997 (corresponding to ISO 13468-1: 1996).

The material, shape, structure, thickness, hardness and the like of the substrate may be suitably selected from those known in the art, but preferably, the substrate may have a high light transmittivity as described above.

The substrate may be roughly classified into rigid substrates such as glass plates and acrylic plates, and flexible substrates such as film substrates. Among the former rigid substrates, glass plates are preferable in view of heat resistance, and the kind of glass is not particularly limited. A thickness of the substrate may be preferably from 0.1 to 100 mm and more preferably from 0.5 to 10 mm.

Examples of the latter flexible substrates may include polyester-based resin films such as polyethylene terephthalate (PET), polyethylene naphthalate and modified polyesters, polyolefin resin films such as polyethylene (PE) resin films, polypropylene (PP) resin films, polystyrene resin films and cyclic olefin-based resins, vinyl-based resin films such as polyvinyl chloride and polyvinylidene chloride, polyvinyl acetal resin films such as polyvinyl butyral (PVB), polyether ether ketone (PEEK) resin films, polysulfone (PSF) resin films, polyether sulfone (PES) resin films, polycarbonate (PC) resin films, polyamide resin films, polyimide resin films, acrylic resin films, triacetyl cellulose (TAC) resin films, and the

like. In addition to these resin films, inorganic glass films may also be used as the substrate. A thickness of the substrate may be preferably from 1 to 1000 μm and more preferably from 10 to 100 μm.

Any resin film having a transmittance at a wavelength in the visible region (400 to 700 nm) of 80% or more may be particularly and preferably applied to the present invention.

Particularly, in view of transparency, heat-resistance, easiness of handling, intensity and cost, a biaxially-stretched polyethylene terephthalate film, a biaxially-stretched polyethylene naphthalate film, a polyether sulfone film or a polycarbonate film may be preferable, and a biaxially-stretched polyethylene terephthalate film or a biaxially-stretched polyethylene naphthalate film may be more preferable.

These substrates may be subjected to a surface treatment, or an easily adhesive layer may be disposed on these substrates in order to secure wettability for a coating liquid and adhesiveness.

For the surface treatment and easily adhesive layer, conventionally known technologies may be used. Examples of the surface treatment may include surface activation treatments such as a corona discharging treatment, a flame treatment, an ultraviolet treatment, a high frequency treatment, a glow discharge treatment, an active plasma treatment, and a laser treatment.

Furthermore, examples of the easily adhesive layer may include polyesters, polyamides, polyurethanes, vinyl-based copolymers, butadiene-based copolymers, acrylic copolymers, vinylidene-based copolymers, epoxy-based copolymers, and the like.

"First electrode"

The first electrode in the present invention is disposed between the substrate and the photoelectric conversion layer. Herein, the first electrode is disposed on one surface of the substrate which becomes the opposite side of the light incidence direction. As the first electrode, one having a light transmittance of 80% or more or 90% or more (upper limit: 100%) may be preferably used. The light transmittance is the same as described above with respect to the substrate.

A material that forms the first electrode is not particularly limited, and known materials may be used. Examples of the material may include: metals such as platinum, gold, silver, copper, aluminum, rhodium and indium; and $SnO_2$, CdO, ZnO, CTO-based compounds ($CdSnO_3$, $Cd_2SnO_4$, $CdSnO_4$), $In_2O_3$, $CdIn_2O_4$, and metal oxides thereof. Among them, silver may be preferably exemplified as the metal, and a grid-patterned film having openings, or a film formed by dispersing and coating microparticles or nanowires may be preferably used so as to impart light transmittivity. Furthermore, preferable examples of the metal oxides may include composite (doped) materials formed by adding one kind or two or more kinds selected from Sn, Sb, F and Al to the above-described metal oxides. More preferably, conductive metal oxides such as Sn-doped $In_2O_3$ (ITO), Sb-doped $SnO_2$ and F-doped $SnO_2$ (FTO) may be used, and FTO may be the most preferable in view of heat resistance. A coating amount of the material that forms the first electrode onto the substrate is not particularly limited, and may be preferably about 1 to 100 g per 1 $m^2$ of the substrate.

Further, the first electrode in the present invention may be preferably a transparent conductive substrate disposed on the surface of a transparent substrate as the substrate. Herein, the substrate having the first electrode formed on the surface is also referred to as a transparent conductive substrate (or a first electrode substrate).

An average thickness of the transparent conductive substrate is not particularly limited, and may be preferably in the range of from 0.1 mm to 5 mm. Furthermore, the transparent conductive substrate may have a surface resistance of preferably 50 $\Omega/cm^2$ (□(square)) or less, more preferably 20 Ω/□ (square) or less, and still more preferably 10 Ω/□ (square) or less. In addition, a lower limit of the surface resistance of the transparent conductive substrate may be preferably as low as possible, and thus, it is not necessary to particularly define the lower limit, but it is sufficient that the lower limit is 0.01 Ω/□ (square) or more. The preferable range of the light transmittance of the transparent conductive substrate is the same as the preferable range of the light transmittance of the above-described substrate.

"Second electrode"

The second electrode in the present invention may be any one having conductivity, and an optional conductive material is used. An insulating material can also be used as long as a conductive material layer is installed on the side facing the hole transportation layer. Furthermore, preferably, the second electrode may have a good contact property with respect to the hole transportation layer. Preferably, the second electrode may have a small difference in work functions from the hole transportation layer and thus may be chemically stable. Such a material is not particularly limited, and examples of the material may include metal thin films of gold, silver, copper, aluminum, platinum, rhodium, magnesium, indium and the like, carbon, carbon black, organic conductors such as conductive polymer and conductive metal oxides (indium-tin composite oxide, fluorine-doped tin oxide, and the like), and the like. Furthermore, an average thickness of the second electrode is also not particularly limited, and may be preferably from 10 to 1000 nm. Further, a surface resistance of the second electrode is not particularly limited, and may be preferably low. Specifically, the range of the surface resistance of the second electrode may be preferably 80 Ω/□ (square) or less and more preferably 20 Ω/□

(square) or less. In addition, a lower limit of the surface resistance of the second electrode may be preferably as low as possible, and thus, it is not necessary to particularly define the lower limit, but it is sufficient that the lower limit is 0.01 Ω/□ (square) or more.

"Buffer layer"

Preferably, the photoelectric conversion element according to the present invention may have a buffer layer that has a film shape (laminar shape) and is disposed between the first electrode and the photoelectric conversion layer (semiconductor layer) as a means for preventing short-circuit and as a rectification action.
In a preferable embodiment, the buffer layer and photoelectric conversion layer in the present invention may be porous as described below. In this case, when the porosity of the buffer layer is C [%] and the porosity of the semiconductor layer is D [%], for example, D/C may be preferably about 1.1 or more, more preferably about 5 or more, and still more preferably about 10 or more. An upper limit of D/C may be preferably as high as possible, and thus, it is not necessary to particularly define the upper limit, but the upper limit is generally about 1000 or less. By this way, the buffer layer and semiconductor layer may exert their functions respectively in more suitable ways.
More specifically, for example, the porosity C of the buffer layer may be preferably about 20% by volume or less, more preferably about 5% by volume or less, and still more preferably 2% by volume or less. In other words, the buffer layer may be preferably a dense layer. By this way, effects such as prevention of short-circuit and a rectification action may be further improved. Herein, the lower limit of the porosity C of the buffer layer may be preferably as small as possible, and thus, it is not necessary to particularly define the lower limit, but the lower limit is generally about 0.05% by volume or more.
An average thickness of the buffer layer is for example, preferably about 0.01 to 10 μm and more preferably about 0.03 to 0.5 μm. By this way, the above-described effects may be further improved.
A material of the buffer layer in the present invention is not particularly limited, and for example, one kind or combinations of two or more kinds of zinc, niobium, tin, titanium, vanadium, indium, tungsten, tantalum, zirconium, molybdenum, manganese, iron, copper, nickel, iridium, rhodium, chromium, ruthenium or oxides thereof, and perovskites such as strontium titanate, calcium titanate, barium titanate, magnesium titanate and strontium niobate, or composite oxides or oxide mixtures thereof, various metal compounds such as CdS, CdSe, TiC, $Si_3N_4$, SiC and BN, and like may be used.
Particularly, in the case where the hole transportation layer is a p-type semiconductor, if a metal is used in the buffer layer, it is preferable to use a metal which has a smaller value of work function than that of the hole transportation layer and gives Schottky-type contact. Furthermore, in the case where a metal oxide is used in the buffer layer, it is preferable to use a metal oxide which contacts the transparent conductive layer in an ohmic manner and has a lower energy potential of a conduction band than that of the porous semiconductor layer. At this time, the electron transfer efficiency from the porous semiconductor layer (photoelectric conversion layer) to the buffer layer may be improved by selecting an oxide. Among them, those having equivalent electroconductivity to that of the semiconductor layer (photoelectric conversion layer) are preferable, and those containing titanium oxide as a major component are particularly more preferable.
In this case, the titanium oxide layer may be either of an anatase type titanium oxide and a rutile type titanium oxide having a relatively high dielectric constant.

"Photoelectric conversion layer"

Preferably, the photoelectric conversion layer in the present invention may be formed of a semiconductor layer containing a semiconductor and a sensitizing dye which is carried by the semiconductor.
The total content of the dye per 1 $m^2$ of the photoelectric conversion layer may be preferably from 0.01 to 100 $mmol/m^2$, more preferably from 0.1 to 50 $mmol/m^2$, particularly preferably from 0.5 to 20 $mmol/m^2$.

(Semiconductor)

In the semiconductor according to the present invention, simple substances such as silicon and germanium, compounds having elements of Group 3 to Group 5 and Group 13 to Group 15 in the Periodic Table (also referred to as Elemental Periodic Table), metal oxides, metal sulfides, metal serenides, or metal nitrides may be used.
Examples of preferable semiconductors may include titanium oxide, tin oxide, zinc oxide, iron oxide, tungsten oxide, zirconium oxide, hafnium oxide, strontium oxide, oxides of indium, cerium, yttrium, lanthanum, vanadium and niobium, or tantalum oxide, cadmium sulfide, zinc sulfide, lead sulfide, silver sulfide, antimony or bismuth sulfide, cadmium or lead serenide, cadmium telluride, and the like. Furthermore, examples of other compound semiconductors may include phosphides of zinc, gallium, indium, cadmium and the like, serenide of gallium-arsenide or copper-indium, sulfide of

copper-indium, titanium nitride, and the like. More specifically, specific examples of the semiconductor may include $TiO_2$, $SnO_2$, $Fe_2O_3$, $WO_3$, ZnO, $Nb_2O_5$, CdS, ZnS, PbS, $Bi_2S_3$, CdSe, CdTe, GaP, InP, GaAs, $CuInS_2$, $CuInSe_2$, $Ti_3N_4$, and the like. Among them, $TiO_2$, ZnO, $SnO_2$, $Fe_2O_3$, $WO_3$, $Nb_2O_5$, CdS, and PbS may be preferably used, $TiO_2$ or $Nb_2O_5$ may be more preferably used, and titanium oxide ($TiO_2$) may be still more preferably used. The above-described semiconductors may be used singly, or plural semiconductors may be used in combination. For example, several kinds of the above-described metal oxides or metal sulfides may be used in combination, and a titanium oxide semiconductor may be used by mixing with 20 mass% of titanium nitride ($Ti_3N_4$). Furthermore, the zinc oxide/tin oxide composite described in J. Chem. Soc., Chem. Commun., 15 (1999) may be used. At this time, in the case where a component other than the metal oxide or metal sulfide is added as a semiconductor, a mass ratio of the additional component to the metal oxide or metal sulfide semiconductor may be preferably 30% or less.

In addition, in the case where $TiO_2$ is used in the semiconductor layer, the $TiO_2$ may be either of an anatase type titanium oxide and/or a rutile type titanium oxide having a relatively high dielectric constant.

Examples of a shape of the semiconductor in the present invention may include a filler shape, a particulate shape, a cone shape, a columnar shape, a tubular shape, a flat plate shape and the like, and the shape is not particularly limited. Furthermore, as the semiconductor layer in the present invention, a film-shaped semiconductor formed by flocculation of semiconductors having a filler shape, a particulate shape, a cone shape, a columnar shape, a tubular shape, and the like may be used. Furthermore, in this case, a semiconductor formed by coating the surface with a sensitizing dye in advance may be used, or a layer formed of a semiconductor may be formed and then, the layer may be coated with a sensitizing dye.

In the case where the semiconductor in the present invention has a particulate shape, the particles may be preferably primary particles and have an average particle size of preferably from 1 to 5000 nm and more preferably from 2 to 100 nm. Herein, the "average particle size" of the semiconductor is an average particle size of primary particle diameters (primary average particle size (diameter)) when 100 or more samples are observed under an electron microscope.

Furthermore, the semiconductor in the present invention may be subjected to a surface treatment by using an organic base. Examples of the above-described organic base may include diarylamine, triarylamine, pyridine, 4-t-butyl pyridine, polyvinyl pyridine, quinoline, piperidine, amidine, and the like. Among them, pyridine, 4-t-butyl pyridine and polyvinyl pyridine are particularly preferable. Herein, a method for the surface treatment of the semiconductor is not particularly limited, and a known method may be used as it is or after suitable modification. For example, in the case where the above-described organic base is a liquid, the liquid is used in its original form, or in the case where the above-described organic base is a solid, a solution dissolved in an organic solvent (an organic base solution) is prepared, and the semiconductor in the present invention is immersed in the above-described liquid organic base or organic base solution at 0 to 80°C for 1 minute to 24 hours, whereby the surface treatment of the semiconductor can be conducted.

(Sensitizing dye)

The sensitizing dye in the present invention is carried by the semiconductor by the above-described treatment for sensitizing the semiconductor, and may generate an electromotive force by being excited by light upon irradiation with light. An arylamine-based dye may be preferable, and a compound represented by the following General Formula (1) may be more preferable.

[Chemical Formula 1]

General Formula (1)

$$(R_3)_{3-n}N-(Ar-(A_1)_p-(A_2)_q-Z)_n$$

In the above-described General Formula (1), $R_3$S each independently represent a hydrogen atom, a halogen atom, a substituted or unsubstituted alkyl group, a substituted or unsubstituted alkoxy group, a substituted or unsubstituted alkenyl group, a substituted or unsubstituted alkynyl group, a substituted or unsubstituted aryl group, an amino group ($-NH_2$), a cyano group (-CN), or a substituted or unsubstituted heterocyclic group. When n is 1, two $R_3$S may be different from each other and $R_3$ may be connected with another substituent to form a cyclic structure. Similarly, the moieties of the formula: $-Ar(A_1)_p-(A_2)_q-Z$ (the right part connected to the nitrogen atom in General Formula (1)) in the case where n is 2 or 3 may be identical to or different from each other. Ar represents a bivalent cyclic compound group. $A_1$ and $A_2$ each independently represent a single bond, a bivalent saturated or unsaturated hydrocarbon group, a substituted or unsubstituted alkylene group, an arylene group, or a bivalent heterocyclic group. Z is an organic group having an acidic group, alkoxysilane, or halogenated silane, and may be preferably an organic group containing at least one carboxyl

group. When n is 2 or more, plural $A_1S$, $A_2S$ and Zs may be different from each other. p and q are each independently an integer of 0 or more and 6 or less. Herein, p and q may be identical to or different from each other. In the case where p is 2 or more, $A_1S$ may be identical to or different from each other. Similarly, in the case where q is 2 or more, $A_2S$ may be identical to or different from each other. n is an integer of 1 or more and 3 or less, and may be preferably 2.

Ar in General Formula (1) is not particularly limited, and for example, a bivalent to tetravalent cyclic compound group may be preferable. Specific examples of the cyclic compound group may include those derived from aromatic rings such as a benzene ring, a naphthalene ring, an anthracene ring, a thiophene ring, a phenyl thiophene ring, a diphenyl thiophene ring, an imidazole ring, an oxazole ring, a thiazole ring, a pyrrole ring, a furan ring, a benzimidazole ring, a benzoxazole ring, a rhodanine ring, a pyrazolone ring, an imidazolone ring, a pyran ring, a pyridine ring, and a fluorene ring. A plurality of these aromatic rings may be used in combination, and may include, for example, a biphenyl group, a terphenyl group, a fluorenyl group, a bithiophene group, a 4-thienyl phenyl group, a diphenyl styryl group, and the like, and groups derived from stilbene, 4-phenyl methylene-2,5-cyclohexadiene, triphenyl ethene (for example, 1,1,2-triphenyl ethene), phenyl pyridine (for example, 4-phenyl pyridine), styryl thiophene (for example, 2-styryl thiophene), 2-(9H-fluoren-2-yl)thiophene, 2-phenylbenzo[b]thiophene, a phenyl bithiophene ring, (1,1-diphenyl-4-phenyl)-1,3-butadiene, 1,4-diphenyl-1,3-dibutadiene, 4-(phenyl methylene)-2,5-cyclohexadiene, and a phenyl dithienothiophene ring. These aromatic rings may have substituents, and examples of the substituents may include halogen atoms (for example, fluorine, chlorine, bromine, and the like), straight chain or branched alkyl groups having a carbon chain length of 1 to 24 (for example, a methyl group, an ethyl group, a t-butyl group, an isobutyl group, a dodecyl group, an octadecyl group, a 3-ethylpentyl group), hydroxyalkyl groups (for example, a hydroxymethyl group, a hydroxyethyl group), alkoxy alkyl groups (for example, a methoxyethyl group and the like), alkoxy groups having a carbon chain length of 1 to 18 (for example, a methoxy group, an ethoxy group, an ethoxy group, a propoxy group, an isopropoxy group, a butoxy group, a pentyloxy group, a hexyloxy group, and the like), aryl groups (for example, a phenyl group, a tolyl group, and the like), alkenyl groups (for example, a vinyl group, an allyl group, and the like), amino groups (for example, a dimethylamino group, a diethylamino group, a diphenylamino group), and heterocyclic groups (for example, a morphonyl group, a furanyl group, and the like), each of which is substituted or unsubstituted. Furthermore, bivalent or trivalent aromatic groups formed by removing two or three hydrogen atoms from the above-described aromatic groups may be preferable.

As Ar in General Formula (1) according to the present invention, the following Chemical Formulas (1-A) to (1-G) are encompassed as preferable groups.

[Chemical Formula 2]

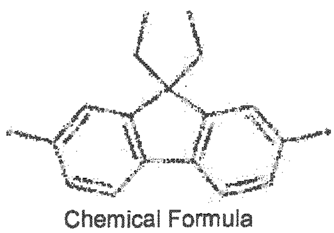

Chemical Formula (1-A)

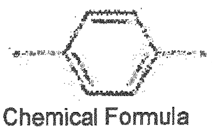

Chemical Formula (1-B)

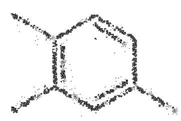

Chemical Formula (1-C)

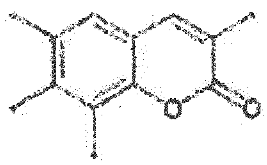

Chemical Formula (1-D)

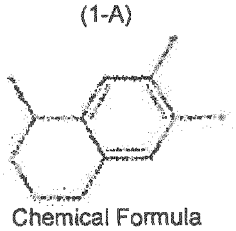

Chemical Formula (1-E)

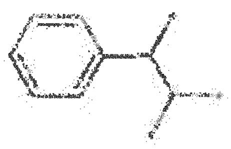

Chemical Formula (1-F)

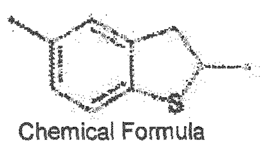

Chemical Formula (1-G)

Furthermore, the alkyl group in General Formula (1) may be preferably a straight chain or branched alkyl group having a carbon chain length of 1 to 30 or a cycloalkyl group having a carbon chain length of 3 to 10, and more preferably a straight chain or branched alkyl group having a carbon chain length of 1 to 24 or a cycloalkyl group having a carbon chain length of 3 to 9. Among them, the straight chain or branched alkyl group having a carbon chain length of 1 to 30 is not particularly limited. Examples of the alkyl group may include a methyl group, an ethyl group, a n-propyl group, an isopropyl group, a n-butyl group, an isobutyl group, a sec-butyl group, a tert-butyl group, a n-pentyl group, an isopentyl group, a tert-pentyl group, a neopentyl group, a 1,2-dimethylpropyl group, a n-hexyl group, an isohexyl group, a 1, 3-dimethylbutyl group, a 1-isopropyl propyl group, a 1,2-dimethylbutyl group, a n-heptyl group, a 1,4-dimethylpentyl group, a 3-ethylpentyl group, a 2-methyl-1-isopropylpropyl group, a 1-ethyl-3-methyl butyl group, a n-octyl group, a 2-ethyl hexyl group, a 3-methyl-1-isopropyl butyl group, a 2-methyl-1-isopropyl group, a 1-t-butyl-2-methylpropyl group, a n-nonyl group, a 3,5,5-trimethylhexyl group, a n-decyl group, an isodecyl group, a n-undecyl group, a 1-methyldecyl group, a n-dodecyl group, a n-tridecyl group, a n-tetradecyl group, a n-pentadecyl group, a n-hexadecyl group, a n-heptadecyl group, a n-octadecyl group, a n-nonadecyl group, a n-eicosyl group, a n-heneicosyl group, a n-docosylgroup, a n-tricosyl group, a n-tetracosyl group, and the like. Among them, straight chain or branched alkyl groups having a carbon chain length of 6 to 24 may be preferable, and straight chain alkyl groups having a carbon chain length of 6 to 18 may be preferable.

Furthermore, the above-described cycloalkyl group having a carbon chain length of 3 to 10 is also not particularly limited. Examples of the cycloalkyl group may include a cyclopropyl group, a cyclobutyl group, a cyclopentyl group, a cyclohexyl group, a cycloheptyl group, a cyclooctyl group, a cyclononyl group, a cyclodecyl group, and the like. Among them, cycloalkyl groups having a carbon chain length of 3 to 6 may be preferable.

Among them, straight chain or branched alkyl groups having a carbon chain length of 1 to 18 and cycloalkyl groups having a carbon chain length of 3 to 7 may be preferable, and straight chain alkyl groups having a carbon chain length of 1 to 6 such as a methyl group, an ethyl group, a n-propyl group, a n-butyl group, a n-pentyl group and a n-hexyl group, and branched alkyl groups having a carbon chain length of 3 to 6 such as an isopropyl group and a t-butyl group, and cycloalkyl groups having a carbon chain length of 5 to 6 such as a cyclopentyl group and a cyclohexyl group may be more preferable.

The alkoxy group in general General Formula (1) is not particularly limited, and may be preferably an alkoxy group having a carbon chain length of 1 to 30 and preferably an alkoxy group having a carbon chain length of 1 to 18. Examples of the alkoxy group may include a methoxy group, an ethoxy group, a propoxy group, an isopropoxy group, a butoxy group, an isobutoxy group, a sec-butoxy group, a tert-butoxy group, a pentyloxy group, an isopentyloxy group, a hexyloxy group, a 2-ethyl hexyloxy group, an octyloxy group, a nonyloxy group, a decyloxy group, an undecyloxy group, a dodecyloxy group, a tridecyloxy group, a tetradecyloxy group, a pentadecyloxy group, a hexadecyloxy group, a heptadecyloxy group, an octadecyloxy group, a n-heneicosyloxy group, a n-docosyloxy group, a n-tricosyloxy group, a n-tetracosyloxy group, and the like. Among them, alkoxy groups having a carbon chain length of 6 to 18 may be preferable, and a hexyloxy group and a decyloxy group may be more preferable.

The alkenyl group in General Formula (1) is not particularly limited, and the alkenyl group may be either straight, branched or cyclic. Furthermore, the carbon number that the alkenyl group has may be preferably 2 to 18. Specific examples of the alkenyl group may include a vinyl group, an allyl group, a propenyl group, an isopropenyl group, a 1-butenyl group, a 2-butenyl group, a 3-butenyl group, a 1-hexenyl group, a 2-hexenyl group, a 3-hexenyl group, 4-hexenyl group, 5-hexenyl group, a cyclopentenyl group, a cyclohexenyl group, a cyclooctenyl group, and the like. Other alkenyl groups may also be used.

The alkynyl group in General Formula (1) is not particularly limited, and may be either straight, branched or cyclic. Furthermore, the carbon number that the alkynyl group has may be preferably 2 to 18. Specific examples of the alkynyl group may include an ethynyl group, a 2-propynyl group, a 2-butynyl group, and the like. Other alkynyl groups may also be used.

The aryl group in General Formula (1) is not particularly limited, and may include, for example, a phenyl group, a naphthyl group, biphenyl group, a fluorenyl group, an anthryl group, a pyrenyl group, an azulenyl group, an acenaphthylenyl group, a terphenyl group, a phenanthryl group, and the like. Among them, a phenyl group, a biphenyl group, and a naphthyl group are preferable.

The heterocyclic group in General Formula (1) is not particularly limited, and may be preferably a heterocyclic group containing at least one kind hetero atom selected from a nitrogen atom, an oxygen atom, and a sulfur atom. The heterocyclic group is not limited to a monocyclic heterocyclic group, and may also be a condensed heterocyclic group in which a plurality of heterocyclic rings is condensed (for example, a group derived from dithieno [3, 2-b: 2', 3'-d] thiophene in which three thiophene rings are condensed, or a condensed heterocyclic group in which a heterocyclic ring and a hydrocarbon ring (a non-aromatic hydrocarbon ring or an aromatic hydrocarbon ring) are condensed (ortho-condensed, ortho and peri-condensed). Furthermore, the heterocyclic group may be either non-aromatic or aromatic. In addition, in the condensed heterocyclic group in which a heterocyclic ring and a hydrocarbon ring are condensed, either of the heterocyclic ring or hydrocarbon ring may have a bond. Specific examples of the heterocyclic group in General Formula (1) may include a pyrrolyl group, an imidazolyl group, a pyridyl group, a pyrazinyl group, an indolyl group, a quinolyl group, an isoquinolyl group, a quinazolyl group, a carbazolyl group, a carbolinyl group, a phenanthrydinyl group, an acridinyl group, a phenazinyl group, isobenzofuranyl, a chromenyl group, a thienyl group, a thianthrenyl group, a morpholinyl group, an isothiazolyl group, an isoxazolyl group, a phenoxathiinyl group, and the like. Preferable heterocyclic groups may be a pyrrolyl group, an indolyl group, and a carbazolyl group.

Furthermore, the "substituted or unsubstituted" in General Formula (1) of the present invention means that at least one hydrogen atom in the alkyl group, alkoxy group, alkenyl group, alkynyl group, aryl group, and heterocyclic group exemplified above is substituted with another substituent, and the substituent may be substituted to the extent that the above-described alkyl group, alkoxy group, alkenyl group, alkynyl group, aryl group and heterocyclic group does not exceed the number of the carbon number. The same will apply to the following. The substituent that is optionally present is not the same as the group to be substituted. For example, in the case where $R_3$ is an alkyl group, the alkyl

group cannot be substituted with an alkyl group.

As $R_3$ in General Formula (1) according to the present invention, the following Chemical Formulas (2-A) to (2-S) are encompassed as preferable groups.

[Chemical Formula 3]

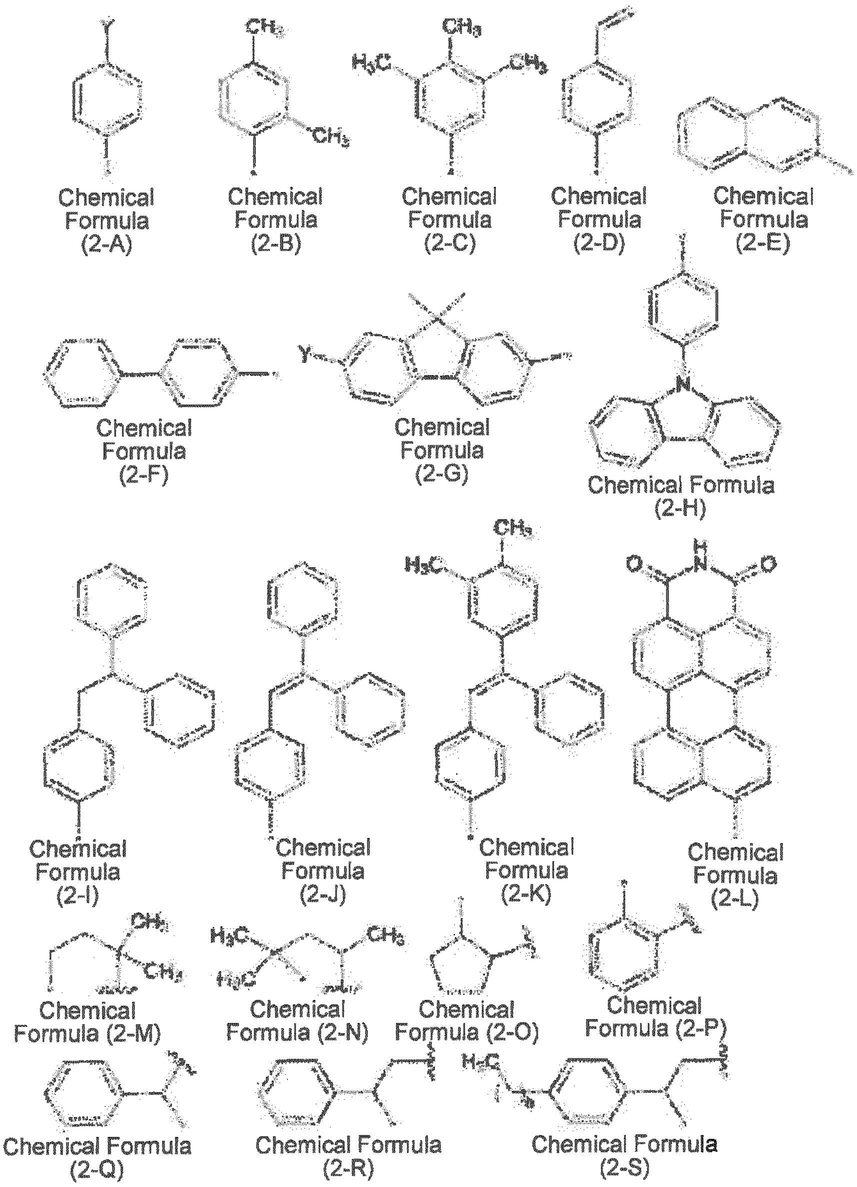

Chemical Formula (2-A) Chemical Formula (2-B) Chemical Formula (2-C) Chemical Formula (2-D) Chemical Formula (2-E)

Chemical Formula (2-F) Chemical Formula (2-G) Chemical Formula (2-H)

Chemical Formula (2-I) Chemical Formula (2-J) Chemical Formula (2-K) Chemical Formula (2-L)

Chemical Formula (2-M) Chemical Formula (2-N) Chemical Formula (2-O) Chemical Formula (2-P)

Chemical Formula (2-Q) Chemical Formula (2-R) Chemical Formula (2-S)

Furthermore, in Chemical Formula (2-S), h is a polymerization degree and is an integer of 1 or more and 17 or less.

In Chemical Formulas (2-A) and (2-G), Y represents a hydrogen atom, the above-described alkyl group, alkoxy group, alkenyl group, alkynyl group, aryl group or heterocyclic group, and may be preferably a hydrogen atom, an alkyl group, or an alkoxy group. Furthermore, in Chemical Formulas (2-M) to (2-S), the wavy line part represents a position to be connected to another group. For example, $R_3$ forms condensed cyclic structure together with Ar by the connection to another group at the broken line part.

The alkylene group in General Formula (1) is not particularly limited and has a straight or branched chain form. Examples of the alkylene group may include a methylene group, an ethylene group, a propylene group, a butylene group, an isobutylene group, a sec-butylene group, a tert-butylene group, a pentylene group, an iso-pentylene group, a hexylene group, and the like.

The arylene group in General Formula (1) is not particularly limited, and examples of the arylene group may include a phenylene group, a biphenyl-diyl group, a terphenyl-diyl group, a naphthalene-diyl group, an anthracene-diyl group, a tetracene-diyl group, a fluorene-diyl group, a phenanthrene-diyl group, and the like.

As $A_1$ and $A_2$ in General Formula (2) according to the present invention, the following Chemical Formulas (3-A) to (3-Z) and Chemical Formulas (3-a) to (3-b) are encompassed as preferable groups.

[Chemical Formula 4]

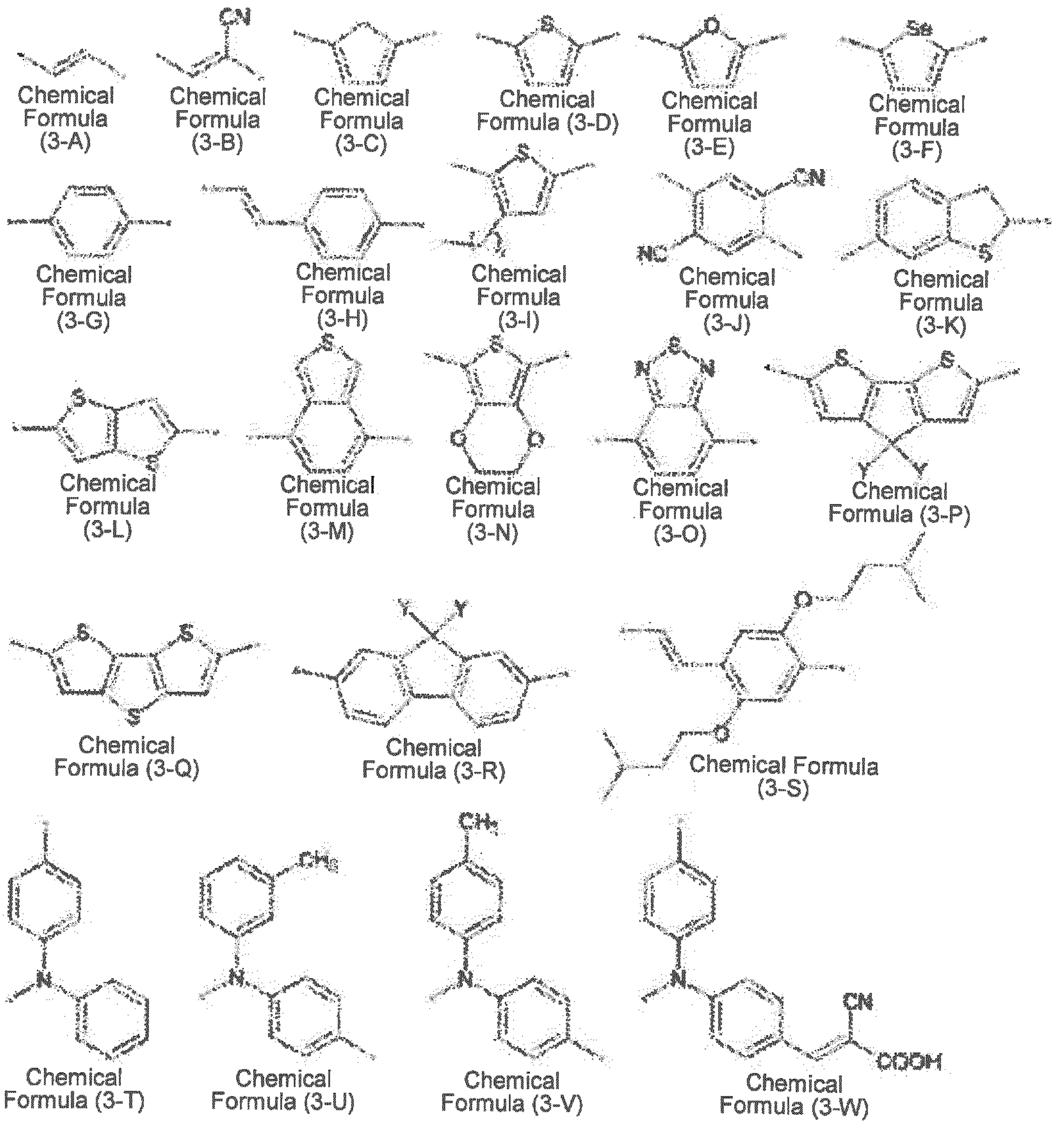

Chemical Formula (3-A) Chemical Formula (3-B) Chemical Formula (3-C) Chemical Formula (3-D) Chemical Formula (3-E) Chemical Formula (3-F)

Chemical Formula (3-G) Chemical Formula (3-H) Chemical Formula (3-I) Chemical Formula (3-J) Chemical Formula (3-K)

Chemical Formula (3-L) Chemical Formula (3-M) Chemical Formula (3-N) Chemical Formula (3-O) Chemical Formula (3-P)

Chemical Formula (3-Q) Chemical Formula (3-R) Chemical Formula (3-S)

Chemical Formula (3-T) Chemical Formula (3-U) Chemical Formula (3-V) Chemical Formula (3-W)

[Chemical Formula 5]

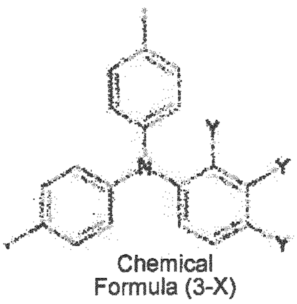

Chemical Formula (3-X)

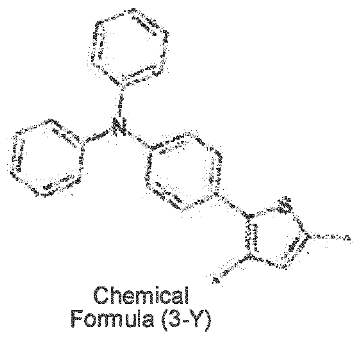

Chemical Formula (3-Y)

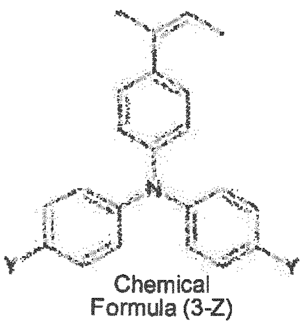

Chemical Formula (3-Z)

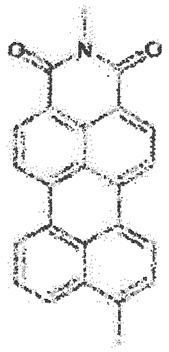

Chemical Formula (3-a)

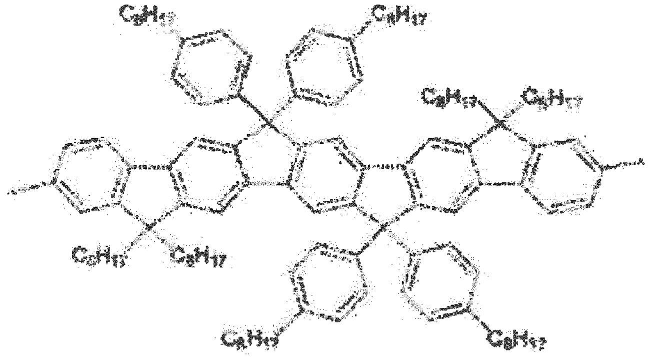

Chemical Formula (3-b)

Further, in Chemical Formula (3-I), i is a polymerization degree, and is an integer of 1 or more and 17 or less. Furthermore, in Chemical Formulas (3-P), (3-R), (3-X), and (3-Z), Y represents a hydrogen atom, the above-described alkyl group, alkoxy group, alkenyl group, alkynyl group, aryl group or heterocyclic group, and may be preferably a hydrogen atom, an alkyl group, or an alkoxy group.

Further, in General Formula (1), Z is an organic group having an acidic group, an alkoxysilane or a halogenated silane, may be preferably an organic group having a partial structure of either of Ar having an acidic group and an electron withdrawing group or an electron withdrawing cyclic structure and more preferably an organic group containing at least one carboxyl group. Furthermore, this partial structure Z is substituted with at least one hydrogen atom (H) existing in either of Ar, $Ar_1$ and $Ar_2$, and $R_3$ in General Formula (1), and may be preferably substituted with at least the hydrogen atom (H) at the terminal of $Ar_2$. In this case, examples of the acidic group in the partial structure Z may include a carboxyl group, a sulfo group [$-SO_3H$], a sulfino group, a sulfinyl group, a phosphonic acid group [$-PO(OH)_2$], a phosphoryl group, a phosphinyl group, a phosphono group, a thiol group, a hydroxy group, a phosphonyl group, an alkoxysilane group, and a sulfonyl group; and salts thereof. Among them, as the acidic group, a carboxyl group, a sulfo group, a phosphonic acid group, and a hydroxy group are preferable, and a carboxyl group is more preferable. Furthermore, examples of the electron withdrawing group may include a cyano group, a nitro group, a fluoro group, a chloro group, a bromo group, an iodine group, a perfluoroalkyl group (for example, a trifluoromethyl group), an alkylsulfonyl group, an arylsulfonyl group, a perfluoroalkylsulfonyl group, a perfluoroarylsulfonyl group, and the like. Among them, a cyano group, a nitro group, a fluoro group, and a chloro group are preferable, and a cyano group and a nitro group are more preferable. Examples of the electron withdrawing cyclic structure may include a rhodanine ring, a dirhodanine ring, an imidazolone ring, a pyrazolone ring, a pyrazoline ring, a quinone ring, a pyran ring, a pyrazine ring, a pyrimidine ring, an imidazole ring, an indole ring, a benzothiazole ring, a benzimidazole ring, a benzo oxazole ring, a thiadiazole ring, and the like. Among them, a rhodanine ring, a dirhodanine ring, an imidazolone ring, a pyrazoline ring, a quinone ring, and a thiadiazole ring are preferable, and a rhodanine ring, a dirhodanine ring, an imidazolone ring, and a pyrazoline ring are more preferable. These Zs may effectively inject photoelectrons to a semiconductor (particularly, an oxide semiconductor). Furthermore, in the partial structure Z, the acidic group and the electron withdrawing group or electron withdrawing cyclic structure may be bonded via an atom such as an oxygen atom (O), a sulfur atom (S), a selenium atom (Se), or a tellurium atom (Te). Alternatively, the partial structure Z may be charged, particularly positively charged. In this case, the partial structure Z may have a counter ion such as $Cl^-$, $Br^-$, $I^-$, $ClO_4^-$, $NO_3^-$, $SO_4^{2-}$, or $H_2PO_4^-$.

That is, preferable examples of Z in General Formula (2) may include the following Chemical Formulas (4-A) to (4-N) .

[Chemical Formula 6]

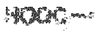
Chemical Formula (4-A)

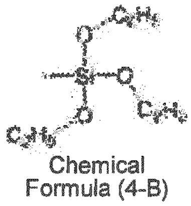
Chemical Formula (4-B)

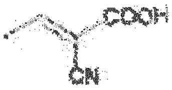
Chemical Formula (4-C)

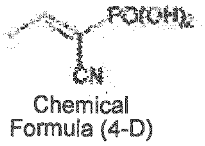
Chemical Formula (4-D)

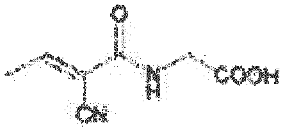
Chemical Formula (4-E)

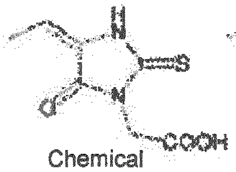
Chemical Formula (4-F)

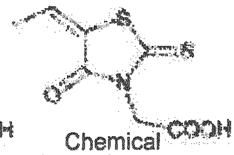
Chemical Formula (4-G)

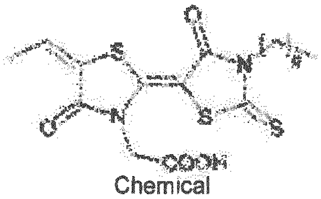
Chemical Formula (4-H)

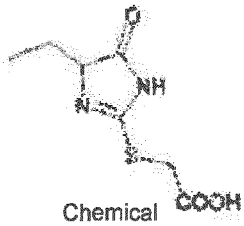
Chemical Formula (4-I)

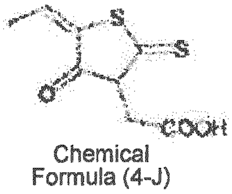
Chemical Formula (4-J)

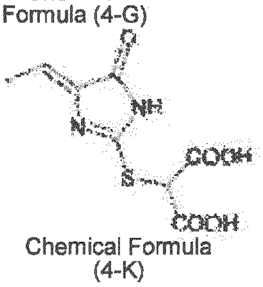
Chemical Formula (4-K)

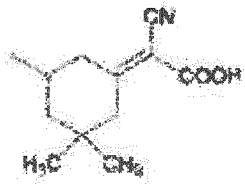
Chemical Formula (4-L)

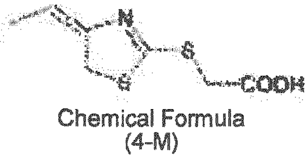
Chemical Formula (4-M)

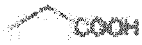
Chemical Formula (4-N)

In Chemical Formula (4-H), g represents a polymerization degree, and is an integer of 1 or more and 17 or less.

In the present invention, since a dye is not deteriorated by the detachment of $CO_2$ (Kolbe electrolysis) by an applied voltage even if a carboxyl group is present, a sensitizing dye having a carboxyl group may be suitably used.

Furthermore, particularly preferable examples of the sensitizing dye in the present invention are shown below.

[Chemical Formula 7]

A-1

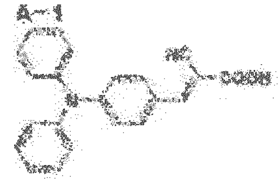

A-2

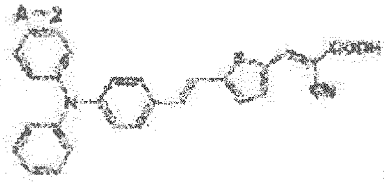

A-3

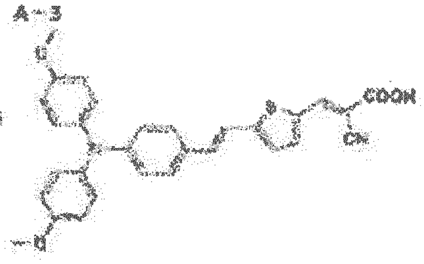

A-4

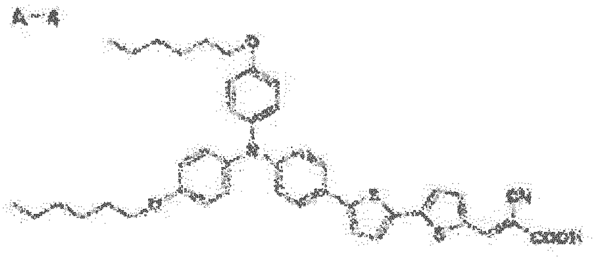

A-5

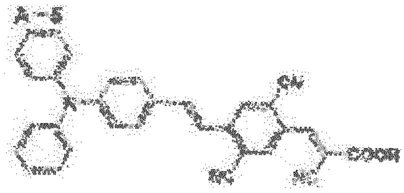

A-6

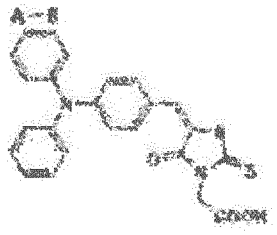

A-7

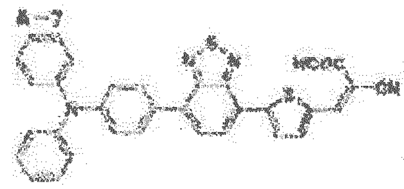

A-8

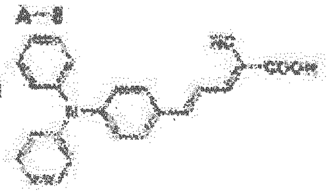

A-9

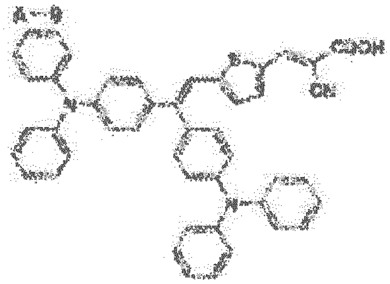

A-10

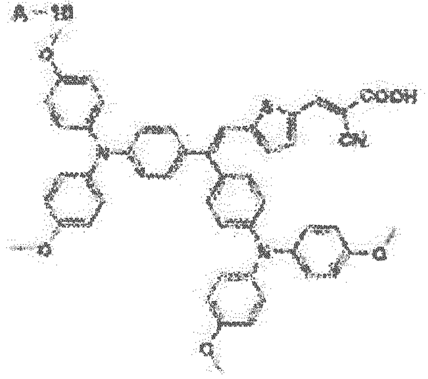

A-11

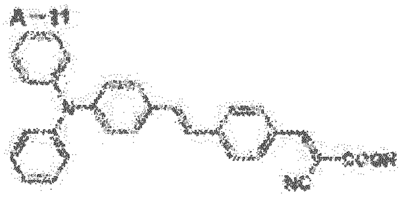

A-12

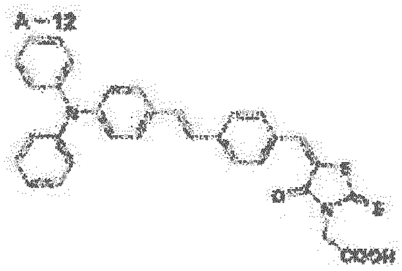

[Chemical Formula 8]

A-13

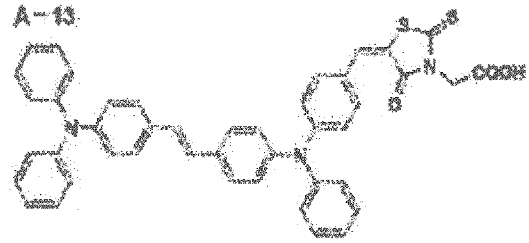

A-14

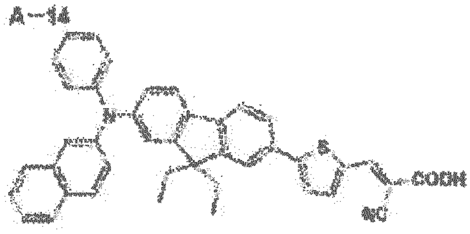

A-16

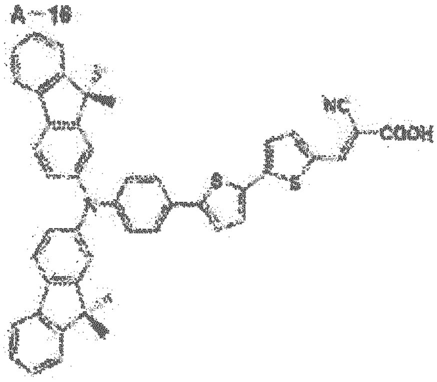

A-15

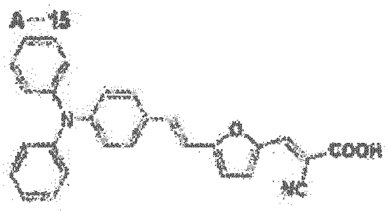

A-18

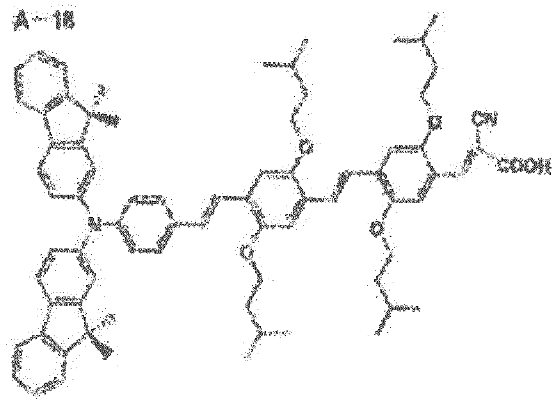

A-17

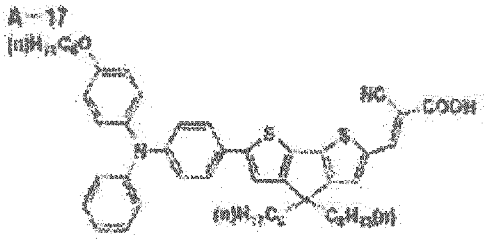

A-19

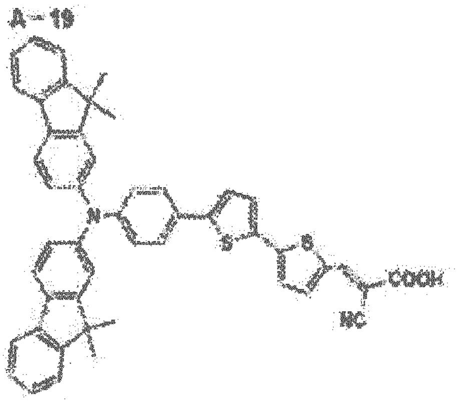

A-20

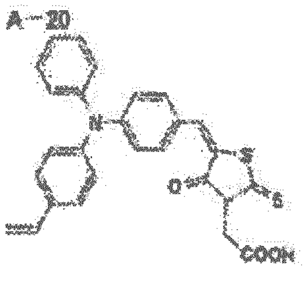

[Chemical Formula 9]

A-21

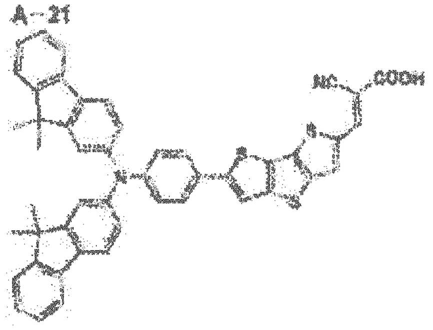

A-22

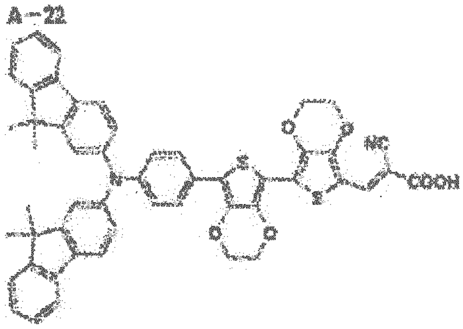

A-23

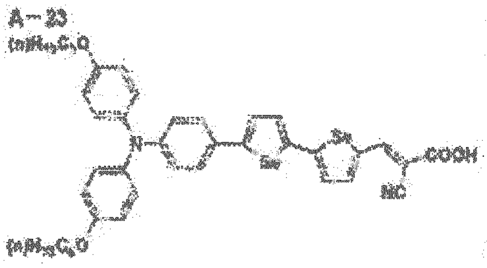

A-24

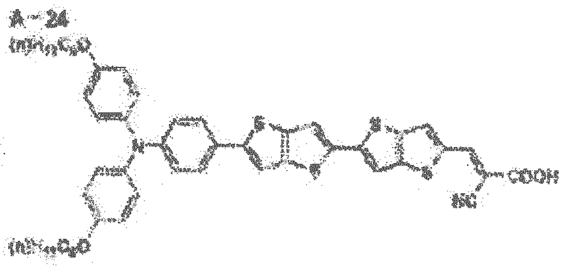

A-25

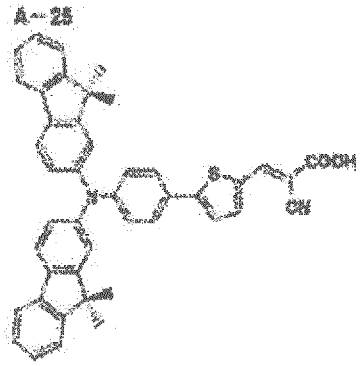

A-26

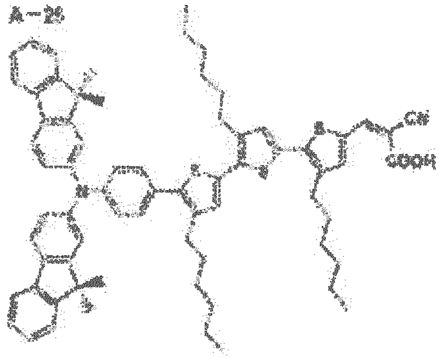

A-27

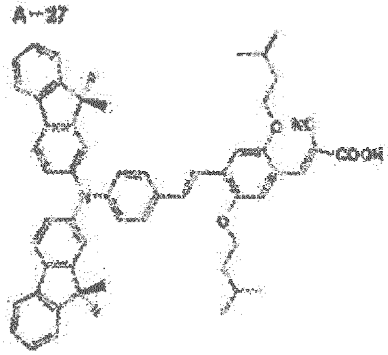

A-28

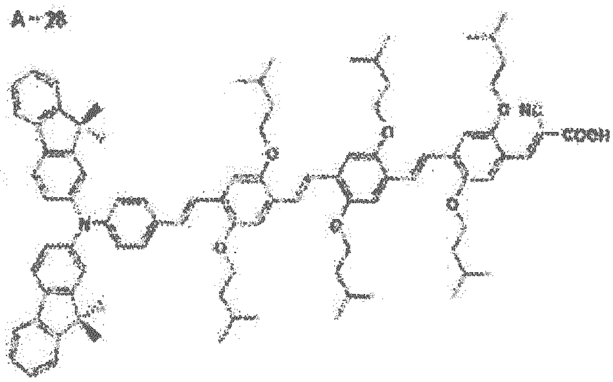

[Chemical Formula 10]

A-29

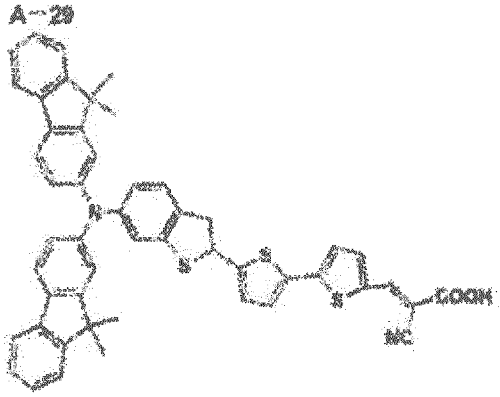

A-30

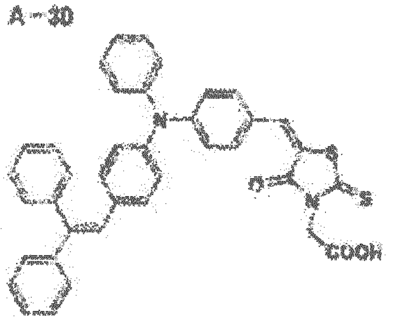

A-31

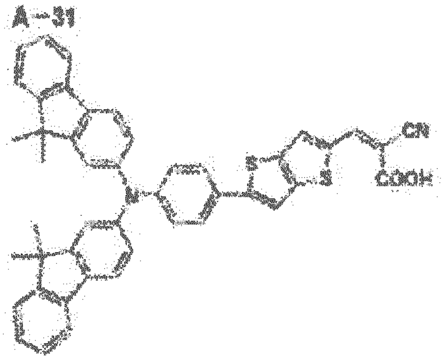

A-32

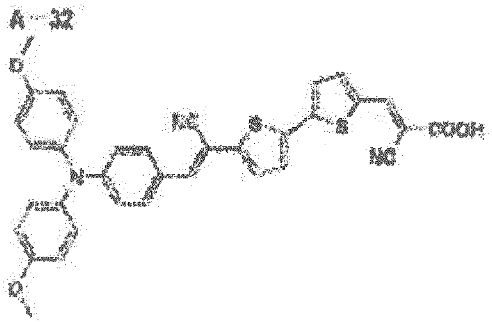

A-33

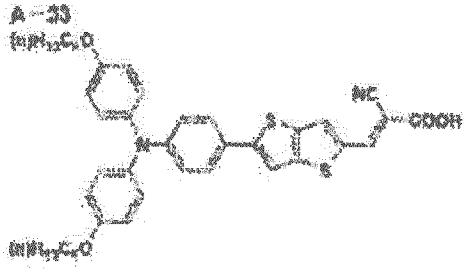

A-34

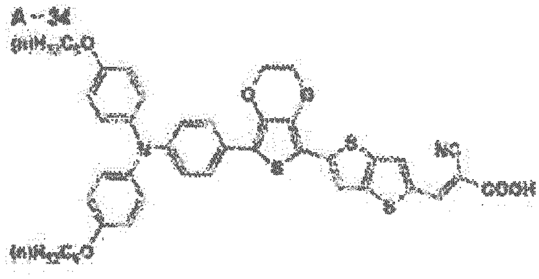

A-36

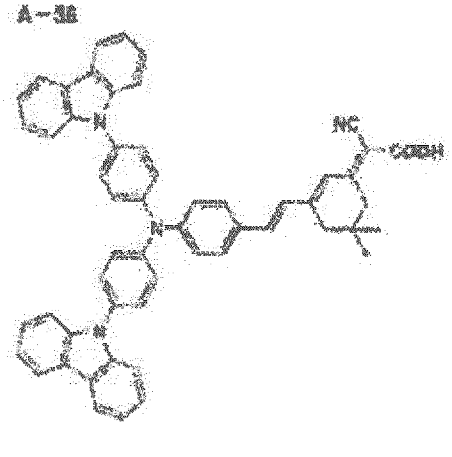

A-35

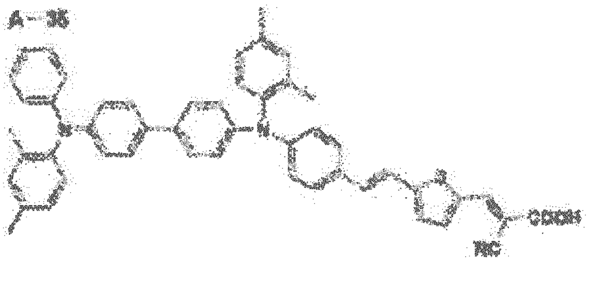

[Chemical Formula 11]

A-37

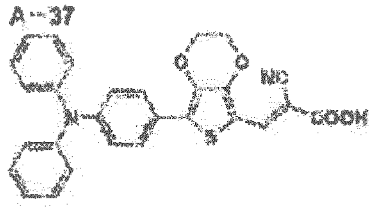

A-38

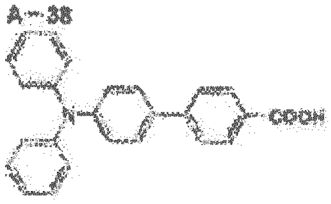

A-39

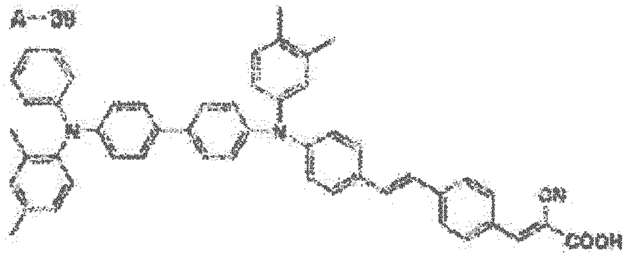

A-40

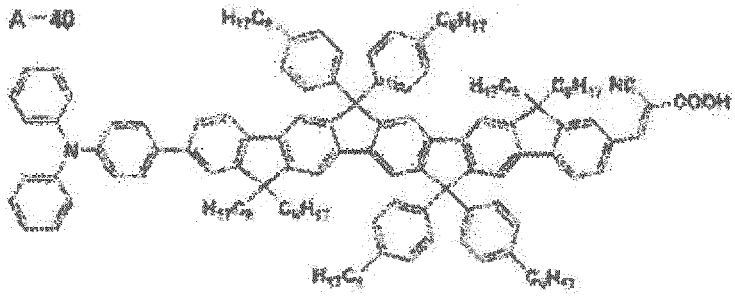

A-42

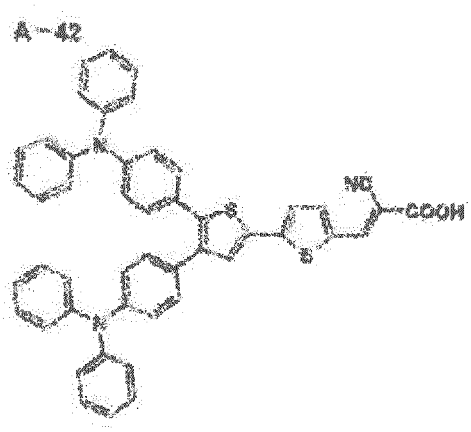

A-41

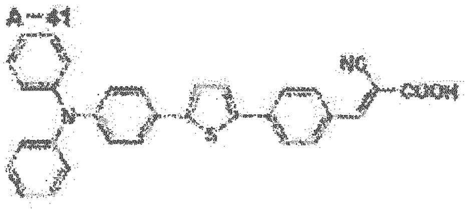

A-43

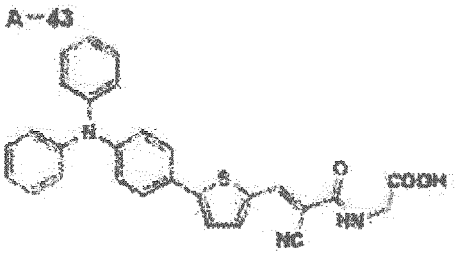

A-44

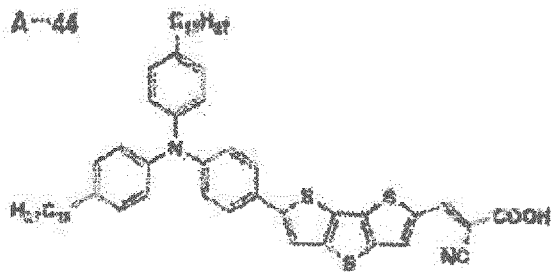

[Chemical Formula 12]

A－46

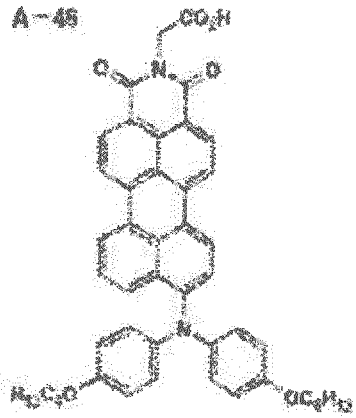

A－45

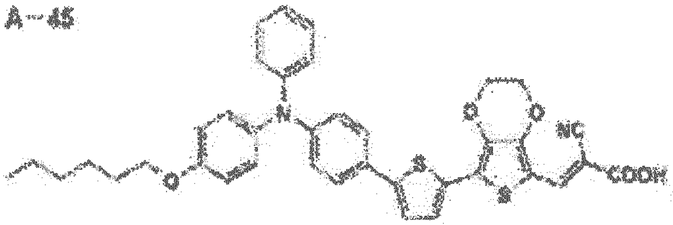

A－47

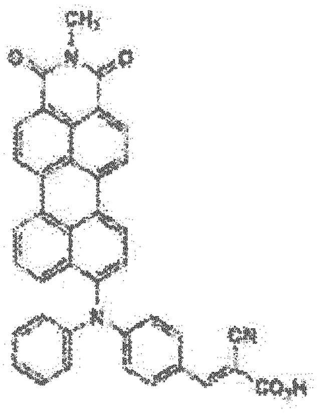

A－48

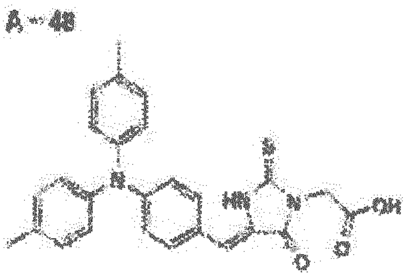

A－49

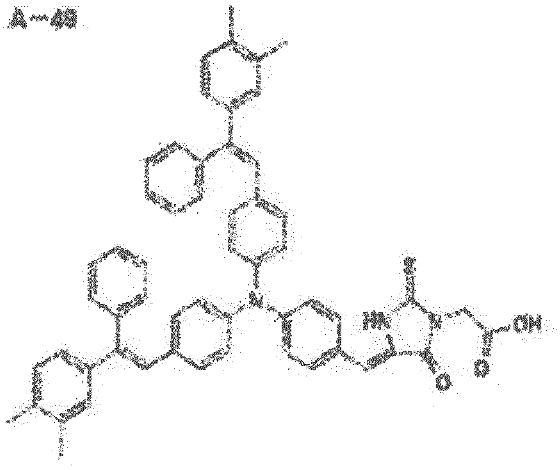

A－50

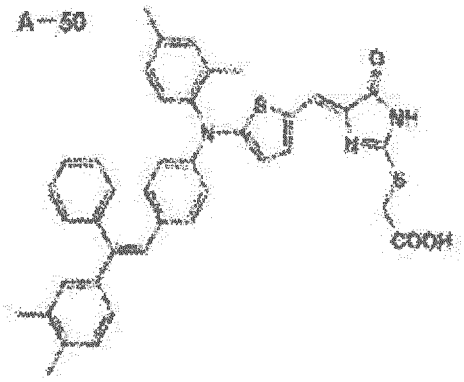

A－51

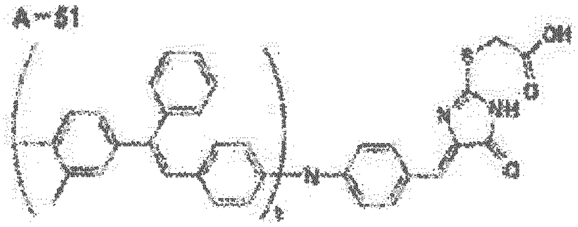

[Chemical Formula 13]

A-52

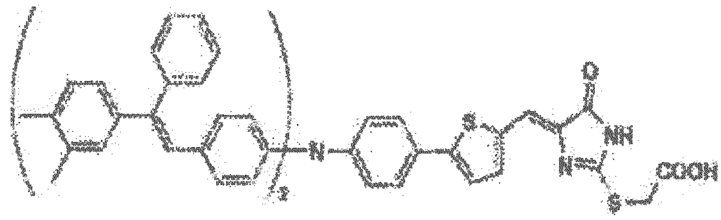

A-53

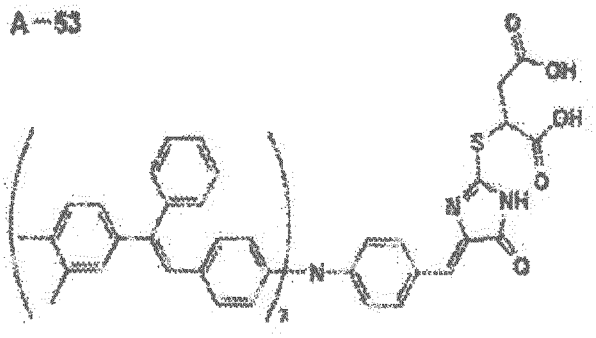

A-54

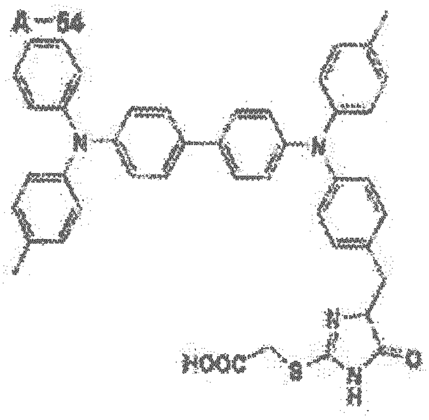

A-55

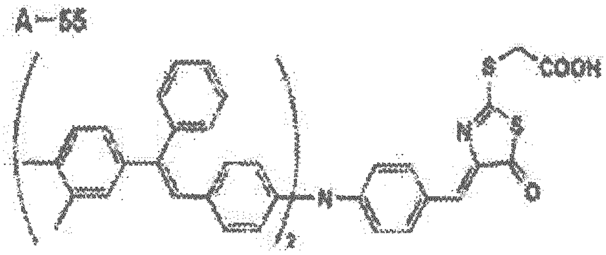

[Chemical Formula 14]

B-1

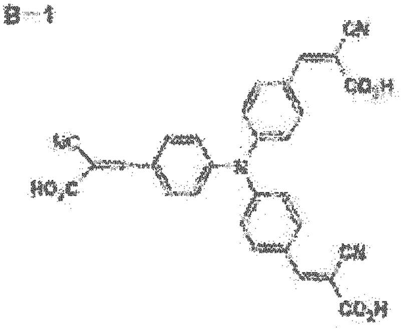

B-2

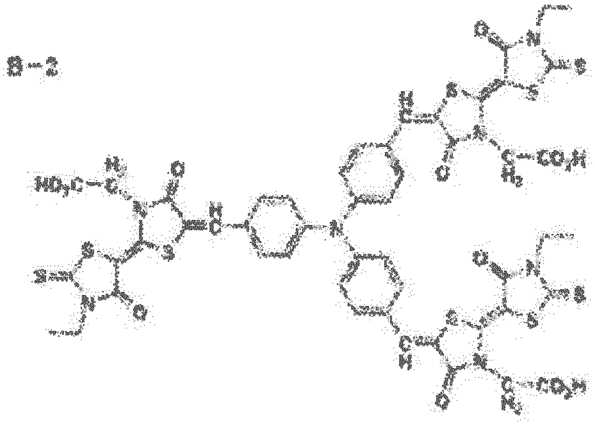

B-3

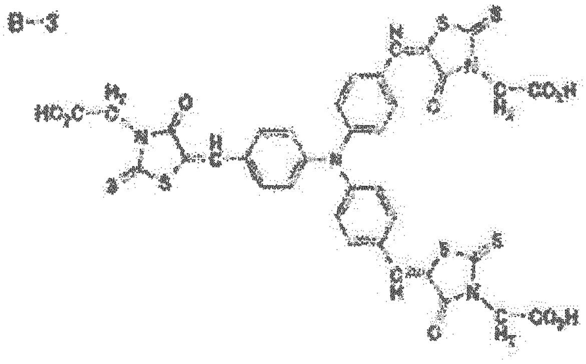

B-4

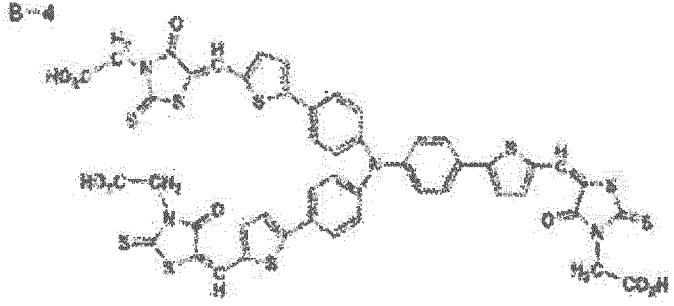

B-5

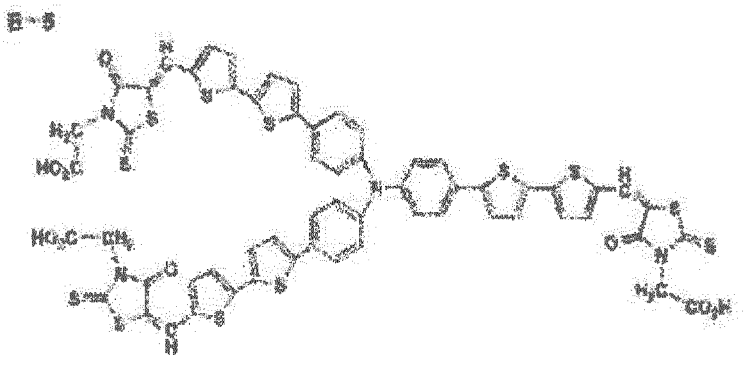

[Chemical Formula 15]

B-6

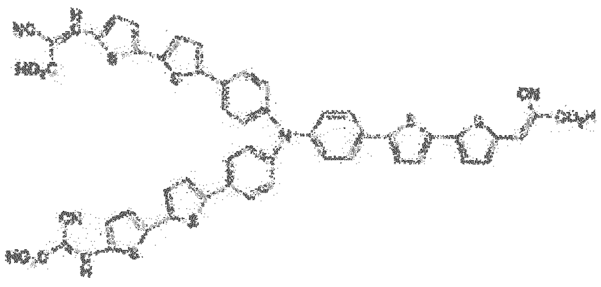

B-7

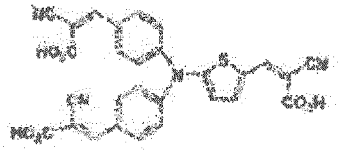

B-8

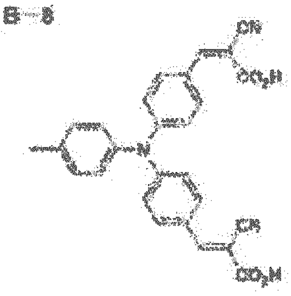

B-9

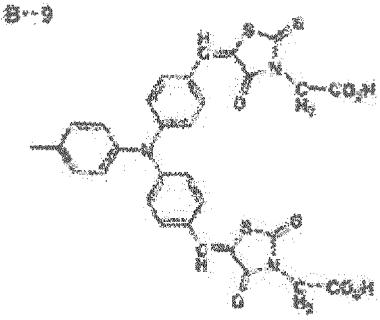

B-10

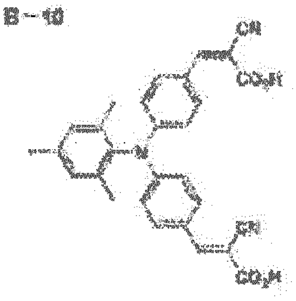

B-11

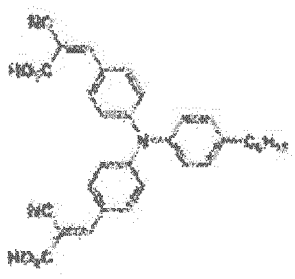

B-12

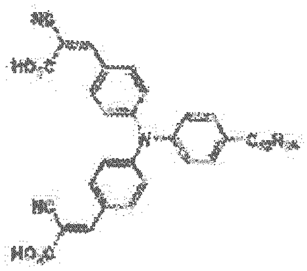

B-13

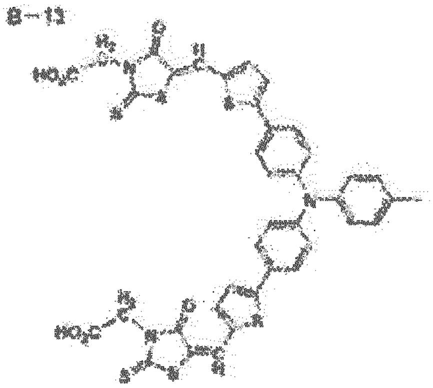

B-14

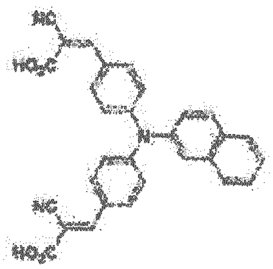

[Chemical Formula 16]

B-15

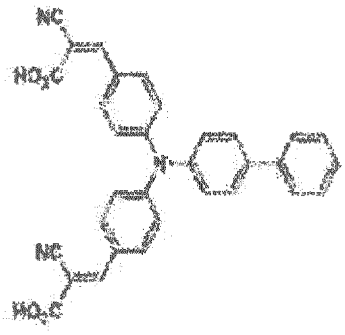

B-16

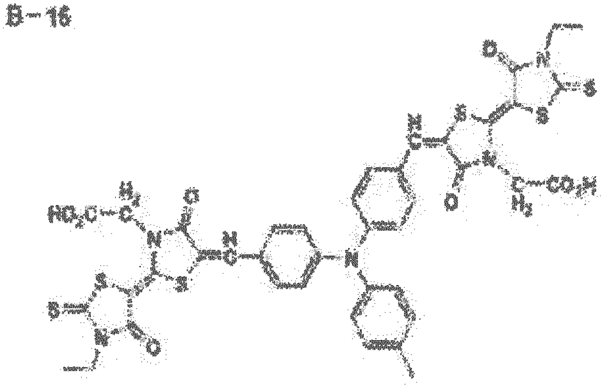

B-17

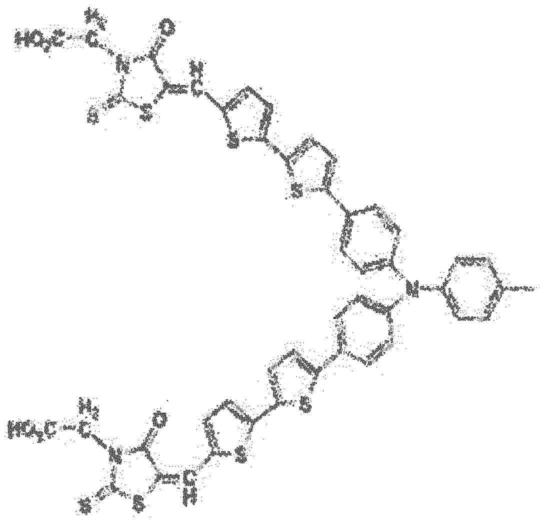

B-18

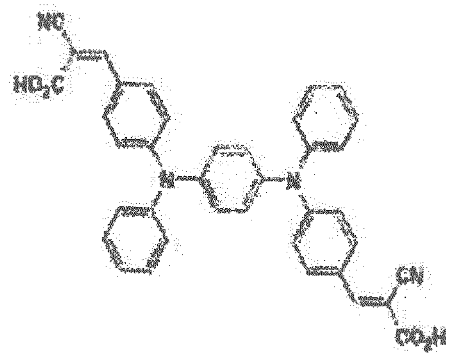

B-19

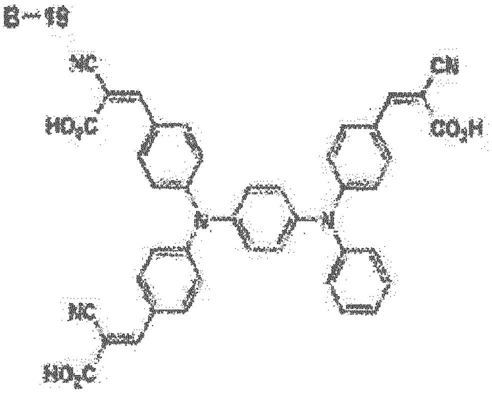

B-20

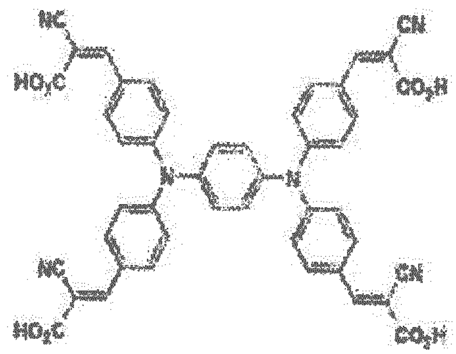

[Chemical Formula 17]

B-21

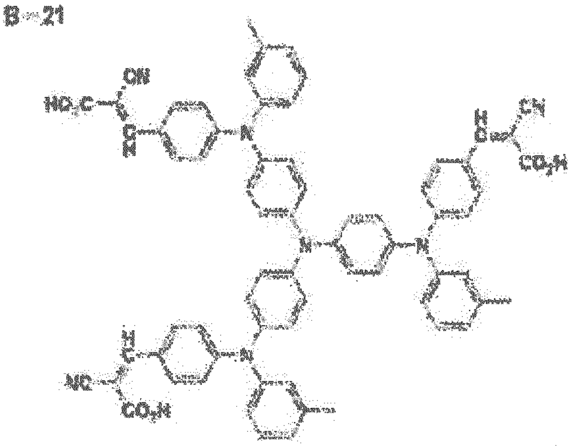

B-22

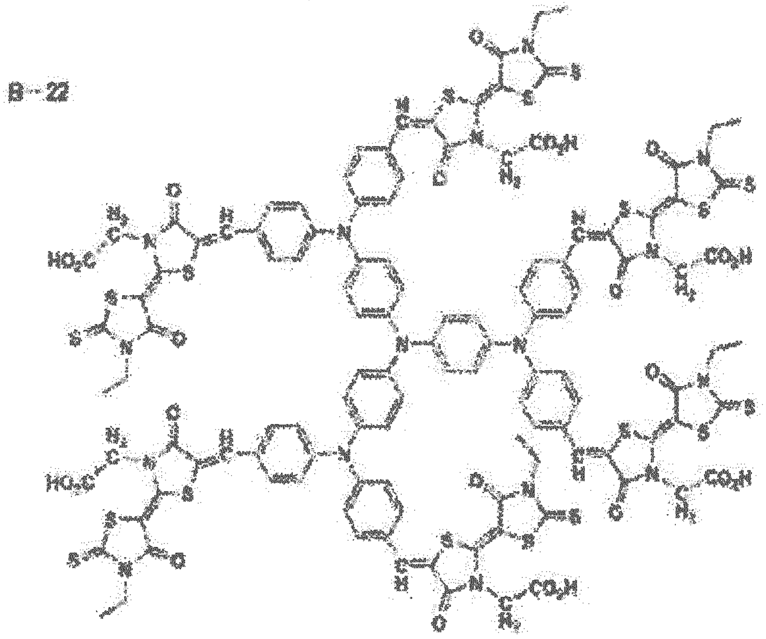

B-23

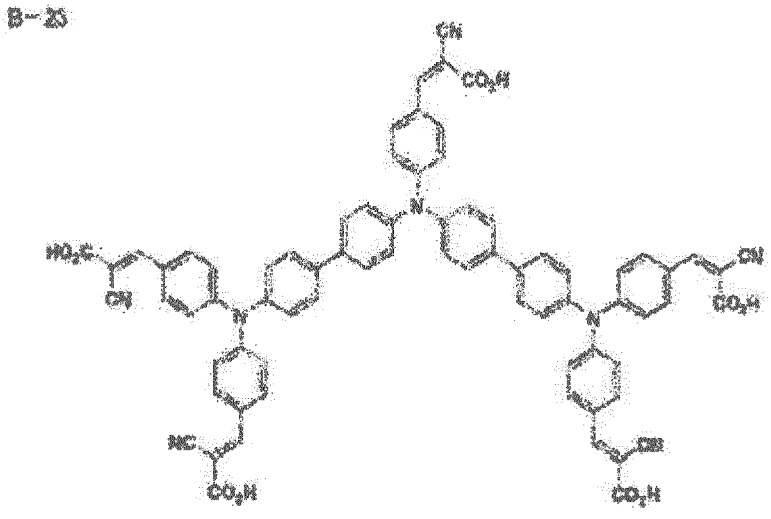

[Chemical Formula 18]

B-24

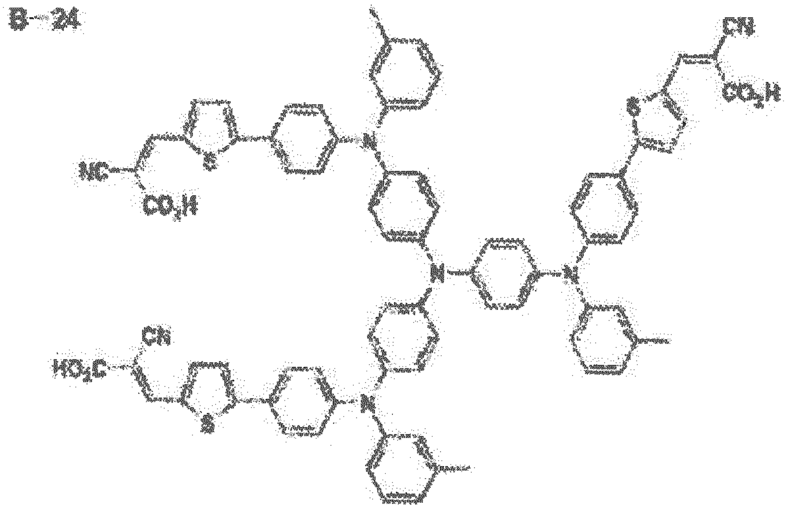

B-25

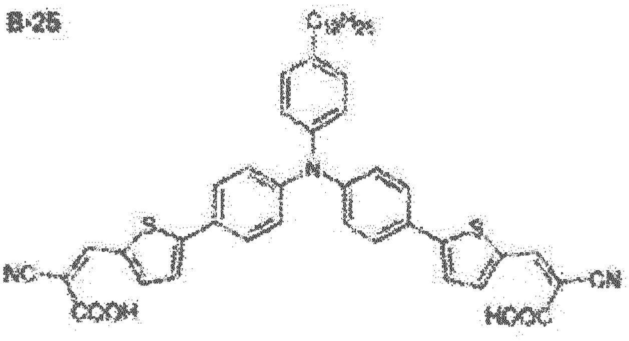

B-26

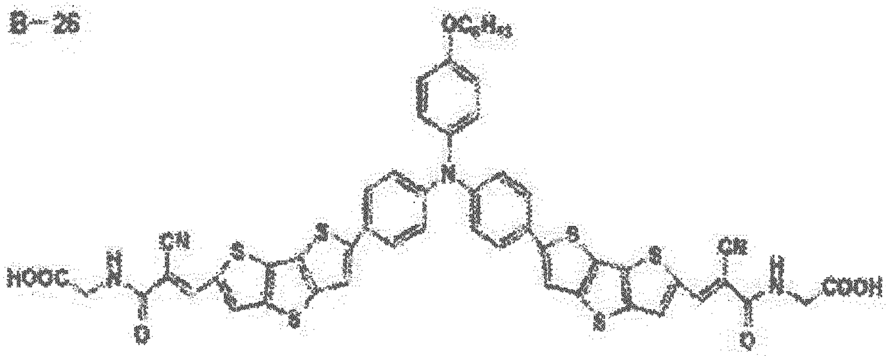

B-27

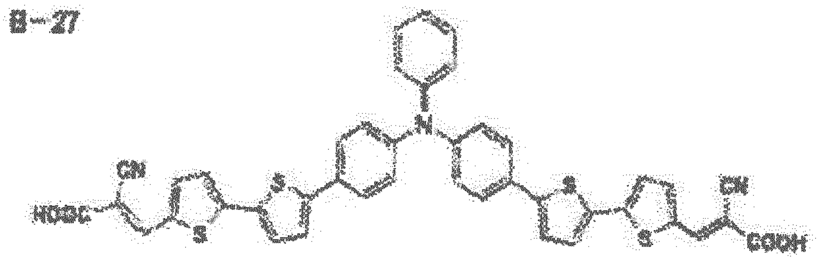

[Chemical Formula 19]

B-28

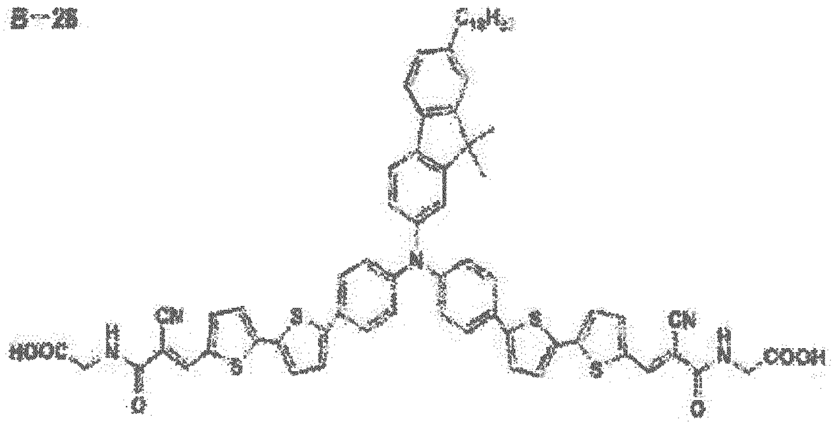

B-29

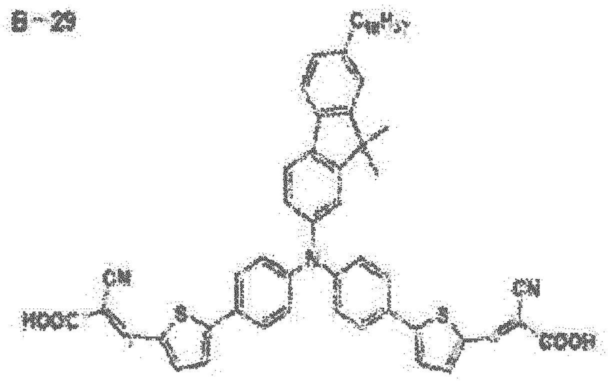

B-30

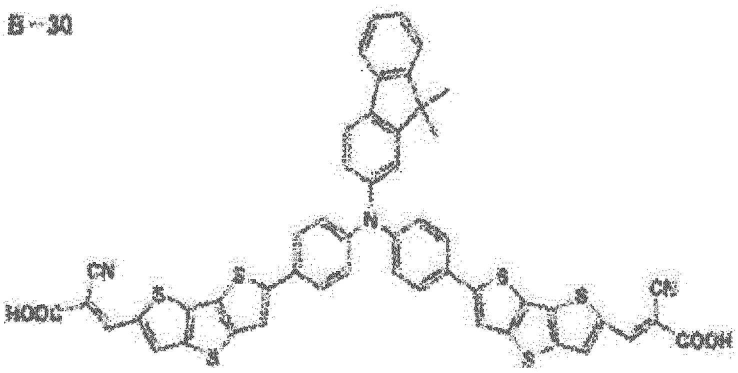

B-31

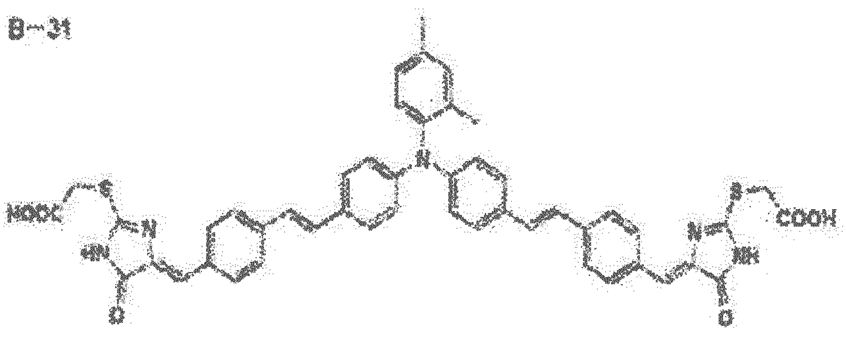

[Chemical Formula 20]

B-32

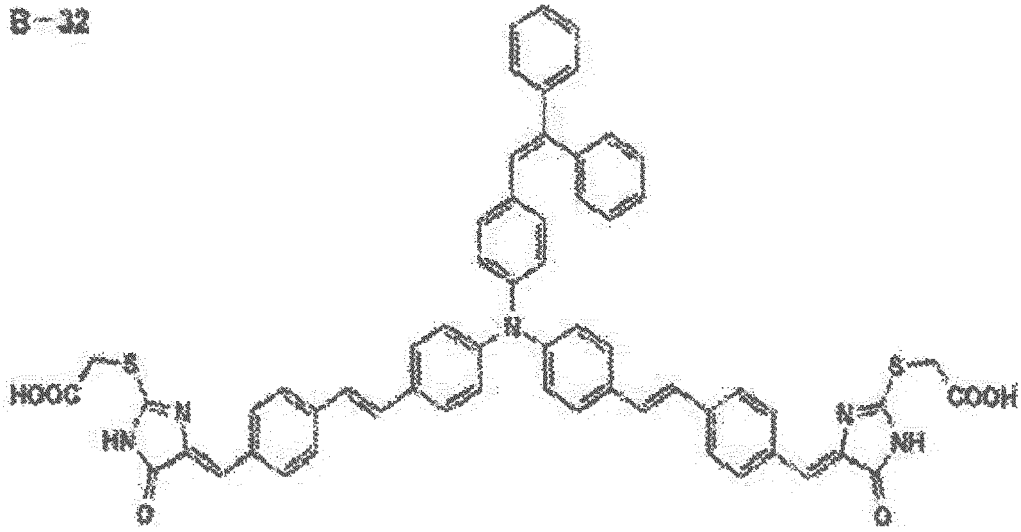

[Chemical Formula 21]

C-1

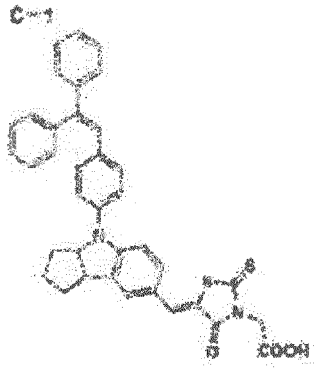

C-2

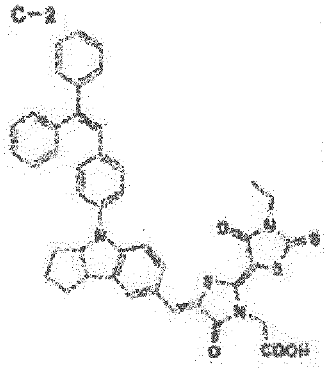

C-3

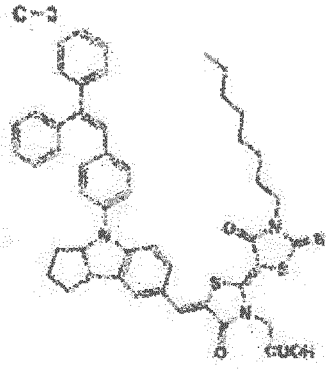

C-4

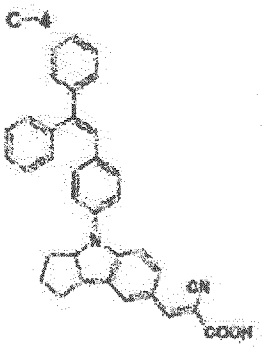

C-5

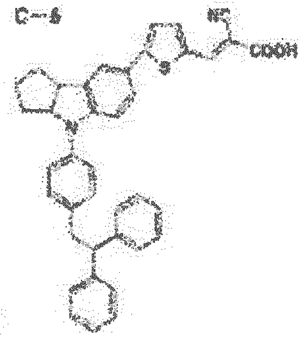

C-6

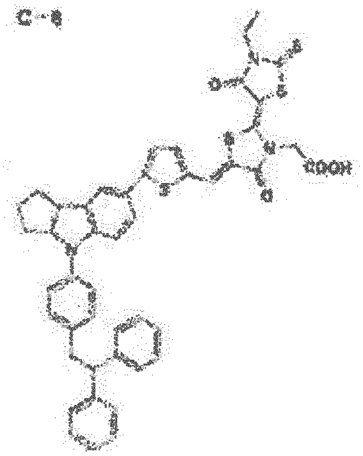

C-7

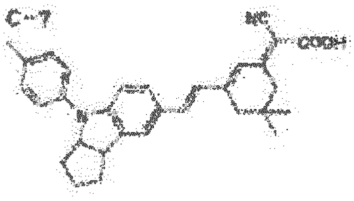

C-8

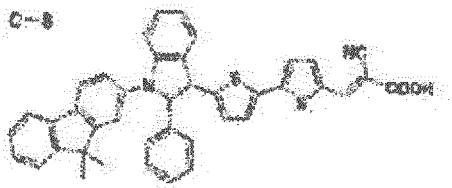

C-9

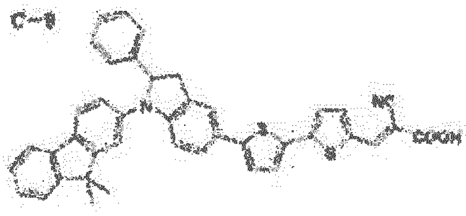

C-10

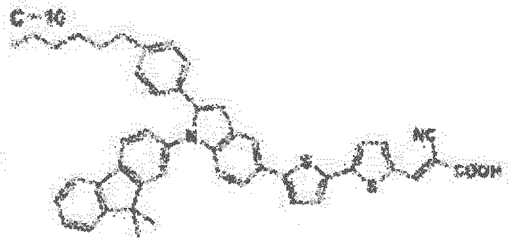

[Chemical Formula 22]

C-11

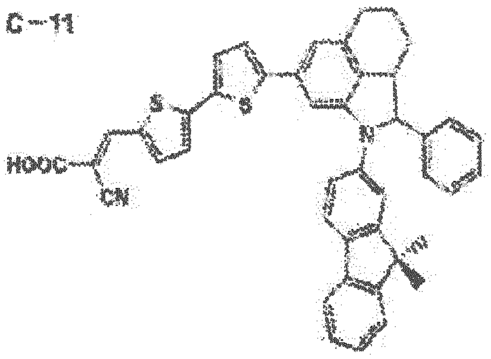

C-12

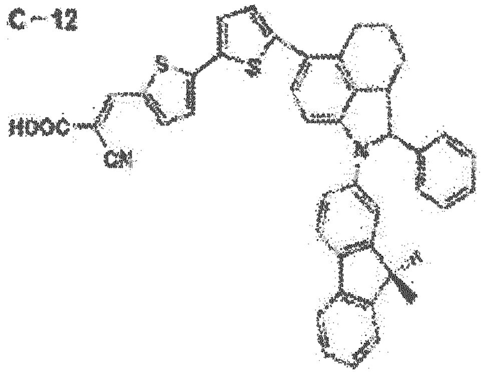

C-13

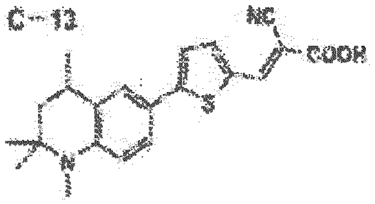

C-14

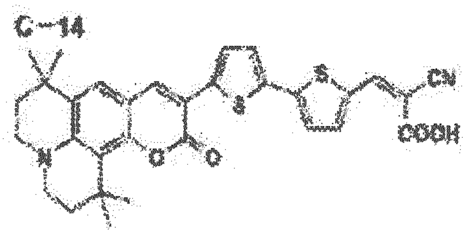

[Chemical Formula 23]

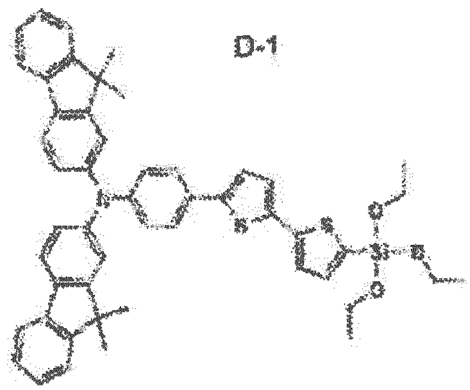

D-1

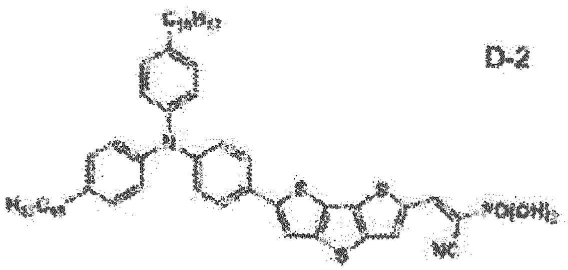

D-2

Among the above-described preferable sensitizing dyes, sensitizing dyes in which Ar has Chemical Formula (1-B), and/or $R_3$ has any of Chemical Formula (2-A), Chemical Formula (2-G), Chemical Formula (2-J) and Chemical Formula (2-K), and/or $A_1$ and $A_2$ each have Chemical Formula (3-D), Chemical Formula (3-I), Chemical Formula (3-P), Chemical Formula (3-Q) or Chemical Formula (3-R) are particularly preferable.

"Hole transportation layer"

The hole transportation layer in the present invention has functions to supply electrons to the sensitizing dye that has been oxidized by photoexcitation to thereby reduce the sensitizing dye, and to transport holes that have been generated on the interface with the sensitizing dye to the second electrode. Preferably, the hole transportation layer may be filled in not only the laminar part formed on the porous semiconductor layer but also in the pores of the porous semiconductor layer.

The hole transportation layer in the present invention is formed by bringing the conductive polymer precursor into contact with the photoelectric conversion layer in the presence of an oxidizer, and irradiating the sensitizing dye with light to thereby polymerize the conductive polymer precursor.

Herein, it is preferable to adjust a mixing ratio of the conductive polymer precursor to the oxidizer in the solution to be within the following Mathematical Formula (1). That is, preferably, the hole transportation layer in the present invention may be formed by bringing the above-described photoelectric conversion layer into contact with a solution containing the conductive polymer precursor and the oxidizer by a ratio of the following Mathematical Formula (1) and then performing irradiation with light.

[Mathematical Formula 1]

$$0.1 < [Ox]/[M] \quad (1)$$

In Mathematical Formula (1), [Ox] is the molar concentration of the oxidizer; and [M] is the molar concentration of the conductive polymer precursor. If the oxidizer is present in a larger amount than that of the conductive polymer precursor as such, a more homogeneous hole transportation layer can be formed as compared with that formed in photoelectrolytic polymerization, by performing irradiation with light (photochemical polymerization of the conductive polymer precursor), and thus, the obtained photoelectric conversion element can exert excellent durability. Further, if the [Ox]/[M] ratio is 0.1 or less, the oxidizer is insufficient, and thus, a homogeneous hole transportation layer may not be formed in some cases. The [Ox]/[M] ratio may be preferably from 0.15 to 300 and more preferably from 0.2 to 100.

That is, when the sensitizing dye in the photoelectric conversion layer is irradiated with light, the electrons excited in the sensitizing dye are consumed by the oxidizer (for example, aqueous hydrogen peroxide or the like). Accordingly, the sensitizing dye is put into a cation state, and the dye in a cation state withdraws electrons from the conductive polymer precursor, whereby the conductive polymer precursor is put into a cation state. The conductive polymer precursor in a cation state acts as a trigger, whereby polymerization is initiated. Herein, by mixing the oxidizer with the conductive polymer precursor at such a ratio that the oxidizer exists at a higher concentration than that of the conductive polymer precursor, the sensitizing dye in a cation state efficiently withdraws electrons from the conductive polymer precursor, and thus, the polymerization can be initiated more quickly by using the conductive polymer precursor in a cation state as a trigger.

Furthermore, if the conductive polymer precursor is a monomer of a relatively low molecule, the conductive polymer precursor easily permeates the photoelectric conversion layer of the porous body, and the sensitizing dye in the photoelectric conversion layer acts as an initiator and also plays a role as a starting point of a polymerization reaction. Therefore, the amount of the polymerized conductive polymer to cover the sensitizing dye is considered to be larger than the amount of a conductive polymer polymerized by electrolytic polymerization to cover the sensitizing dye.

Furthermore, since the above-described process proceeds very quickly as compared with a process of electrolytic polymerization, it is possible to shorten the polymerization time, which is very advantageous in simplifying the manufacturing process. Furthermore, it is also possible to easily form a hole transportation layer having a large area by the above-described process.

Accordingly, the hole transportation layer in the present invention has a conductive polymer formed by a photopolymerization reaction of a conductive polymer precursor by using a sensitizing dye that has been oxidized by light irradiation as a polymerization initiator. To be more specific, the hole transportation layer in the present invention contains a conductive polymer obtained by polymerizing a conductive polymer precursor by using a sensitizing dye cation formed by oxidizing a sensitizing dye by a reaction between electrons excited by irradiating the sensitizing dye with light and an oxidizer.

As described above, it becomes possible to polymerize the conductive polymer precursor by the presence of the sensitizing dye, the irradiated light for exciting the sensitizing dye, and the oxidizer that deprives the sensitizing dye of the excited electrons in the solution of the conductive polymer precursor for the hole transportation layer. Furthermore, if the level of the oxidizer is higher than the level of the excited sensitizing dye, it is possible to deprive the sensitizing dye of the electrons. Further, if the level of the oxidizer is too high, the conductive polymer precursor (for example, bis-EDOT) is directly subjected to oxidation polymerization, and thus, it may be difficult to form a homogeneous film in the vicinity of the sensitizing dye. Therefore, it is preferable to perform polymerization with an oxidizer having a suitable standard electrode potential.

Considering the above-described points, the oxidizer in the present invention has a standard electrode potential ($E^0_{(ox)}$) (V) of preferably from -1.5 to +2.5 V and more preferably from -0.5 to +2.0 V. If the standard electrode potential of the oxidizer is at the lower limit or more of the above-described range, the polymerization can be promoted more efficiently. If the standard electrode potential of the oxidizer is at the upper limit or less of the above-described range, the reaction (reaction velocity) is easily controlled and the productivity is excellent, which is industrially preferable. That is, since the oxidizer having such standard electrode potential ($E^0_{(ox)}$) (V) can efficiently consume the electrons excited by the sensitizing dye during the light irradiation, the polymerization of the conductive polymer precursor can be further promoted, and thus, a homogeneous film can be formed in the vicinity of the sensitizing dye. In the present specification, "standard electrode potential ($E^0_{(ox)}$) (V)" means a standard electrode potential (25°C) in an aqueous solution.

Examples of the above-described oxidizer may include hydrogen peroxide, metal salts and peroxides. Herein, hydrogen peroxide, metal salts and organic peroxides [hydroperoxides (R-O-O-H), dialkyl peroxide(R-O-O-R'), peroxy ester (R-C(=O)-O-O-R'), diacyl peroxide (R-C(=O)-O-O-C(=O)-R'), peroxycarbonate (R-O-C(=O)-O-O-C(=O)-O-R'), peroxyketal (R-O-O-C(X)(X')-O-O-R'), ketone peroxide (H-O-O-C(X)(X')-O-O-H)] are preferable. That is, the oxidizer used in the present invention may be preferably oxygen, ozone, peroxides, or metal salts. Further, a gas such as oxygen or ozone may be preferably used as the oxidizer.

Furthermore, the oxidizer in the present invention may be preferably a compound that becomes a gas compound or a liquid compound by light irraidation (by the reduction of the oxidizer itself). Since the oxidizer becomes a gas or a liquid after the polymerization reaction as such, the oxidizer does not remain in the hole transportation layer, which is a polymerized film. Therefore, the photoelectric conversion efficiency of the obtained photoelectric conversion element can be further improved. Further, in the present specification, "gas compound" means a compound that is in a gas state under conditions of 20°C and 1 atm. Furthermore, "liquid compound" means a compound that is in a liquid state under conditions of 20°C and 1 atm.

It is considered that, when the sensitizing dye is irradiated with light in the presence of the oxidizer, the electrons excited in the dye are consumed by the oxidizer (for example, hydrogen peroxide/aqueous hydrogen peroxide, or the like), and the sensitizing dye in a cation state withdraws the electrons in the conductive polymer precursor as a monomer, and polymerization is initiated.

Examples of the above-described peroxide may include permanganic acid or salts thereof, chromic acid or salts thereof, peroxo acid or salts thereof, oxygen acid or salts thereof, nitric acids, sulfates, and the like. Specific examples thereof may include inorganic peroxides such as hydrogen peroxide, sodium peroxide, barium peroxide, potassium permanganate, sodium permanganate, chromic acid metal salt, dichromic acid metal salt, peroxodisulfate, ammonium peroxodisulfate, peroxodisulfate metal salt, peroxophosphoric acid, peroxosulfuric acid, peroxyboric acid sodium, hypochlorous acid, hybrobromous acid, hypoiodous acid, chloric acid, bromate, iodic acid, sodium hypochlorite, and calcium hypochlorite; and organic peroxides such as cumene hydroperoxide, formic acid, performic acid, peracetic acid, perbenzoic acid, perphthalic acid, t-butyl hydroperoxide, 1,1,3,3-tetramethylbutyl hydroperoxide, diisopropylbebzene hydroperoxide, p-menthane hydroperoxide, di-t-butyl peroxide, t-butyl cumyl peroxide, 2,5-dimethyl-2,5-di(t-butyl peroxy) hexane, di-t-hexyl peroxide, dicumyl peroxide, di(2-t-butylperoxy isopropyl) bebzene, n-butyl-4,4-di(t-butyl peroxy) valerate, t-butyl peroxy benzoate, 2,2-di(t-butyl peroxy) butane, t-butyl peroxy acetate, 2,5-di-methyl-2, 5-di(benzoyl peroxy) hexane, t-hexyl peroxybenzoate, t-butyl peroxy 2-ethylhexyl monocarbonate, t-butyl peroxy isopropyl monocarbonate, t-butyl peroxy laurate, t-butyl peroxy-3,5,5,-trimethyl hexanoate, t-butyl peroxy maleic acid, t-hexyl peroxy isopropyl monocarbonate, 2,2-di(4,4-di(t-butyl peroxy) cyclohexyl) propane, 1,1-di(t-butyl peroxy) cyclohexane, 1,1-di(t-hexyl peroxy) cyclohexane, diisobutyryl peroxide, cumyl peroxy neodecanoate, di-n-propyl peroxy dicarbonate, diisopropyl peroxy dicarbonate, di-sec-butyl peroxydicarbonate, 1,1,3,3-tetramethylbutyl peroxy neodecanoate, di(4-tert-butylcyclohexyl) peroxydicarbonate, di(2-ethylhexyl) peroxydicarbonate, t-hexyl peroxy neodecanoate, t-butyl peroxy neodecanoate, t-butyl peroxy neo-heptanoate, t-hexyl peroxypivalate, t-butyl peroxypivalate, di(3,5,5-trimethyl hexanoyl) peroxide, dilauroyl peroxide, 1,1,3,3-tetramethylbutyl peroxy-2-ethylhexanoate, disuccinic acid peroxide, 2,5-dimethyl-2,5-di(ethyl hexanoyl peroxy) hexane, t-hexyl peroxy-2-ethylhexanoate, di(3-methylbenzoyl) peroxide, benzoyl (3-methylbenzoyl) peroxide, dibenzoyl peroxide, 1,1-di(t-butyl peroxy)-2-methylcyclohexane, and 1,1-di(t-hexyl peroxy)-3,3,5-trimethyl cyclohexane. The above-described peroxides may be synthesized, or commercially available products may be used. In the above description, the matter in the brackets represents a standard electrode potential ($E^0_{(ox)}$) (V).

Examples of the above-described metal salt may include tris-p-toluenesulfonic acid iron (III), iron chloride (II), iron chloride (III), iron sulfate (III), iron nitrate (III), silver nitrate ($AgNO_3$), ferric citrate (III), ammonium iron sulfate (III), and the like.

Besides the above-described metal salts, an oxidizer having a standard electrode potential ($E^0_{(ox)}$) of from -0.5 to +2.0 (V) may also be used, and for example, methanol (+0.588 V), oxygen (+1.229 V), and the like may be used.

Among the above-described oxidizers, hydrogen peroxide (+1.763 V), cumene hydroperoxide, formic acid (+0.034 V), iron chloride (II) (-0.440 V), silver nitrate ($AgNO_3$) (+0.799 V), methanol, oxygen (+1.229 V), tris-p-toluenesulfonic acid iron (III), potassium permanganate, and ozone are preferable, and hydrogen peroxide, oxygen (+1.229 V), and ozone are more preferable.

The conductive polymer precursor according to the present invention may be preferably a monomer component having a repeating unit represented by the following Monomer Formula 1.

[Chemical Formula 24]

(Monomer Formula 1)

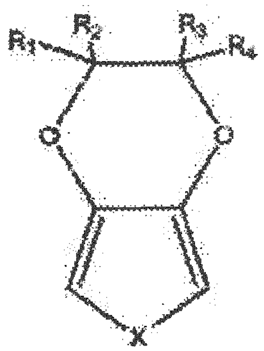

In Monomer Formula 1, X represents, S, NR, or O, R is any of a hydrogen atom and an alkyl group, and $R_1$ to $R_4$ are each independently a hydrogen atom, a halogen atom, a straight chain or branched alkyl group having 1 to 30 carbon atom(s), a cycloalkyl group having 3 to 10 carbon atoms, an alkoxy group having 1 to 30 carbon atom(s), a polyethylene oxide group having 2 to 30 carbon atoms, or a substituted or unsubstituted cyclic compound-containing group having 4 to 30 carbon atoms.

Since the straight chain or branched alkyl group having 1 to 30 carbon atom(s), the cycloalkyl group having 3 to 10 carbon atoms, and the alkoxy group having 1 to 30 carbon atom(s) described above are the same as those in General Formula (1), descriptions thereof will be omitted.

Furthermore, the halogen atom is not particularly limited, and may include a fluorine atom, a chlorine atom, a bromine atom, or an iodine atom.

The polyethylene oxide groups having 2 to 30 carbon atoms refer to groups represented by the formula: $-(CH_2CH_2O)_xH$ or the formula: $-(OCH_2CH_2)_xH$ [wherein x is an integer of from 1 to 9]. Among them, groups in which x is from 3 to 9 are preferable, and $-(OCH_2CH_2)_9H$ is more preferable.

The cyclic compound group having 4 to 30 carbon atoms is derived from a group formed by removing one hydrogen element from a benzene ring, a naphthalene ring, an anthracene ring, a thiophene group, a phenylthiophene ring, a diphenyl thiophene ring, an imidazole ring, an oxazole ring, a thiazole ring, a pyrrole ring, a furan ring, a benzimidazole ring, a benzoxazole ring, a rhodanine ring, a pyrazolone ring, an imidazolone ring, a pyran ring, a pyridine ring, a fluorene ring, or the like.

More preferable $R_1$ to $R_4$ in General Formula (2) in the present invention are each independently a hydrogen atom, a halogen atom, an alkyl group having a carbon number of 6 to 24, an alkoxy group having a carbon number of 1 to 18, a phenyl group, a biphenyl group, a phenyl group substituted with an alkyl group having a carbon number of 1 to 8, a biphenyl group substituted with an alkyl group having a carbon number of 1 to 8, a thiophene group, bithiophene group, a thiophene group substituted with an alkyl group having a carbon number of 1 to 8, a bithiophene group substituted with an alkyl group having a carbon number of 1 to 8, a thiophene group substituted with an alkoxy group having a carbon number of 1 to 8, a bithiophene group substituted with an alkoxy group having a carbon number of 1 to 8.

Furthermore, the conductive polymer precursor in the present invention may be any one as long as it has Formula (1) and plays a role for polymerization. Therefore, Formula (1) may be used singly, or as a multimer in which plural kinds of repeating units are bonded. Furthermore, the conductive polymer precursor may be a prepolymer (including multimers of dimer or more, and so-called oligomers) formed by polymerizing a monomer having the above-described repeating unit in advance, singly or together with plural kinds of monomers if necessary. In this case, the conductive polymer precursor is a prepolymer, and as will also be described in the following synthesis method, a method for forming a conductive polymer by coating the conductive polymer precursor in the form of a prepolymer on a photoelectric conversion layer, and performing chemical polymerization on the photoelectric conversion layer may be convenient.

The repeating unit in the case where the conductive polymer precursor is a multimer is represented by the following Formula:

[Chemical Formula 25]

(Repeating Unit Formula 2)

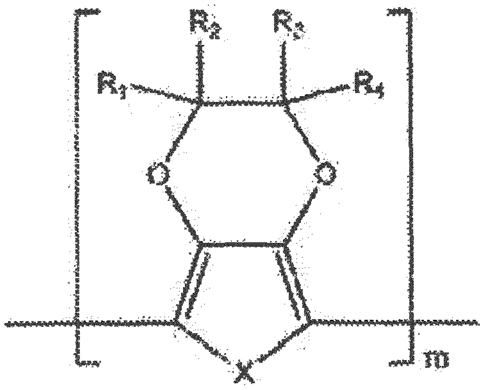

In Repeating Unit Formula 2, X and $R_1$ to $R_4$ are the same as in Monomer Formula 1, m represents the number of the bonds in the monomer, and for example, a dimer is represented in the case where m = 2, and a trimer is represented in the case where m = 3. Herein, m may be preferably an integer of 1 or more and 10 or less.

Furthermore, particularly preferable embodiments of the conductive polymer precursor in the present invention will be shown below in Table 1.

[Table 1-1]

| Repeating unit | m | X | $R_1$ | $R_2$ | $R_3$ | $R_4$ |
|---|---|---|---|---|---|---|
| M1-1 | 2 | S | -H | -H | -H | -H |
| M1-2 | 2 | S | -H | -H | $-C_6H_{13}$ | -H |
| M1-3 | 2 | S | -H | -H | $-C_{10}H_{21}$ | -H |
| M1-4 | 2 | S | -H | -H | $-C_{12}H_{25}$ | -H |
| M1-5 | 2 | S | -H | -H | $-C_{18}H_{37}$ | -H |
| M1-6 | 2 | S | -H | -H | $-C_{24}H_{49}$ | -H |
| M1-7 | 2 | S | -H | -H | 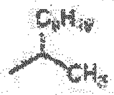 | -H |
| M1-8 | 3 | S | -H | -H | 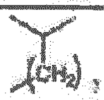 | -H |
| M1-9 | 2 | S | -H | -H | 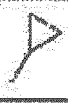 | -H |
| M1-10 | 2 | S | -H | -H | 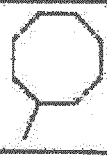 | -H |
| M1-11 | 2 | S | -H | -H | $-OCH_3$ | -H |
| M1-12 | 1 | S | -H | -H | $-OC_{10}H_{21}$ | -H |
| M1-13 | 2 | S | -H | -H | $-OC_{16}H_{33}$ | -H |
| M1-14 | 1 | S | -H | -H | $-(OC_2H_4)_4-OC_2H_5$ | -H |
| M1-15 | 2 | S | -H | -H | 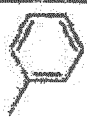 | -H |
| M1-16 | 2 | S | -H | -H | 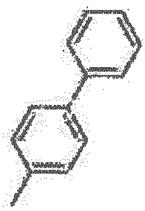 | -H |

[Table 1-2]

| Repeating unit | m | X | $R_1$ | $R_2$ | $R_3$ | $R_4$ |
|---|---|---|---|---|---|---|
| M1-17 | 2 | S | -H | -H | 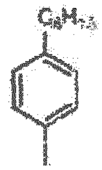 | -H |
| M1-18 | 2 | S | -H | -H | 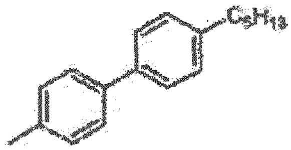 | -H |
| M1-19 | 2 | S | -H | -H | 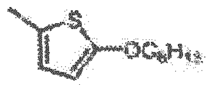 | -H |
| M1-20 | 2 | S | -H | -H | 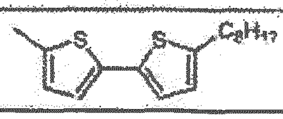 | -H |
| M1-21 | 3 | S | -H | -H | -Cl | -H |
| M1-22 | 2 | S | -H | $-CH_3$ | $-C_{14}H_{29}$ | -H |
| M1-23 | 2 | S | -H | -H | $-CH_3$ | $-C_4H_9$ |
| M1-24 | 2 | S | -H | $-C_{10}H_{21}$ | $-C_{10}H_{21}$ | -H |
| M1-25 | 2 | S | -H | $-CH_3$ | $-CH_3$ | $-C_6H_{13}$ |
| M1-26 | 2 | S | $C_2H_5$ | $C_2H_5$ | $C_2H_5$ | $C_2H_5$ |

The conductive polymer in the present invention may have the repeating unit represented by the following General Formula (2):

[Chemical Formula 26]

General Formula (2)

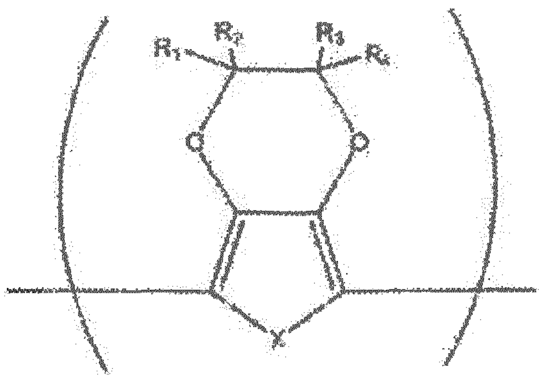

In General Formula (2), X represents S, NR, or O, R is any one of a hydrogen atom and an alkyl group, $R_1$ to $R_4$ each independently represent a hydrogen atom, a halogen atom, a straight chain or branched alkyl group having 1

to 30 carbon atom(s), a cycloalkyl group having 3 to 10 carbon atoms, an alkoxy group having 1 to 30 carbon atom(s), a polyethylene oxide group having 2 to 30 carbon atoms, or a substituted or unsubstituted cyclic compound-containing group having 4 to 30 carbon atoms.

The preferable substituents ($R_1$ to $R_4$) and X in General Formula (2) are the same as in the above-described repeating unit.

It is difficult to figure out the polymerization degree of the conductive polymer in the present invention from the polymer obtained by the synthesis method thereof. However, since the solvent solubility of a hole transportation layer formed after the polymerization significantly decreases, whether the conductive polymer is a polymer or not can be determined by the solubility of the hole transportation layer by immersing the hole transportation layer in tetrahydrofuran (THF), which can dissolve the polymer. Specifically, 60 mg of a compound (conductive polymer) is put into a sample vial of 25 mL, 10 ml of THF is added thereto, and the compound is irradiated with an ultrasonic wave (25 kHz, 150 W, Ultrasonic Engineering Co., Ltd. COLLECTOR CURRENT 1.5 A manufactured by Ultrasonic Engineering Co., Ltd. 150) for 5 minutes. In the case where the dissolved compound is 5 mg or less, the compound is determined as being polymerized.

The hole transportation layer in the present invention contains the conductive polymer represented by General Formula (2), and where necessary, the hole transportation layer may contain at least one selected from the group consisting of electrolytes and additives, as components.

The above-described electrolytes may include a dispersion of a redox electrolyte and a support electrolyte. As the redox electrolyte, $I^-/I^{3-}$-based, $Br^-/Br^{3-}$-based, quinone/hydroquinone-based, and $[Co(bpy)_3]^{2+}/[Co(bpy)_3]^{3+}$ redox electrolytes may be used. The above-described dispersion of a redox electrolyte can be obtained by a known method. For example, an $I^-/I^3$-based electrolyte can be obtained by mixing iodide ion and iodine. The above-described dispersion of a redox electrolyte is called a liquid electrolyte when used in the form of a liquid, a solid polymer electrolyte when dispersed in a solid polymer at room temperature (25°C), and a gel electrolyte when dispersed in a gel-like substance. In the case where a liquid electrolyte is used as a hole transportation layer, an electrochemically inactive solvent is used as a solvent therefor. As the solvent, for example, acetonitrile, propylene carbonate, ethylene carbonate, and the like are used. In the case where a solid polymer electrolyte is used, the electrolyte described in JP 2001-160427 A can be referred to, and in the case where a gel electrolyte is used, the electrolyte described in "Surface Science" Vol. 21, No. 5, pages 288 to 293 can be referred to, respectively.

As the above-described support electrolyte, an ionizable support electrolyte is used, and the ionizable support electrolyte is not specifically limited, but an ionizable support electrolyte that is difficult to be oxidized and reduced may be preferably used. Specific examples thereof may preferably include salts such as lithium perchlorate ($LiClO_4$), lithium tetrafluoroborate, tetrabutylammonium perchlorate, $Li[(CF_3SO_2)_2N]$ (lithium bistrifluoromethanesulfonyl imide), $(n-C_4H_9)_4NBF_4$, $(n-C_4H_9)_4NPF_4$, p-toluenesulfonate, and dodecylbenzenesulfonate. Furthermore, the polymer electrolyte described in JP 2000-106223 A (for example, PA-1 to PA-10 in this publication) may also be used as the support electrolyte. The above-described support electrolytes may be used singly, or two or more kinds may be mixed and used.

Meanwhile, as described above, in the case where the polymer is formed by using a prepolymer as the conductive polymer precursor on the photoelectric conversion layer, the polymerization may be performed by using a mixture containing, together with the prepolymer, a solvent, and additives such as a polymerization catalyst and a polymerization velocity adjusting agent as necessary.

The above-described polymerization catalyst is not particularly limited, and may include iron chloride (III), p-dodecylbenzenesulfonate iron (III), methanesulfonic iron(III), p-ethylbenzene sulfonic iron (III), naphthalenesulfonic iron (III), and hydrates thereof. Further, in the present invention, as described above, since the sensitizing dye acts as a polymerization initiator, it is not necessary to add a polymerization catalyst, but in the case where it is desirable to further promote and progress polymerization, a polymerization catalyst may be added as necessary.

Furthermore, the above-described polymerization velocity adjusting agent is not particularly limited as long as a weak complexing agent is present for the trivalent iron ion in the polymerization catalyst, and the polymerization velocity is decreased so that a film can be formed. For example, in the cases where the polymerization catalyst is iron chloride (III) and a hydrate thereof, aromatic oxysulfonic acids such as 5-sulfosalicylic acid may be used. Furthermore, in the cases where the polymerization catalyst is p-dodecylbenzenesulfonate iron (III), methanesulfonic iron (III), p-ethylbenzene sulfonic iron (III), naphthalenesulfonic iron (III), and hydrates thereof, imidazole and the like may be used.

The reaction condition of the above-described chemical polymerization differs depending on the prepolymer used, and the kinds, ratios and concentrations of the polymerization catalyst and polymerization velocity adjusting agent that are added as necessary, the thickness of the liquid film at the coating stage, and the desired polymerization velocity, and preferable polymerization conditions are, in the case where heating is conducted in the air, a heating temperature of preferably from 25 to 120°C and a heating time of preferably from 1 minute to 24 hours. Preferably, as will be specifically described below, the chemical polymerization is performed by light irradiation.

The hole transportation layer in the present invention is preferably a solid hole transportation layer. Therefore, as a material for the solid hole transportation layer, the above-described solid polymer electrolyte may be suitably used.

If necessary, for example, various additives such as acceptor dopants such as $N(PhBr)_2SbCl_6$, $NOPF_6$, $SbCl_5$, $I_2$, $Br_2$, $HClO_4$, $(n\text{-}C_4H_9)_4ClO_4$, trifluoroacetic acid, 4-dodecylbenzenesulfonic acid, 1-naphthalenesulfonic acid, $FeCl_3$, $AuCl_3$, $NOSbF_6$, $AsF_5$, $NOBF_4$, $LiBF_4$, $H_3[PMo_{12}O_{40}]$ and 7,7,8,8-tetracyanoquinodimethane (TCNQ), binder resins that are difficult to trap holes, and agents for improving coating property such as a leveling agent may be added to the hole transportation layer in the present invention. The above-described additives may be used singly or by mixing two or more kinds.

Preferably, a material contained in the hole transportation layer may have a large band gap so that the light absorption by the sensitizing dye is not inhibited. Specifically, the material may have preferably a band cap of 2 eV or more and more preferably a band cap of 2.5 eV or more. Furthermore, preferably, the hole transportation layer may have a low ionization potential so as to reduce sensitizing dye holes. The value of the ionization potential varies depending on the sensitizing dye to be applied, but generally, the value may be preferably from 4.5 to 5.5 eV and more preferably from 4.7 to 5.3 eV.

In the case where the semiconductor layer is a porous body, it is not easy to measure an average thickness of the hole transportation layer in the present invention due to permeation into the insides and gaps of the porous body.

{Method for manufacturing photoelectric conversion element module}

A second aspect of the present invention relates to a method for manufacturing the photoelectric conversion element module obtained by electrically connecting two or more photoelectric conversion elements obtained by stacking a substrate, a first electrode, a photoelectric conversion layer containing a semiconductor and a sensitizing dye, a hole transportation layer having a conductive polymer, and a second electrode in the sequence listed, the method including: forming the photoelectric conversion layer on the first electrode; bringing a conductive polymer precursor into contact with the photoelectric conversion layer in the presence of an oxidizer; irradiating the sensitizing dye with light in the presence of the oxidizer to polymerize the conductive polymer precursor to thereby form the hole transportation layer; forming the second electrode on the hole transportation layer; and electrically connecting at least the two photoelectric conversion elements.

As described above, the hole transportation layer in the present invention is formed by not electrolytic polymerization but chemical polymerization. Therefore, as described above, the present invention can solve the problem that a sufficient amount of conductive polymer cannot be formed by polymerization under a low voltage so as to prevent deterioration of the sensitizing dye, the problem that the producibility is decreased due to a long polymerization time by the polymerization under a low voltage, or the problem that it is difficult to form a homogeneous conductive polymer on the entire photoelectric conversion element since it is difficult to uniformly apply a voltage in conventional electrolytic polymerization when the photoelectric conversion element having a large area is manufactured. Further, as described above, according to the present invention, since it is possible to easily form a hole transportation layer having a large area, when a module is manufactured, it is possible to reduce an area of a portion which does not contribute to power generation as compared with a module manufactured by arranging a large number of small photoelectric conversion elements on the entire surface, and thus, a photoelectric conversion element having an excellent photoelectric conversion efficiency, and a solar cell can be provided.

In the case where the hole transportation layer is formed by electrolytic polymerization, a problem that, when a -COOH group is present in a sensitizing dye, $CO_2$ is detached by an applied voltage (Kolbe electrolysis), and thus, a dye is decomposed, has been reported (for example, see JP 2011-065751 A). However, since the hole transportation layer is formed by chemical polymerization in the present invention, the problem of the decomposition of the sensitizing dye can be solved, and thus a dye having a carboxylic acid (carboxyl group) may be suitably used.

Hereinafter, the method for producing the photoelectric conversion element according to the present invention will be described in detail. Further, unless otherwise stated, definitions of the components in the manufacturing method of the present invention are the same as those in the photoelectric conversion element module of the present invention.

"Forming a photoelectric conversion layer on a first electrode (hereinafter, referred to as a step (1) in the present specification)"

In the method for manufacturing the photoelectric conversion element according to the present invention, the step (1) of forming the above-described photoelectric conversion layer on the substrate including the first electrode on its surface is divided into a method for manufacturing the first electrode including forming the first electrode on the substrate and a method for forming the photoelectric conversion layer, and if necessary, a method for forming a buffer layer after the first electrode is formed on the substrate may also be provided. The respective methods will be described in detail.

(Method for manufacturing first electrode)

As the method for manufacturing the first electrode in the present invention, that is, a method for forming a

plurality of first electrodes (or also referred to as transparent conductive layers) on a substrate, a suitable method may be selected depending on the material of the transparent conductive layer. Examples of the method may include a sputtering process and a CVD process (a vapor deposition process), a SPD process (a spray pyrolysis deposition process), a deposition process, and the like. By these methods, a thin film formed of an oxide semiconductor such as ITO, FTO, $SnO_2$, or the like is formed. If the transparent conductive layer is too thick, the light transmittivity is poor, whereas if the transparent conductive layer is too thin, the conductivity is poor. Therefore, considering the balance of the functions of light transmittivity and conductivity, a film thickness of the transparent conductive layer may be preferably in the range of from about 0.1 to 5 $\mu$m. Further, considering the photoelectric conversion efficiency per unit area of the module, a size of the substrate may be preferably 50 to 3000 mm in length and width and 0.01 to 100 mm in thickness. Further, a size of each photoelectric conversion element is not particularly limited. However, for example, each photoelectric conversion element may be of such a size that preferably 2 to 300 and more preferably 10 to 100 photoelectric conversion elements can be arranged in series on the substrate. With such a size, the photoelectric conversion element module can show sufficient power generation performance and an area of a portion which does not contribute to power generation can be reduced. Further, preferably, a size of each first electrode may have a ratio of 1 : 2 to 100 between a length (shorter side) and a width (longer side) considering a resistance of an oxide semiconductor or an area contributing to power generation. Furthermore, preferably, a distance ("X" in Fig. 1) between the first electrodes may be as short as possible considering reduction in an area of a portion which does not contribute to power generation and achievement of sufficient photoelectric conversion efficiency, and may be preferably 0.001 to 10 mm and more preferably 0.1 to 1 mm considering formation of the second electrode in a subsequent process.

Furthermore, in the case where the transparent conductive layer is formed into slits, a suitable method may be selected depending on the material of the transparent conductive layer. Specific examples thereof may include processing by excimer laser, YAG laser, $CO_2$ laser, air jet or water jet, etching processing, mechanical processing, and the like. By this way, the transparent conductive layer may be separated into a plurality of regions. The pitch of the slits may be suitably preset depending on a size of the cell of the photoelectric conversion element.

(Method for forming buffer layer)

The method for forming a buffer layer in the present invention may include covering the first electrode with a buffer layer precursor, which is a component for forming the buffer layer, and conducting a thermal treatment as necessary. To be specific, a method including forming a (coating) layer of the component for forming the buffer layer on the transparent conductive substrate (the first electrode) on which the first electrode in the present invention is formed, and progressing a reaction by a CVD process or a calcination process to form a buffer layer, an inkjet method using a coating liquid for forming a buffer layer, coating by a spin coating process, and an atomic layer deposition (ALD) process are preferable. Among them, the method described below, which includes forming a (coating) layer of the component for forming the buffer layer on the transparent conductive substrate (the first electrode) on which the first electrode in the present invention is formed, and progressing a reaction by a CVD process or a calcination process to form a buffer layer is more preferable. The component for forming a buffer layer herein refers to a compound that becomes a buffer layer by a chemical reaction.

Furthermore, the component for forming a buffer layer used in the calcination process according to the present invention may be preferably a titanium oxide precursor, and more preferably, the titanium oxide precursor may generate titanium oxide by hydrolysis. Specific examples thereof may include organic titanium compounds such as titanium halides (titanium trichloride, titanium tetrachloride, and the like), orthotitanate esters (methyl orthotitanate, ethyl orthotitanate, isopropyl orthotitanate, butyl orthotitanate, and the like), titanium butoxide dimer, titanium stearate, diisopropoxytitanium distearate, tri-n-butoxytitanium monostearate, polyhydroxytitanium stearate tan acylate; titanium diisopropoxy bis(acetylacetonate), titanium tetra acetylacetonate, titanium dioctyloxy bis (octylene glycolate), titanium diisopropoxy bis(ethylacetacetate), titanium diisopropoxy bis(triethanolaminate), titanium lactate ammonium salt, titanium lactate, propane dioxytitanium bis(ethylacetacetate), and the like. Among them, orthotitanate esters are preferable. These titanium oxide precursors may be mixed with various ligands (for example, acetylacetone, aminoethanol, diethanolamine, triethanolamine, ethylenediamine, other amines, pyridine carboxylic acid, tartaric acid, oxalic acid, lactic acid, glycolic acid, other hydroxy carboxylic acids, and the like) in advance of hydrolysis to thereby form a complex of the titanium oxide precursor, and the complex may be used for the hydrolysis. Furthermore, it is preferable to use these titanium oxide precursors used for the calcination process as a solution by dissolving in a solvent.

As the solvent for dissolving the titanium oxide precursor, water, alcohols (methanol, ethanol, n-propanol, isopropanol), THF, and the like are preferable.

Further, in the case where the component for forming a buffer layer in the present invention is a solution, it is preferable to incorporate 0.5 to 13 parts by mass of the component for forming a buffer layer in 100 parts by mass of the above-described solvent.

The CVD process is called Chemical Vapor Deposition, and refers to a method including forming a desired

titanium oxide layer on a substrate by deposition, by supplying a raw material substance (gas, liquid, solid) formed into a gas to a reaction chamber in an apparatus and causing a chemical reaction (gas phase reaction) on the surface of the substrate. Since it is necessary to make the raw material substance chemically active (an excited state) in the CVD process, heat, plasma, or light (laser light, ultra violet, and the like) may be used. The respective processes are called a thermal CVD process, a plasma CVD process and a light CVD process.

Further, when the buffer layer is formed, a buffer layer non-forming part is formed at an end portion of each first electrode. The buffer layer non-forming part may be formed at any one end portion of the first electrode. Preferably, the buffer layer non-forming part may be formed continuously along one side of the first electrode. The buffer layer non-forming part is used to connect the first electrode with the second electrode in a subsequent process. As a method for forming the buffer layer non-forming part, a method of forming a buffer layer after disposing a coating member, a bar code method of coating a buffer layer in a restricted region, a die coating method, a gravure coating method, an ink-jet method, and the like may be used. As for a size of the buffer layer non-forming part, an upper buffer layer non-forming part may have a width in the range of preferably 0.01 to 3 mm considering the photoelectric conversion efficiency per unit area of the module or easiness of forming the second electrode to be described later.

As described above, the buffer layer in the present invention can be obtained by coating the coating liquid for forming a buffer layer on the transparent conductive substrate, and drying or/and sintering the coating liquid. Furthermore, generally, it is preferable to coat the coating liquid for forming a buffer layer on the transparent conductive substrate, and thereafter immediately conducting drying or/and sintering, in view of improvement of conductivity. In addition, that the buffer layer contains titanium oxide may be that the buffer layer has a -Ti-O- bond, and the buffer layer of the photoelectric conversion element in the present invention may contain a buffer layer precursor whose bonds have not reacted, and may contain an organic substance such as an unreacted titanium oxide precursor.

The conditions for the calcination method for forming the buffer layer by calcining the component for forming a buffer layer in the present invention are suitably selected depending on the kind of the compound used. For example, a calcination temperature may be preferably from 200 to 700°C and more preferably from 300 to 600°C. Furthermore, the calcination treatment time may be preferably from 0.5 to 120 minutes and more preferably from 5 to 30 minutes.

(Method for forming photoelectric conversion layer)

[Method for preparing semiconductor layer]

Hereinafter, a method for preparing a semiconductor layer in the step (1) of forming the photoelectric conversion layer in the present invention will be described below. The semiconductor layer is formed on the buffer layer. As described above, the preferable photoelectric conversion layer in the present invention is formed by flocculating a semiconductor having a sensitizing dye carried by the surface thereof.

In the case where the semiconductor in the semiconductor layer is in a particulate form, (1) a method for preparing a semiconductor layer by coating or spraying a dispersion liquid or colloid solution of a semiconductor (a semiconductor-containing coating liquid) onto a conductive substrate; and (2) a method including coating a precursor of semiconductor microparticles onto a conductive substrate, hydrolyzing the precursor with moisture (for example, moisture in the air), and then conducting condensation (a sol-gel process) may be used. The above-described method (1) is preferable. In the case where the semiconductor in the present invention is in a film-like form and is not retained on the conductive substrate, it is preferable to prepare a semiconductor layer by attaching a semiconductor onto a conductive substrate.

A preferable embodiment of the method for preparing the semiconductor layer in the present invention may include a method including forming the semiconductor layer by calcination using microparticles of a semiconductor on the above-described conductive substrate.

In the case where the semiconductor layer in the present invention is prepared by calcination, it is preferable to conduct a treatment for sensitizing the semiconductor (adsorption, filling into a porous layer, or the like) by using a dye after the calcination. After the calcination, it is particularly preferable to quickly conduct a treatment for adsorbing the compound before the semiconductor adsorbs water.

Hereinafter, the semiconductor layer preferably used in the present invention will be described in detail for a method of forming the semiconductor layer by calcination using semiconductor micropowder.

<Preparation of semiconductor-containing coating liquid>

Firstly, a coating liquid containing a semiconductor, preferably micropowder of a semiconductor, (semiconductor-containing coating liquid) is prepared. A finer primary particle size of the semiconductor micropowder is more preferable, and the primary particle size may be preferably from 1 to 5000 nm and more preferably from 2 to 100 nm. The coating liquid containing the semiconductor micropowder can be prepared by dispersing the semiconductor micropowder

in a solvent.

The semiconductor micropowder dispersed in the solvent is dispersed in the form of its primary particles. The solvent may be any one that can disperse the semiconductor micropowder, and is not particularly limited. As the above-described solvent, water, an organic solvent, a mixed liquid of water and an organic solvent may be included. As the organic solvent, alcohols such as methanol, ethanol, and isopropanol, ketones such as methyl ethyl ketone, acetone, and acetylacetone, hydrocarbons such as hexane and cyclohexane, cellulose derivatives such as acetyl cellulose, nitrocellulose, acetylbutyl cellulose, ethyl cellulose, and methyl cellulose, and the like may be used. If necessary, surfactants, acids (acetic acid, nitric acid, and the like), viscosity adjusting agents (polyvalent alcohols such as polyethylene glycol, and the like), chelating agents (acetylacetone and the like) may be added to the coating liquid. The range of the concentration of the semiconductor micropowder in the solvent may be preferably from 0.1 to 70 mass% and more preferably from 0.1 to 30 mass%.

<Coating of semiconductor-containing coating liquid, and treatment for calcining formed semiconductor layer>

The semiconductor-containing coating liquid obtained as above is coated or sprayed onto the conductive substrate and then dried. The coating liquid is then calcined in the air or an inert gas, whereby a semiconductor layer (also referred to as a semiconductor film) is formed on the conductive substrate. Herein, the coating method is not particularly limited, and may include known methods such as a doctor blade process, a squeegee process, a spin coating process, and a screen printing process.

The coating film obtained by coating and drying the semiconductor-containing coating liquid onto the conductive substrate is formed of an aggregate of the semiconductor microparticles. Therefore, the particle size of the microparticles corresponds to the primary particle size of the semiconductor micropowder used.

The semiconductor layer (semiconductor

microparticle layer) formed as such on the conductive layer such as the conductive substrate generally has a weak bonding force against the conductive substrate and a weak mutual bonding force of the microparticles, and thus, has a weak mechanical intensity. Therefore, in order to increase the mechanical intensity to thereby give a semiconductor layer that is strongly fixed on the substrate, a treatment for calcining the semiconductor layer (semiconductor microparticle layer) is conducted.

Although the semiconductor layer may have any structure, it may be preferably a porous structure film (also referred to as a porous layer having pores). In the case where the semiconductor layer is a porous structure film, preferably, the components of the hole transportation layer such as the hole transportation substance may also be present in the pores. The porosity (D) of the semiconductor layer is not particularly limited, and may be preferably from 1 to 90% by volume, more preferably from 10 to 80% by volume, and particularly preferably from 20 to 70% by volume. The porosity of the semiconductor layer means a porosity having permeability in a thickness direction of the semiconductor layer, and can be measured by using a commercially available apparatus such as a mercury porosimeter (Shimadzu Poresizer Type 9220). Furthermore, although a film thickness of the semiconductor layer, which becomes a film of a calcined product having a porous structure, is not particularly limited, it may be preferably at least 1 μm or more and more preferably from 2 to 30 μm. In this range, a semiconductor layer excellent in properties such as transmittivity and conversion efficiency can be formed. The semiconductor layer may be either a single layer formed by semiconductor microparticles having approximately the same average particle size, or a multi-layered film (laminar structure) formed of a semiconductor layer containing semiconductor microparticles having different average particle sizes and kinds.

Furthermore, the conditions for the calcination are not particularly limited. From the viewpoint of obtaining a calcined film having the above-described porosity by suitably adjusting the actual surface area of the calcination film during the calcination treatment, the calcination temperature may be preferably lower than 900°C, more preferably in the range of from 200°C to 850°C, and particularly preferably in the range of from 450°C to 800°C. Furthermore, in the case where the substrate is plastic or the like and thus poor in heat-resistance, it is also possible to fix the microparticles and the microparticles-substrate by pressurization without conducting a calcination treatment at 250°C or more, or only the semiconductor layer can be subjected to a heat treatment by a microwave without heating the substrate. Furthermore, from the above-described viewpoint, the calcination time may be preferably in the range of from 10 seconds to 12 hours, more preferably in the range of from 1 to 240 minutes, and particularly preferably in the range of from 10 to 120 minutes. Furthermore, the calcination atmosphere is also not particularly limited, but the calcination step is generally conducted in the air or an atmosphere of an inert gas (for example, argon, helium, nitrogen, or the like). Also, the above-described calcination may be conducted only one time at a single temperature, or may be repeatedly conducted twice or more with changing the temperature and time.

Furthermore, the ratio of the actual surface area to the apparent surface area may be controlled by the particle size and specific surface area of the semiconductor microparticles, calcination temperature, and the like. Furthermore,

for example, chemical plating using an aqueous titanium tetrachloride solution or an electrochemical plating treatment using an aqueous titanium trichloride solution may be conducted for the purpose of enhancing the electron injection efficiency from the dye to the semiconductor particles, by increasing the surface area of the semiconductor particles after the heating treatment, or increasing the purity in the vicinity of the semiconductor particles.

[sensitizing treatment method of semiconductor layer]

In the case where the sensitizing treatment in the present invention is conducted, the sensitizing dyes described above may be used singly, a plurality of sensitizing dyes may be used in combination, or the sensitizing dyes may be used by mixing with other compounds (for example, the compounds described in US 4,684,537, 4,927,721, 5,084,365, 5,350,644, 5,463,057, 5,525,440, JP 7-249790 A, JP 2000-150007 A, and the like).

Particularly, in the case where the intended use of the photoelectric conversion element of the present invention is a solar cell described below, it is preferable to use two or more kinds of dyes having different absorption wavelengths by mixing so that solar light can be effectively utilized by broadening a wavelength region of photoelectric conversion as much as possible.

The method for making the above-described semiconductor layer carry the sensitizing dye is not particularly limited, and a known method may be applied in a similar manner or after suitable modification. For example, in order to make the semiconductor carry the sensitizing dye, a method including dissolving the sensitizing dye in a suitable solvent and immersing the semiconductor layer which is thoroughly dried in the solution for a long time is generally used. In conducting the sensitizing treatment by using a plurality of sensitizing dyes in combination or using other dyes in combination, mixed solutions of the respective dyes may be prepared and used, or it is possible to prepare separate solutions for the respective dyes and sequentially immerse the semiconductor layer in the respective solutions. Furthermore, in the case where the preparation is conducted by preparing separate solutions for the respective sensitizing dyes and sequentially immersing in the respective solutions, the order of including the sensitizing dye in the semiconductor may be any order. Alternatively, the preparation may be conducted by mixing microparticles of the semiconductor which has adsorbed the above-described dye singly, or the like.

Furthermore, in the case of a semiconductor having a high porosity, it is preferable to complete the treatment for adsorbing the sensitizing dye before water is adsorbed on the semiconductor layer and the pores in the semiconductor layer due to moisture, water vapor and the like in the pores.

As described above, the treatment for sensitizing the semiconductor is conducted by dissolving the sensitizing dye in a suitable solvent and immersing the above-described substrate on which the semiconductor has been calcined in the solution. At this time, it is preferable to subject the substrate on which the semiconductor layer (semiconductor film) has been formed by calcination to a treatment under a reduced pressure or a heating treatment in advance to thereby remove the airbubbles in the film. By this treatment, the sensitizing dye may enter the portion deep inside of the semiconductor layer (semiconductor thin film), which is particularly preferable in the case where the semiconductor layer (semiconductor thin film) is a porous structure film.

The solvent used for dissolving the sensitizing dye is not particularly limited as long as the solvent can dissolve the sensitizing dye but does not dissolve the semiconductor or react with the semiconductor. However, it is preferable to subject the semiconductor film to deaeration and distillation purification in advance so as to prevent a sensitizing treatment such as adsorption of the sensitizing dye from being inhibited by permeation of the moisture and gas dissolved in the solvent into the semiconductor film. Examples of the solvent preferably used in dissolving the sensitizing dye may include nitrile-based solvents such as acetonitrile, alcohol-based solvents such as methanol, ethanol, n-propanol, isopropanol, and t-butyl alcohol, ketone-based solvents such as acetone and methyl ethyl ketone, ether-based solvents such as diethyl ether, diisopropyl ether, tetrahydrofuran, and 1,4-dioxane, and halogenated hydrocarbon solvents such as methylene chloride and 1,1,2-trichloroethane. These solvents may be used singly, or by mixing two or more kinds. Among them, acetonitrile, methanol, ethanol, n-propanol, isopropanol, t-butyl alcohol, acetone, methyl ethyl ketone, tetrahydrofuran and methylene chloride, and mixed solvents thereof such as an acetonitrile/methanol mixed solvent, an acetonitrile/ethanol mixed solvent, and an acetonitrile/t-butyl alcohol mixed solvent are preferable.

<Conditions for sensitizing treatment>

The conditions for the sensitizing treatment in the present invention are not particularly limited. For example, the time for immersing the substrate on which the semiconductor has been calcined in the sensitizing dye-containing solution may be preferably a time such that the solution enters deep into the semiconductor layer (semiconductor film) to sufficiently progress the adsorption and the like to thereby sufficiently sensitize the semiconductor. Furthermore, from the viewpoint of preventing the decomposed product generated by the decomposition of the dye in the solution from inhibiting the adsorption of the dye, a temperature for the sensitizing treatment may be preferably from 0 to 80°C and more preferably from 20 to 50°C. Furthermore, from similar viewpoints, the time for the sensitizing treatment may be

preferably from 1 to 24 hours, and more preferably from 2 to 6 hours. It is particularly preferable to conduct the sensitizing treatment under a condition of room temperature (25°C) for 2 to 48 hours, particularly for 3 to 24 hours. This effect is significant particularly in the case where the semiconductor layer is a porous structure film. However, the immersion time is a value under 25°C condition, and is not limited to the above-described value in the case where the temperature condition is changed.

In the immersion, the solution containing the dye in the present invention may be used by heating to a temperature at which the solution does not boil as long as the above-described dye is not decomposed. A preferable temperature range is from 5 to 100°C and more preferably from 25 to 80°C, but the temperature range is not limited to this range in the case where the solvent boils in the temperature range as described above.

"Brining conductive polymer precursor into contact with photoelectric conversion layer in the presence of oxidizer (hereinafter, referred to as a step (2) in the present specification)"

In the step (2) of the method for manufacturing the photoelectric conversion element according to the present invention, the photoelectric conversion layer manufactured in the step (1) and the conductive polymer precursor as a precursor for the conductive polymer that constitutes the hole transportation layer are brought into contact with each other in the presence of an oxidizer. That is, in the case where the semiconductor layer, which is the constitutional element of the photoelectric conversion layer, is not a porous body, a method including forming an oxidizer and a conductive polymer precursor, and if necessary, the electrolyte described above, on the photoelectric conversion layer, or a method including coating a solution, to which an oxidizer and a form of a monomer or a prepolymer as a precursor for the hole transportation layer, and if necessary, a solvent, an electrolyte and the like have been added, onto a photoelectric conversion layer, and conducting polymerization to form a polymer is preferable. Furthermore, in the case where the semiconductor layer, which is the constitutional element of the photoelectric conversion layer, is a porous body, it is preferable to bring the sensitizing dye adsorbed on the surface of the semiconductor layer into contact with the hole transportation layer in the presence of the oxidizer so that the surface of the porous body is covered with the hole transportation layer. Specifically, it is preferable to polymerize the conductive polymer by immersion and/or coating so that the above-described solution containing the precursor for the hole transportation layer and oxidizer and the electrolyte added as necessary can permeate the inside and gaps of the porous body and cover approximately the whole surface of the porous body.

In this step (2), preferably, the photoelectric conversion layer prepared in the above-described step (1) is brought into contact with a solution containing the conductive polymer precursor and the oxidizer by a ratio represented by the following Mathematical Formula (1).

[Mathematical Formula 2]

$$0.1 < [Ox]/[M] \quad (1)$$

In Mathematical Formula (1), [Ox] is the molar concentration (mol/L) of the oxidizer; and [M] is the molar concentration (mol/L) of the conductive polymer precursor. When the oxidizer is present in a larger amount than that of the conductive polymer precursor as such, a homogeneous hole transportation layer can be formed by performing irradiation with light (photochemical polymerization of the conductive polymer precursor) as compared with photoelectrolytic polymerization, and thus, the obtained photoelectric conversion element can exert excellent durability. When [Ox]/[M] ratio is 0.1 or less, the oxidizer is insufficient, and thus, a homogeneous hole transportation layer may not be formed in some cases. The ratio [Ox]/[M] may be preferably from 0.15 to 300 and more preferably from 0.2 to 100.

Among them, a method including coating a solution, to which an oxidizer and a form of a monomer or a prepolymer as a precursor for the hole transportation layer, and if necessary, a solvent, an electrolyte and the like have been added, onto a photoelectric conversion layer, and conducting polymerization to form a polymer, or a method including polymerizing the conductive polymer precursor by immersion and/or coating so that the above-described solution containing the precursor for the hole transportation layer and oxidizer and the electrolyte added as necessary can permeate and cover approximately the whole surface of the porous body is more preferable. Particularly, since it is preferable that the semiconductor layer as the constitutional element of the photoelectric conversion layer is a porous body, an immersion process including immersing the photoelectric conversion layer in the solution containing the conductive polymer precursor and the oxidizer is particularly preferable.

The composition of the solution to be coated onto the photoelectric conversion layer or in which the photoelectric conversion layer is to be immersed may include preferably the oxidizer of from 10 to 10000 parts by mass, the support electrolyte of from 100 to 100000 parts by mass, and the solvent of from 5000 to 200000 parts by mass and more preferably the oxidizer of from 10 to 1000 parts by mass, the support electrolyte of from 500 to 10000 parts by mass, the solvent of from 10000 to 1000000 parts by mass, with respect to 100 parts by mass of the conductive polymer precursor.

Furthermore, the above-described solvent is not particularly limited as long as it can dissolve the support electrolyte and the above-described monomer or a multimer thereof, and may include butylene oxide, chloroform, cyclohexanone, acetonitrile, tetrahydrofuran, propylene carbonate, dichloromethane, o-dichlorobenzene, dimethyl formamide, dimethyl sulfoxide, hexamethylphosphoric triamide, dimethoxyethane, acetone, methanol, ethanol, propanol, isobutyl alcohol, t-butyl alcohol, methylene chloride, and the like. Furthermore, the above-described solvents may be used as a mixed solvent by adding water or other organic solvent as necessary. The above-described solvent may be used singly, or by mixing two or more kinds.

Furthermore, as the coating method in the case where the hole transportation layer is formed by coating the above-described solution onto the photoelectric conversion layer, various coating processes such as dipping, dropwise addition, a doctor blade, spin coating, brush coating, spray coating, a roll coater, air knife coating, curtain coating, wire bar coating, gravure coating, the extrusion coating using a hopper described in US 2,681,294, and the simultaneous multilayer coating processes described in US 2,761,418, 3, 508, 947 and 2, 761, 791 may be used. Furthermore, the stacking may be conducted by repeatedly conducting such operations for coating. The number of coating in this case is not particularly limited and may be suitably selected depending on the thickness of a desired hole transportation layer.

"Forming hole transportation layer by irradiating sensitizing dye with light in the presence of oxidizer to thereby polymerize conductive polymer precursor (hereinafter, referred to as a step (3) in the present specification)"

In the step (3) of the method for manufacturing the photoelectric conversion element according to the present invention, the sensitizing dye is irradiated with light in the presence of an oxidizer after the above-described step (2), whereby the above-described conductive polymer precursor is polymerized to form the hole transportation layer. That is, it is preferable to irradiate the sensitizing dye with light from the outside in the state where the photoelectric conversion layer is immersed in a solution, to which an oxidizer and a form of a monomer or a prepolymer (multimer) as a precursor for the hole transportation layer, and if necessary, a solvent, an electrolyte and the like have been added. Alternately, the sensitizing dye may be irradiated with light from the outside in the state where the solution is coated onto the photoelectric conversion layer.

In the manufacturing method according to the present invention, although the condition for irradiating the photoelectric conversion layer (particularly the sensitizing dye in the photoelectric conversion layer) with light is not particularly limited, preferably, the wavelength of the irradiated light may include the absorption wavelength of the sensitizing dye. Specifically, a wavelength may be preferably 400 nm or more. It is preferable to use a light source having a wavelength of more preferably more than 400 nm and 1100 nm or less, and still more preferably more than 420 nm and 1100 nm or less. Furthermore, the intensity of the light may be preferably from 10 to 150 $mW/cm^2$ and more preferably from 20 to 80 $mW/cm^2$. The time for irradiating the sensitizing dye with light may be preferably from 0.1 to 30 minutes and more preferably from 0.5 to 15 minutes. When irradiation is selectively performed with light with a wavelength of 400 nm or more, a photocatalyst action of titanium oxide caused by light having a wavelength equal to or less than that wavelength is suppressed. Thus, concern about the decomposition of the dye is eliminated. Further, since a thick hole transportation layer is formed, a photoelectric conversion element having stable properties can be formed also in the case where irradiation is performed with light for a long time.

Furthermore, it is preferable to suppress irradiation with infrared ray at a wavelength of longer than 1100 nm since heating due to excess irradiation can be suppressed, delamination can be suppressed, and a high photoelectric conversion efficiency can be obtained. Further, in the case where a hole transportation layer having a polymer having Monomer Formula 1 is used, side reactions such as decomposition of the polymer caused by overlapping of light at a wavelength of more than 1100 nm with the absorption region of this polymer are suppressed, and thus, stable properties can be obtained.

If the wavelength at which the sensitizing dye is irradiated with light is 400 nm or less, titanium oxide is excited, and thus, a photocatalystic action acts on the dye to decompose the dye. Furthermore, since light at a longer wavelength transmits deeper into the titania fine pores, although it is slightly different depending on the dye, the polymerization proceeds more homogeneously. On the other hand, if the wavelength of the light source is a too long wavelength, the absorption of the dye is conversely eliminated, and thus, the polymerization does not progress. Therefore, the wavelength is set to be within the above-described range. Furthermore, the amount of light is set to be within the above-described range as an amount of light which is deemed to be necessary so as to transmit the light deep into the titania fine pores as described above. Furthermore, the irradiation time represents a time in which the polymerization sufficiently proceeds within this range.

Examples of the light source in the present invention may include a xenon lamp, a halogen lamp, an LED, and the like.

As indicated in the following Reaction Formula, when the sensitizing dye adsorbed by the photoelectric conversion layer is irradiated with light, the sensitizing dye is excited by the light, and the excited electrons are consumed by the oxidizer, whereby the sensitizing dye is put into a cation state. It is considered that the sensitizing dye in a cation state withdraws electrons from the conductive polymer precursor, whereby the conductive polymer precursor is cationized and plays a role as a polymerization initiator.

[Chemical Formula 27]

(Reaction Formula)

| | | hv |
|---|---|---|
| (1) | Sensitizing Dye | → Sensitizing Dye* |
| (2) | Sensitizing Dye* | → Sensitizing $Dye^+$ + $e^-$ |
| | Oxidizer + $e^-$ | → $Oxidizer^-$ |
| (3) | Sensitizing $Dye^+$ + Monomer | → Sensitizing Dye + $Monomer^+$ |
| (4) | $Monomer^+$ + Monomer | → $2(Monomer)^+$ |
| | | → Polymer |

By this way, since the conductive polymer can be formed by photopolymerization, the polymerization time can be shortened as compared with electrolytic polymerization. Thus, a layer of a polymer can be easily formed on the surface of the photoelectric conversion layer (semiconductor layer) with a sufficient amount and finely. Furthermore, according to the above-described method, the problem of decomposition of the sensitizing dye can be solved, and a dye having a carboxylic acid can be suitably used.

It is preferable to set the range of the temperature at which coating of the solution onto the photoelectric conversion layer and/or immersion of the photoelectric conversion layer in the solution to a range at which the solvent is not solidified nor bumped, and the range is generally from -10°C to 60°C.

Furthermore, after the formation of the hole transportation layer on the photoelectric conversion layer in the step (3), if necessary, a step of washing by a known method using the above-described solvent, and/or a step of drying under conditions of from 25 to 150°C and from 0.2 to 12 hours may be conducted.

Furthermore, if necessary, in the step (3), after the formation of the conductive polymer by photopolymerizing the conductive polymer precursor to thereby dispose the hole transportation layer on the surface of the photoelectric conversion layer, the semiconductor electrode on which the hole transportation layer has been formed may be immersed in a solution formed by mixing a solvent used for immersing and/or coating the above-described photoelectric conversion layer and at least one selected from the group consisting of the above-described support electrolyte and the above-described organic salt at from -10 to 70°C for 0.1 to 2 hours for the purpose of improving a doping rate of the conductive polymer and prevention of reverse electron transfer from the titania to the hole transportation layer. In this case, it is preferable to conduct the step (4) described below by conducing immersion and thereafter allowing to stand for 0.01 to 24 hours under natural drying.

"Forming second electrode on hole transportation layer (hereinafter, referred to as a step (4) in the present specification)"

The step (4) of the method for manufacturing the photoelectric conversion element according to the present invention is a step of forming a second electrode on the above-described hole transportation layer after the above-described step (3).

The method for forming the second electrode in the present invention is not particularly limited, and a known method can be applied. For example, a method including depositing (including vacuum deposition), sputtering, coating, or screen printing a material for the above-described second electrode may be preferably used.

The photoelectric conversion element of the present invention obtained as described above can efficiently absorb light. To be specific, preferably, the absorbance ($A_{1000}$) of the photoelectric conversion element at 1000 nm may satisfy the following Mathematical Formula (2):

[Mathematical Formula 3]

$$A_{1000} \geq FT_{sc}/8 \quad (2)$$

In Mathematical Formula (2), $A_{1000}$ is the absorbance of the photoelectric conversion element at 1,000 nm; and $FT_{sc}$ is the film thickness (μm) of the semiconductor layer.

"Electrically connecting at least two photoelectric conversion elements (hereinafter, referred to as a step (5) in the present specification)"

The step (5) of the method for manufacturing the photoelectric conversion element according to the present invention is a step of electrically connecting at least two photoelectric conversion elements. The method for electrically connecting the photoelectric conversion elements is not particularly limited, and a known method can be applied. For example, the

connection may be made by using conductive paste of silver, copper, carbon, or the like, and it is preferable to connect the photoelectric conversion elements in series. To be more specific, (a) as illustrated in Fig. 1, preferably, the end portion 31 of the first electrode 30 of one of the two adjacent photoelectric conversion elements 10 may be connected in series with the end portion 71 of the second electrode 70 of the other photoelectric conversion element 10. Otherwise, (b) preferably, the end portion 31 of the first electrode 30 of one of the two adjacent photoelectric conversion elements 10 may be connected with the end portion 71 of the second electrode 70 of the other photoelectric conversion element 10 with a conductive member interposed therebetween.

Particularly, the form (a) is preferable. That is, the step of electrically connecting may preferably include connecting at least two photoelectric conversion elements adjacent to each other among photoelectric conversion elements by connecting one end portion of a first electrode of one photoelectric conversion element with one end portion of a second electrode of the other photoelectric conversion element adjacent to the above-described photoelectric conversion element in view of reduction in electric resistance. It is preferable in that it is possible to suppress a loss of an electric resistance element caused by a conductive member, as compared with the case where connection is made by interposing a conductive member such as conductive paste.

In the method for manufacturing the photoelectric conversion element according to the present invention, the step (4) and the step (5) may be performed at the same time. For example, it is preferable to form the second electrode and thus electrically connect at least two photoelectric conversion elements. By this way, it is possible to make a size of the entire photoelectric conversion element module compact. Further, it is possible to simplify a manufacturing process. Furthermore, for example, in the case where the connection is made by using conductive paste, concern about deterioration of the photoelectric conversion element caused by heat used for curing the paste can also be eliminated. The method for forming the second electrode is not particularly limited, and a known method can be applied. The method as described in the above-described step (4) can be applied.

Further, preferably, a first electrode and a second electrode of adjacent photoelectric conversion elements may be connected in series.

(Solar cell)

The photoelectric conversion element of the present invention may be suitably used particularly for a solar cell. Therefore, the present invention also provides a solar cell having the photoelectric conversion element of the present invention or a photoelectric conversion element manufactured by the method of the present invention.

The solar cell of the present invention has the above-described the photoelectric conversion element of the present invention. The solar cell of the present invention has the photoelectric conversion element of the present invention, and the solar cell and a circuit thereof are designed optimally for sunlight. Thus, the solar cell has such a structure that optimal photoelectric conversion is conducted when sunlight is used as a light source. In other words, the solar cell has a structure in which a dye-sensitized semiconductor is irradiated with sunlight. In constituting the solar cell of the present invention, it is preferable to seal the above-described photoelectric conversion layer, hole transportation layer and second electrode by housing in a case, or seal the entirety thereof by a resin.

When the solar cell of the present invention is irradiated with sunlight or an electromagnetic wave equal to sunlight, the sensitizing dye carried by the semiconductor excites by absorbing the irradiated light or electromagnetic wave. The electrons generated by the excitation are transferred to the semiconductor, and then transferred to the second electrode through the first electrode and outer load and supplied to the hole transportation layer. Meanwhile, the sensitizing dye from which the electrons are transferred to the semiconductor becomes an oxidized body, but is reduced by the supply of the electrons from the second electrode through the polymer of the hole transportation layer to thereby return to the original state. At the same time, the polymer of the hole transportation layer is oxidized so as to return again to a reducible state by the electrons supplied from the second electrode. The electrons flow as such, and thus, a solar cell using the photoelectric conversion element of the present invention can be constituted.

Examples

Hereinafter, the present invention will be described in detail with reference to Examples, but the scope of the present invention is not limited thereto. In the following Examples, unless otherwise stated, the operations were conducted at room temperature (25°C).

"Production of dye-sensitizing photoelectric conversion element"

(Reference Example 1)

Fluorine-doped tin oxide (FTO) having a sheet resistance of 20 Ω/□ (square) as a first electrode was sputtered

on a glass substrate to form a transparent conductive layer (FTO) (coating amount: 7 g/m$^2$ substrate), whereby a conductive glass substrate (first electrode substrate) was obtained. The glass substrate had a size of 10 mm × 15 mm × 1.0 mm, and the first electrode had a size of 10 mm × 10 mm × 0.1 μm. Kapton tape having a size of 10 mm × 2 mm was attached onto the obtained first electrode so as to cover a right end portion of the first electrode. Then, TC100 (manufactured by Matsumoto Trading Co., Ltd.): titanium diisopropoxy bis (acetylacetonate) was added dropwise onto the first electrode, coated by a spin coating process, and then the Kapton tape was detached. Then, heating was performed at 450°C for 8 minutes. By this way, a buffer layer formed of a titanium oxide thin layer (porosity (C) of 1.0% by volume) having a thickness of 50 nm was formed on the transparent conductive film (FTO).

A titanium oxide paste (an anatase type, primary average particle size (average observed under a microscope): 18 nm, ethyl cellulose was dispersed in 10% aqueous acetylacetone) was coated on the above-described buffer layer by a screen printing process (coated surface area: 7 mm × 7 mm) . The obtained coating film was calcined at 200°C for 10 minutes and at 500°C for 15 minutes, whereby a titanium oxide porous layer (porous semiconductor layer) having a thickness of 2.5 μm and a porosity (D) of 60% by volume was formed.

As a sensitizing dye, A-4 (manufactured by Konica Minolta, Inc.) was dissolved in a mixed solvent of acetonitrile : t-butyl alcohol = 1 : 1 (volume ratio) to prepare a solution of 5 × $10^{-4}$ mol/l. The above-described FTO glass substrate on which the titanium oxide porous film had been formed was immersed in this solution at room temperature (25°C) for 3 hours to adsorb the dye. By this way, a semiconductor electrode having a porous semiconductor layer (photoelectric conversion layer) carrying a dye was obtained. At this time, the total carrying amount of the sensitizing dye per 1 m$^2$ of the semiconductor layer was 1 mmol. Furthermore, as the sensitizing dye, a sensitizing dye of the following Structural Formula having an absorption band at 350 to 650 nm was used.

[Chemical Formula 28]

A-4

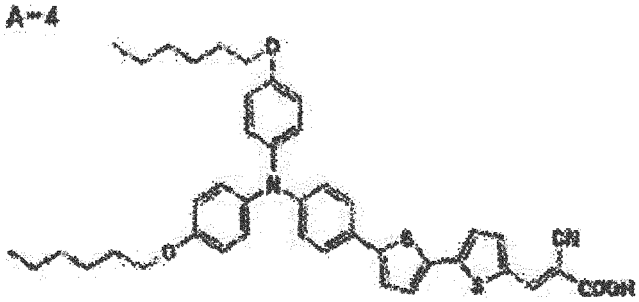

Meanwhile, the above-described conductive polymer precursor M1-1 2,2'-bis[3,4-(ethylenebisoxy)thiophene]) was dissolved at a ratio of 1 × $10^{-3}$ (mol/l) and $Li[(CF_3SO_2)_2N]$ was dissolved at a ratio of 0.1 (mol/l) in acetonitrile to prepare a solution, 30 wt% aqueous hydrogen peroxide was then added to the solution so as to be 1 v/v %, and the semiconductor electrode produced above was immersed. Furthermore, the semiconductor electrode was irradiated from the outside with light that had come from a xenon lamp and passed through a Sharp Cut Filter (manufactured by HOYA CORPORATION: S-L42), which cuts the wavelengths of 420 nm or less, for 2 minutes, whereby photopolymerization was conducted. The condition for the light irradiation was a light intensity of 22 mW/cm$^2$. When irradiation was performed with light under this condition, a new absorption appeared at 600 to 1100 nm. Thus, it was confirmed that the conductive polymer precursor was polymerized to form a conductive polymer. Then, the semiconductor electrode on which the hole transportation layer had been formed by the polymerization was washed with acetonitrile and dried, whereby a hole transportation layer was obtained. The obtained hole transportation layer was a polymerized film being insoluble in solvents.

The semiconductor electrode on which the hole transportation layer had been formed (semiconductor electrode/hole transportation layer) was then immersed in an acetonitrile solution containing $Li[(CF_3SO_2)_2N]$ at a ratio of 15 × $10^{-3}$ (mol/l) and tert-butylpyridine at a ratio of 50 × $10^{-3}$ (mol/l) for 10 minutes. The obtained semiconductor electrode/hole transportation layer was naturally dried, and 60 nm of gold was further deposited thereon by a vacuum deposition process to form a second electrode. By this way, a photoelectric conversion element SC-1 was obtained.

(Reference Examples 2 to 5)

Photoelectric conversion elements SC-2 to SC-5 were produced in the same manner as the method for producing the photoelectric conversion element SC-1 except that an oxidizer was changed to para toluenesulfonic acid iron (III),

$AgNO_3$, cumene hydroperoxide, and $KMnO_4$, respectively.

(Reference Example 6)

A photoelectric conversion element SC-6 was produced in the same manner as the method for producing the photoelectric conversion element SC-1 except that photopolymerization was conducted in a state where bubbling of oxygen was sufficiently conducted to an oxidizer.

(Reference Example 7)

A photoelectric conversion element SC-7 was produced in the same manner as the method for producing the photoelectric conversion element SC-6 except that an oxidizer was changed to ozone.

(Reference Examples 8 and 9)

Photoelectric conversion elements SC-8 and SC-9 were produced in the same manner as the method for producing the photoelectric conversion element SC-1 except that a conductive polymer precursor was changed to M1-4 and M1-26, respectively.

(Reference Example 10)

A photoelectric conversion element SC-10 was produced in the same manner as the method for producing the photoelectric conversion element SC-1 except that a light source which cuts the wavelengths of 400 nm or more was used.

(Reference Example 11)

A photoelectric conversion element SC-11 was produced in the same manner as the method for producing the photoelectric conversion element SC-1 except that a light source which cuts the wavelengths of 400 nm or less was used.

(Comparative Example 1)

In a polymerization process of the photoelectric conversion element SC-1, the above-described semiconductor electrode was immersed in an acetonitrile solution (electrolytic polymerization solution) containing the above-described conductive polymer precursor M1-1 (bis-EDOT) at a ratio of $1 \times 10^{-3}$ (mol/l) and $Li[(CF_3SO_2)_2N]$ at a ratio of 0.1 (mol/l). The above-described semiconductor electrode was connected to a working electrode, a platinum wire was connected to a counter electrode, and $Ag/Ag^+$ ($AgNO_3$ 0.01 M) was connected to a reference electrode, and then, the sustained voltage was set to -0.16 V. The voltage was sustained for 30 minutes while irradiation was performed with light from the direction of the semiconductor layer (using a xenon lamp having a light intensity of 22 $mW/cm^2$ and cutting the wavelengths of 420 nm or less), whereby a hole transportation layer 51 was formed on the surface of the above-described semiconductor electrode. A photoelectric conversion element SC-13 was produced in the same manner except that the obtained semiconductor electrode/hole transportation layer was washed with acetonitrile and dried to thereby obtain a hole transportation layer.

"Manufacturing of dye-sensitizing photoelectric conversion element module"

(Example 1)

Fluorine-doped tin oxide (FTO) having a sheet resistance of 20 Ω/□ (square) as a first electrode was sputtered on a glass substrate to form transparent conductive layers (FTO) (coating amount: 7 $g/m^2$ substrate) 21, 22, and 23, whereby conductive glass substrates (first electrode substrates) were obtained. The glass substrate had a size of 100 mm × 100 mm × 1.0 mm, and each of the first electrodes 21, 22, and 23 had a size of 90 mm × 30 mm × 100 nm. Kapton tape having a size of 100 mm × 2 mm was attached onto each of the obtained first electrodes so as to cover a right end portion of each first electrode, and in the same manner, Kapton tape having a size of 15 mm × 30 mm was attached so as to cover an upper end portion of each first electrode. Then, TC100 (manufactured by Matsumoto Trading Co. , Ltd.): titanium diisopropoxy bis(acetylacetonate) was added dropwise, coated by a spin coating process, and then, the Kapton tape was detached. Then, heating was conducted thereto at 450°C for 8 minutes. By this way, buffer layers 31, 32, and 33 formed of a titanium oxide thin layer (porosity (C) : 1.0% by volume) having a thickness 50 nm were formed on the transparent conductive film (FTO).

A titanium oxide paste (an anatase type, primary average particle size (average observed under a microscope): 18 nm, ethyl cellulose was dispersed in 10% aqueous acetylacetone) was coated on the above-described buffer layers 31, 32, and 33 by a screen printing process (coated surface area: 70 mm × 25 mm). The obtained coating film was calcined at 200°C for 10 minutes and at 500°C for 15 minutes, whereby a titanium oxide porous layer (porous semiconductor layer) having a thickness of 2.5 μm and a porosity (D) of 60% by volume was formed.

As a sensitizing dye, A-4 (manufactured by Konica Minolta, Inc.) was dissolved in a mixed solvent of acetonitrile : t-butyl alcohol = 1 : 1 (volume ratio) to prepare a solution of $5 \times 10^{-4}$ mol/l. The above-described FTO glass substrate on which the titanium oxide porous film had been formed was immersed in this solution at room temperature (25°C) for 3 hours to adsorb the dye. By this way, a semiconductor electrode having a porous semiconductor layer (photoelectric conversion layer) carrying a dye was obtained. At this time, the total carrying amount of the sensitizing dye per 1 $m^2$ of the semiconductor layer was 1 mmol. Furthermore, as the sensitizing dye, a sensitizing dye of the following Structural Formula having an absorption band at 350 to 650 nm was used.

[Chemical Formula 29]

A-4

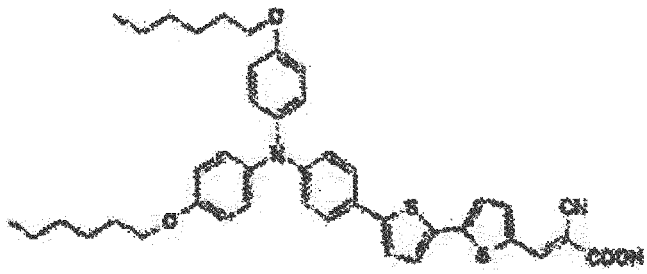

Meanwhile, the above-described conductive polymer precursor M1-1 was dissolved at a ratio of $1 \times 10^{-3}$ (mol/l) and $Li[(CF_3SO_2)_2N]$ was dissolved at a ratio of 0.1 (mol/l) in acetonitrile to prepare a solution, 30 wt% aqueous hydrogen peroxide was then added to the solution so as to be 1 v/v %, and the prepared semiconductor electrode was immersed. Furthermore, the semiconductor electrode was irradiated from the outside with light that had come from a xenon lamp and passed through a Sharp Cut Filter (manufactured by HOYA CORPORATION: S-L42), which cuts the wavelengths of 420 nm or less, for 2 minutes, whereby photopolymerization was conducted. The condition for the light irradiation was a light intensity of 22 $mW/cm^2$. When irradiation was performed with light for 2 minutes under this condition, a new absorption appeared at 600 to 1100 nm. Thus, it was confirmed that the conductive polymer precursor was polymerized to form a conductive polymer. Then, the semiconductor electrode on which the hole transportation layer had been formed by the polymerization was washed with acetonitrile and dried, whereby hole transportation layers 51, 52, and 53 were obtained. The obtained hole transportation layers were polymerized films being insoluble in solvents.

The semiconductor electrode on which the hole transportation layer had been formed (semiconductor electrode/hole transportation layer) was then immersed in an acetonitrile solution containing $Li(CF_3SO_2)_2N]$ at a ratio of 15 $\times 10^{-3}$ (mol/l) and tert-butylpyridine at a ratio of $50 \times 10^{-3}$ (mol/l) for 10 minutes. The obtained semiconductor electrode/hole transportation layer was naturally dried, and gold was further deposited to 60 nm thereon by a vacuum deposition process to form a second electrode. When the second electrode was formed by deposition, the deposition was performed such that an end portion of the first electrode covered by the Kapton tape was connected with the second electrode of the photoelectric conversion element adjacent to the first electrode, as illustrated in Fig. 1. By this way, a photoelectric conversion element module SM-1 was obtained.

(Examples 2 to 5)

Photoelectric conversion element modules SM-2 to SM-5 were produced in the same manner as the method for producing the photoelectric conversion element module SM-1 except that an oxidizer was changed to para toluenesulfonic acid iron (III), $AgNO_3$, cumene hydroperoxide, and $KMnO_4$, respectively.

(Example 6)

A photoelectric conversion element module SM-6 was produced in the same manner as the method for producing the photoelectric conversion element module SM-1 except that photopolymerization was conducted in a state where bubbling of oxygen was sufficiently conducted to an oxidizer.

(Example 7)

A photoelectric conversion element module SM-7 was produced in the same manner as the method for producing the photoelectric conversion element module SM-6 except that an oxidizer was changed to ozone.

(Examples 8 and 9)

Photoelectric conversion element modules SM-8 and SM-9 were produced in the same manner as the method for producing the photoelectric conversion element module SM-1 except that a conductive polymer precursor was changed to M1-4 and M1-26, respectively.

(Example 10)

A photoelectric conversion element module SM-10 was produced in the same manner as the method for producing the photoelectric conversion element module SM-1 except that a light source which cuts the wavelengths of 400 nm or more was used.

(Example 11)

A photoelectric conversion element module SM-11 was produced in the same manner as the method for producing the photoelectric conversion element module SM-1 except that a light source which cuts the wavelengths of 400 nm or less was used.

(Example 12)

FTO was sputtered on the glass substrate used in Example 1 to form first electrodes 201 to 210 each having a size of 90 mm × 9 mm × 100 nm. A distance (X) between the electrodes was 0.5 mm. Kapton tape having a size of 100 mm × 1 mm was attached onto each of the obtained first electrodes so as to cover a right end portion of each first electrode, and in the same manner, Kapton tape having a size of 15 mm × 30 mm was attached so as to cover an upper end portion of each first electrode. Then, TC100 (manufactured by Matsumoto Trading Co., Ltd.) : titanium diisopropoxy bis(acetylacetonate) was added dropwise, coated by a spin coating process, and then, the Kapton tape was detached. Then, heating was conducted thereto at 450°C for 8 minutes. By this way, buffer layers 301 to 310 formed of a titanium oxide thin layer (porosity (C): 1.0% by volume) having a thickness 50 nm were formed on a transparent conductive film (FTO).

A titanium oxide paste (an anatase type, primary average particle size (average observed under a microscope): 18 nm, ethyl cellulose was dispersed in 10% aqueous acetylacetone) was coated on the above-described buffer layers 301 to 310 by a screen printing process (coated surface area: 70 mm × 7.5 mm). The obtained coating film was calcined at 200°C for 10 minutes and at 500°C for 15 minutes, whereby a titanium oxide porous layer (porous semiconductor layer) having a thickness of 2.5 μm and a porosity (D) of 60% by volume was formed.

A photoelectric conversion element module SM-12 was produced in the same manner as in Example 1 except the above-described matters.

(Comparative Example 2)

In a polymerization process of the photoelectric conversion element module 1, the above-described semiconductor electrode was immersed in an acetonitrile solution (electrolytic polymerization solution) containing the above-described conductive polymer precursor (bis-EDOT) at a ratio of $1 \times 10^{-3}$ (mol/l) and $Li[(CF_3SO_2)_2N]$ at a ratio of 0.1 (mol/l). The above-described first electrode 21 was connected to a working electrode, a platinum wire was connected to a counter electrode, and $Ag/Ag^+$ ($AgNO_3$ 0.01 M) was connected to a reference electrode, and then, the sustained voltage was set to -0.16 V. The voltage was sustained for 30 minutes while irradiation is performed with light from the direction of the semiconductor layer (using a xenon lamp having a light intensity of 22 $mW/cm^2$ and cutting the wavelengths of 430 nm or less), whereby the hole transportation layer 51 was formed on the surface of the above-described semiconductor electrode. The hole transportation layer 52 was obtained by washing the obtained semiconductor electrode/hole transportation layer with acetonitrile, drying the semiconductor electrode/hole transportation layer and connecting the working electrode with the first electrode 22 again while sustaining the voltage in the same condition. In the same manner, the hole transportation layer 53 was obtained. Further, a photoelectric conversion element module SM-13 was produced in the same manner except that a hole transportation layer was obtained.

The compositions of the above-described photoelectric conversion elements SC-1 to SC-11 and SC13 and

photoelectric conversion element modules SM-1 to SM-13 are as shown in the following Table 2.

(Measurement of photoelectric conversion efficiency)

For the photoelectric conversion elements and photoelectric conversion element modules prepared in the above-described Examples and Comparative Examples, the obtained photoelectric conversion elements and photoelectric conversion element modules were each irradiated with artificial sunlight at an intensity of 100 mW/cm$^2$ through an AM filter (AM-1.5) from a xenon lamp by using a solar simulator (manufactured by EKO Instruments Co., Ltd.). Furthermore, the current-voltage property of the photoelectric conversion element at room temperature was measured by using an I-V tester, and the short-circuit current density (Jsc), open circuit voltage (Voc) and form factor (F. F.) were measured. These values were put into the following Formulas to obtain a photoelectric conversion efficiency $\eta_c$ (%) of the photoelectric conversion element and the photoelectric conversion element module and a photoelectric conversion efficiency $\eta_m$ of the module.
[Mathematical Formula 4]

Formula (A)

$$\eta_c = 100 \times (Voc \times Jsc \times F.\ F.)/P$$

[Mathematical Formula 5]

Formula (B)

$$\eta_m = 100 \times (Voc \times Jsc \times F.\ F.)/P$$

Herein, P represents an incident light intensity [mW/cm$^2$], Voc represents an open circuit voltage [V], Jsc represents a short-circuit current density [mA·cm$^{-2}$], and F. F. represents a fill factor.

[Table 2]

| Photoelectric conversion element, Photoelectric conversion element module | Oxidizer | After polymerization Status of oxidizer | Conductive polymer precursor | Wavelength of irradiated light | Kind of dye |
|---|---|---|---|---|---|
| SC-1 | $H_2O_2$ | Liquid | M1-1 | 420 nm or less cut | A-4 |
| SC-2 | p -toluenesulfonic acid iron(III) | Solid | M1-1 | 420 nm or less cut | A-4 |
| SC-3 | $AgNO_3$ | Solid | M1-1 | 420 nm or less cut | A-4 |
| SC-4 | cumene hydroperoxide | Solid | M1-1 | 420 nm or less cut | A-4 |
| SC-5 | $KMnO_4$ | Solid | M1-1 | 420 nm or less cut | A-4 |
| SC-6 | $O_2$ | Liquid | M1-1 | 420 nm or less cut | A-4 |
| SC-7 | $O_3$ | Liquid | M1-1 | 420 nm or less cut | A-4 |
| SC-8 | $H_2O_2$ | Liquid | M1-4 | 420 nm or less cut | A-4 |

(continued)

| Photoelectric conversion element, Photoelectric conversion element module | Oxidizer | After polymerization Status of oxidizer | Conductive polymer precursor | Wavelength of irradiated light | Kind of dye |
|---|---|---|---|---|---|
| SC-9 | $H_2O_2$ | Liquid | M1-26 | 420 nm or less cut | A-4 |
| SC-10 | $H_2O_2$ | Liquid | M1-1 | 400 nm or more cut | A-4 |
| SC-11 | $H_2O_2$ | Liquid | M1-1 | 400 nm or less cut | A-4 |
| SC-13 | None | Liquid | M1-1 | 420 nm or less cut | A-4 |
| SM-1 | $H_2O_2$ | Liquid | M1-1 | 420 nm or less cut | A-4 |
| SM-2 | p -toluenesulfonic acid iron(III) | Solid | M1-1 | 420 nm or less cut | A-4 |
| SM-3 | $AgNO_3$ | Solid | M1-1 | 420 nm or less cut | A-4 |
| SM-4 | cumene hydroperoxide | Solid | M1-1 | 420 nm or less cut | A-4 |
| SM-5 | $KMnO_4$ | Solid | M1-1 | 420 nm or less cut | A-4 |
| SM-6 | $O_2$ | Liquid | M1-1 | 420 nm or less cut | A-4 |
| SM-7 | $O_3$ | Liquid | M1-1 | 420 nm or less cut | A-4 |
| SM-3 | $H_2C_2$ | Liquid | M1-4 | 420 nm or less cut | A-4 |
| SM-9 | $H_2O_2$ | Liquid | M1-26 | 420 nm or less cut | A-4 |
| SM-10 | $H_2O_2$ | Liquid | M1-1 | 400 nm or more cut | A-4 |
| SM-11 | $H_2O_2$ | Liquid | M1-1 | 400 nm or less cut | A-4 |
| SM-12 | $H_2O_2$ | Liquid | M1-1 | 420 nm or less cut | A-4 |
| SM-13 | None | Liquid | M1-1 | 420 nm or less cut | A-4 |

[Table 3]

| Photoelectric conversion element | Photoelectric conversion element module | Oxidizer | Conductive polymer precursor | Wavelength of irradiated light | Photoelectric conversion efficiency of cell ($\eta_c$(%)) | Photoelectric conversion efficiency of module ($\eta_m$ (%)) |
|---|---|---|---|---|---|---|
| SC-1 | SM-1 | $H_2O_2$ | M1-1 | 420 nm or less cut | 4.32 | 3.21 |
| SC-2 | SM-2 | p -toluenesulfonic acid iron(III) | M1-1 | 420 nm or less cut | 3.97 | 2.59 |
| SC-3 | SM-3 | $AgNO_3$ | M1-1 | 420 nm or less cut | 4.25 | 2.8 |
| SC-4 | SM-4 | cumene hydroperoxide | M1-1 | 420 nm or less cut | 4.15 | 2.88 |
| 3C-5 | SM-5 | $KMnO_4$ | M1-1 | 420 nm or less cut | 3.95 | 2.55 |
| SC-6 | SM-6 | $O_2$ | M1-1 | 420 nm or less cut | 4.21 | 3.1 |
| SC-7 | SM 7- | $O_3$ | M1-1 | 420 nm or less cut | 4.14 | 3.03 |
| SC-8 | SM-8 | $H_2O_2$ | M1-4 | 420 nm or less cut | 3.87 | 2.7 |
| SC-9 | SM-9 | $H_2O_2$ | M1-26 | 420 nm or less cut | 3.76 | 2.55 |
| SC-10 | SM-10 | $H_2O_2$ | M1-1 | 400 nm or more cut | 3.8 | 2.61 |
| SC-11 | SM-11 | $H_2O_2$ | M1-1 | 400 nm or less cut | 4.16 | 2.98 |
| | SM-12 | $H_2O_2$ | M1-1 | 420 nm or less cut | - | 3.59 |
| SC-13 | SM-13 | None | M1-1 | 420 nm or less cut | 3.51 | 0.61 |

As shown in Table 3, with respect to the photoelectric conversion efficiency ($\eta_c$) of the photoelectric conversion elements from Reference Examples, the photoelectric conversion efficiency $\eta_m$) of the module according to the present invention was 65 to 75%. Referring to Comparative Examples 1 and 2, the photoelectric conversion efficiency ($\eta_m$) of the module with respect to the photoelectric conversion efficiency $\eta_c$) of the photoelectric conversion elements were remarkably decreased to about 17%. It is considered that this is because a first electrode of a photoelectric conversion element is relatively small, and thus, the photoelectric conversion element is not easily affected by a sheet resistance of the first electrode, and when a hole transportation layer is formed by photoelectrolytic polymerization, an appropriately homogeneous hole transportation layer is formed, whereas a module including a first electrode having a relatively large area is strongly affected by a sheet resistance of the first electrode when a hole transportation layer is formed by photoelectrolytic polymerization, and thus, the hole transportation layer cannot be polymerized completely homogeneously. From the above result, the photoelectric conversion element module according to the present invention is expected to solve the conventional problem that a module with a high photoelectric conversion efficiency cannot be manufactured. It is considered that this is achieved by one of the features of the present invention of forming a hole transportation layer by the above-described photochemical polymerization and thus forming a highly homogeneous hole transportation layer with respect to an electrode having a relatively large area, thereby reducing an area of a connection portion of each photoelectric conversion element, that is, a portion which does not contribute to power generation.

Herein, if the photoelectric conversion element exemplified as Reference Examples is connected in series without forming the module according to the present invention, an area of a connection portion of each photoelectric conversion element, that is, a portion which does not contribute to power generation increases. Therefore, it is deemed that as compared with the case where the photoelectric conversion elements are connected in series, the module according to the present invention shows a high photoelectric conversion efficiency.

This application is based on Japanese Patent Application No. 2013-138166 filed on July 1, 2013 and incorporated herein by reference in its entirety.

## Claims

1. A photoelectric conversion element module obtained by electrically connecting two or more photoelectric conversion elements obtained by stacking a substrate, a first electrode, a photoelectric conversion layer containing a semiconductor and a sensitizing dye, a hole transportation layer having a conductive polymer, and a second electrode in the sequence listed, wherein
the hole transportation layer is formed by bringing the photoelectric conversion layer into contact with a conductive polymer precursor and then irradiating the sensitizing dye with light in the presence of an oxidizer, whereby the conductive polymer precursor is polymerized.

2. The photoelectric conversion element module according to claim 1, wherein as for at least two adjacent photoelectric conversion elements among the photoelectric conversion elements, one end portion of the first electrode of one photoelectric conversion element is connected with one end portion of the second electrode of another photoelectric conversion element adjacent to the one photoelectric conversion element.

3. The photoelectric conversion element module according to any one of claim 1 or 2, wherein the oxidizer is oxygen, ozone, peroxides, or metal salts.

4. The photoelectric conversion element module according to any one of claims 1 to 3, wherein the conductive polymer precursor has a repeating unit represented by the following Monomer Formula 1:

[Chemical Formula 1]

(Monomer Formula 1)

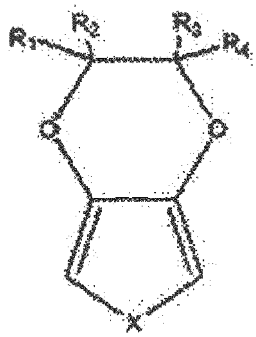

(in Monomer Formula 1, X represents, S, NR, or O, R is a hydrogen atom or an alkyl group, and $R_1$ to $R_4$ are each independently a hydrogen atom, a halogen atom, a straight chain or branched alkyl group having 1 to 30 carbon atom(s), a cycloalkyl group having 3 to 10 carbon atoms, an alkoxy group having 1 to 30 carbon atom (s), a polyethylene oxide group having 2 to 30 carbon atoms, or a substituted or unsubstituted aromatic ring-containing group having 4 to 30 carbon atoms).

**5.** The photoelectric conversion element module according to any one of claims 1 to 4, wherein the sensitizing dye is represented by General Formula (1):

[Chemical Formula 2]

General Formula (1)

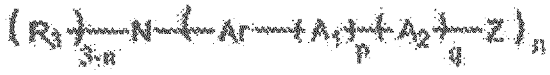

(in General Formula (1), $R_3$s each independently represent a hydrogen atom, a halogen atom, a substituted or unsubstituted alkyl group, a substituted or unsubstituted alkoxy group, a substituted or unsubstituted alkenyl group, a substituted or unsubstituted alkynyl group, a substituted or unsubstituted aryl group, an amino group, a cyano group, or a substituted or unsubstituted heterocyclic group,
Ar represents a bivalent cyclic compound group,
$A_1$ and $A_2$ each independently represent a single bond, a bivalent saturated or unsaturated hydrocarbon group, a substituted or unsubstituted alkylene group, an arylene group, or a bivalent heterocyclic group,
Z is an organic group having an acidic group, alkoxysilane, or halogenated silane,
p and q are each independently an integer of 0 or more and 6 or less,
n is an integer of 1 or more and 3 or less, and
when n is 1, two $R_3$s are different from each other and $R_3$ is connected with another substituent to form a cyclic structure, and when n is 2 or more, plural Ars, $A_1$s, $A_2$s and Zs are different from each other).

**6.** The photoelectric conversion element module according to any one of claims 1 to 5, wherein a wavelength of the irradiated light includes an absorption wavelength of the sensitizing dye.

**7.** A method for manufacturing a photoelectric conversion element module obtained by electrically connecting two or more photoelectric conversion elements obtained by stacking a substrate, a first electrode, a photoelectric conversion layer containing a semiconductor and a sensitizing dye, a hole transportation layer having a conductive polymer, and a second electrode in the sequence listed, the method comprising:

forming the photoelectric conversion layer on the first electrode;
bringing a conductive polymer precursor into contact with the photoelectric conversion layer in the presence of an oxidizer;
irradiating the sensitizing dye with light in the presence of the oxidizer to polymerize the conductive polymer precursor to thereby form the hole transportation layer;
forming the second electrode on the hole transportation layer; and

electrically connecting at least the two photoelectric conversion elements.

**8.** The method for manufacturing a photoelectric conversion element module according to claim 7, wherein the electrically connecting includes connecting one end portion of the first electrode of one photoelectric conversion element with one end portion of the second electrode of another photoelectric conversion element adjacent to the one photoelectric conversion element.

**9.** The method for manufacturing a photoelectric conversion element module according to claim 8, wherein since the second electrode is formed, at least the two photoelectric conversion elements are electrically connected.

**10.** The method for manufacturing a photoelectric conversion element module according to any one of claims 7 to 9, wherein the oxidizer is oxygen, ozone, peroxides, or metal salts.

**11.** The method for manufacturing a photoelectric conversion element module according to any one of claims 7 to 10, wherein the conductive polymer has a repeating unit represented by the following General Formula (2)

[Chemical Formula 3]

General Formula (2)

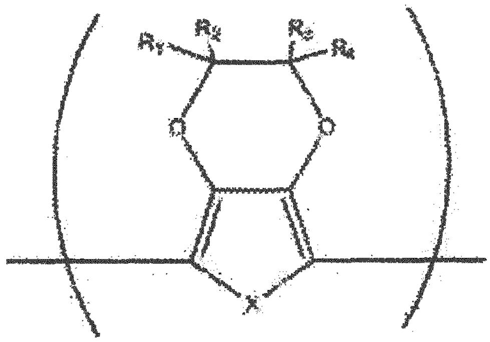

(in General Formula (2), X represents S, NR, or O, R is a hydrogen atom or an alkyl group, and $R_1$ to $R_4$ are each independently a hydrogen atom, a halogen atom, a straight chain or branched alkyl group having 1 to 30 carbon atom(s), a cycloalkyl group having 3 to 10 carbon atoms, an alkoxy group having 1 to 30 carbon atom (s), a polyethylene oxide group having 2 to 30 carbon atoms, or a substituted or unsubstituted aromatic ring-containing group having 4 to 30 carbon atoms).

**12.** The method for manufacturing a photoelectric conversion element module according to any one of claims 7 to 11, wherein a wavelength of the irradiated light includes an absorption wavelength of the sensitizing dye.

FIG. 1

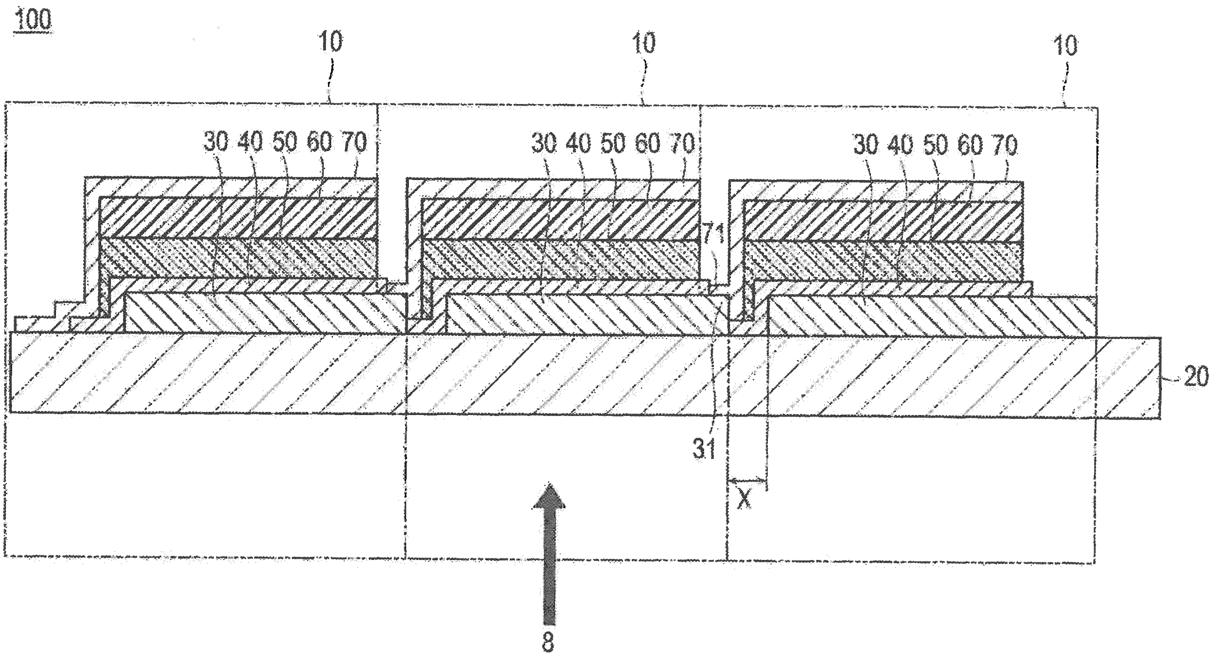

## INTERNATIONAL SEARCH REPORT

International application No. PCT/JP2014/066358

A. CLASSIFICATION OF SUBJECT MATTER
*H01L51/44*(2006.01)i, *C09B23/00*(2006.01)i, *C09K3/00*(2006.01)i, *H01G9/20*(2006.01)i, *H01L51/46*(2006.01)i, *H01L51/48*(2006.01)i

According to International Patent Classification (IPC) or to both national classification and IPC

B. FIELDS SEARCHED

Minimum documentation searched (classification system followed by classification symbols)
H01L51/42-51/48, C09B23/00, C09K3/00, H01G9/20

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)
Science Direct, JSTPlus/JMEDPlus/JST7580(JDreamIII)

C. DOCUMENTS CONSIDERED TO BE RELEVANT

| Category* | Citation of document, with indication, where appropriate, of the relevant passages | Relevant to claim No. |
|---|---|---|
| A | WO 2010/098464 A1 (Independent Administrative Institution National Institute for Materials Science), 02 September 2010 (02.09.2010), paragraphs [0014], [0015], [0029] to [0033]; fig. 1 & US 2012/0032166 A1 & EP 2403006 A1 | 1-12 |
| A | JP 2004-063758 A (FDK Corp.), 26 February 2004 (26.02.2004), paragraphs [0014] to [0031] (Family: none) | 1-12 |

☒ Further documents are listed in the continuation of Box C.

☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 15 August, 2014 (15.08.14) | 02 September, 2014 (02.09.14) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2014/066358

C (Continuation). DOCUMENTS CONSIDERED TO BE RELEVANT

| Category* | Citation of document, with indication, where appropriate, of the relevant passages | Relevant to claim No. |
|---|---|---|
| A | WO 2007/007735 A1 (Osaka University, Kansai Technology Licensing Organization Co., Ltd.), 18 January 2007 (18.01.2007), paragraphs [0047], [0048]; fig. 1 (Family: none) | 1-12 |
| A | JP 2009-108175 A (Tama-TLO Ltd., Tokyo Polytechnic University), 21 May 2009 (21.05.2009), paragraphs [0013] to [0015], [0023] to [0034] (Family: none) | 1-12 |
| P,A | WO 2014/046145 A1 (Konica Minolta, Inc.), 27 March 2014 (27.03.2014), paragraphs [0014] to [0022], [0191] to [0208], [0218] to [0233] (Family: none) | 1-12 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2005078853 A
- JP 2003142168 A
- JP 2013012366 A
- JP 1123228 A
- JP 2009016582 A
- JP 2001160427 A
- JP 2000106223 A
- JP 2011065751 A
- US 4684537 A
- US 4927721 A
- US 5084365 A
- US 5350644 A
- US 5463057 A
- US 5525440 A
- JP 7249790 A
- JP 2000150007 A
- US 2681294 A
- US 2761418 A
- US 3508947 A
- US 2761791 A
- JP 2013138166 A

### Non-patent literature cited in the description

- *J. Chem. Soc., Chem. Commun.,* 1999, vol. 15
- *Surface Science,* vol. 21 (5), 288-293